# EUROPEAN PATENT APPLICATION

(11) **EP 2 889 356 A2**
(43) Date of publication of application: **01.07.2015**
(21) Application number: 13831153.5
(22) Date of filing: 13.08.2013
(51) Int. Cl.: C09K 11/06, H01L 51/50

(54) **ORGANIC PHOTOELECTRIC ELEMENT AND DISPLAY DEVICE COMPRISING SAME**

(30) Priority: 21.08.2012 KR 20120091341
(71) Applicant: Cheil Industries Inc., Gumi-si, Gyeongsangbuk-do 730-730 (KR)
(72) Inventor: KIM, Jun-Seok, Uiwang-si Gyeonggi-do 437-711 (KR); JUNG, Sung-Hyun, Uiwang-si Gyeonggi-do 437-711 (KR); RYU, Dong-Wan, Uiwang-si Gyeonggi-do 437-711 (KR); KANG, Eui-Su, Uiwang-si Gyeonggi-do 437-711 (KR); YANG, Yong-Tak, Uiwang-si Gyeonggi-do 437-711 (KR); RYU, Dong-Kyu, Uiwang-si Gyeonggi-do 437-711 (KR); LEE, Han-Ill, Uiwang-si Gyeonggi-do 437-711 (KR); JANG, Yu-Na, Uiwang-si Gyeonggi-do 437-711 (KR); JO, Young-Kyoung, Uiwang-si Gyeonggi-do 437-711 (KR); CHAE, Mi-Young, Uiwang-si Gyeonggi-do 437-711 (KR); HUH, Dal-Ho, Uiwang-si Gyeonggi-do 437-711 (KR); HONG, Jin-Seok, Uiwang-si Gyeonggi-do 437-711 (KR)
(74) Representative: Michalski Hüttermann & Partner Patentanwälte mbB
(86) International application number: PCT/KR2013/007286
(87) International publication number: WO 2014/030872

(57) **Abstract**

Provided are an organic optoelectronic device and a display device including the same, and the organic optoelectronic device includes an anode, a cathode and at least one organic thin layer between the anode and the cathode, wherein the organic thin layer includes an emission layer, a hole transport layer (HTL), a hole injection layer (HIL), an electron transport layer (ETL), an electron injection layer (EIL) or a combination thereof, the organic thin layer includes an emission layer and a plurality of hole transport layer (HTL), the hole transport layer (HTL) adjacent to the emission layer of the plurality of hole transport layer (HTL) includes a compound represented by Chemical Formula A-1, one of the hole transport layers (HTL) that are not adjacent to the emission layer includes a compound represented by Chemical Formula B-1.

## Description

### [Technical Field]

An organic optoelectronic device and a display device including the same are disclosed.

### [Background Art]

An organic optoelectronic device is a device requiring a charge exchange between an electrode and an organic material by using holes or electrons.

An organic optoelectronic device may be classified as follows in accordance with its driving principles. A first organic optoelectronic device is an electronic device driven as follows: excitons are generated in an organic material layer by photons from an external light source; the excitons are separated into electrons and holes; and the electrons and holes are transferred to different electrodes as a current source (voltage source).

A second organic optoelectronic device is an electronic device driven as follows: a voltage or a current is applied to at least two electrodes to inject holes and/or electrons into an organic material semiconductor positioned at an interface of the electrodes, and the device is driven by the injected electrons and holes.

Representative organic optoelectronic devices, an organic light emitting diode (OLED) has recently drawn attention due to an increase in demand for flat panel displays. In general, organic light emission refers to conversion of electrical energy into photo-energy.

Such an organic light emitting diode converts electrical energy into light by applying current to an organic light emitting material. It has a structure in which a functional organic material layer is interposed between an anode and a cathode. The organic material layer includes a multi-layer including different materials, for example a hole injection layer (HIL), a hole transport layer (HTL), an emission layer, an electron transport layer (ETL), and an electron injection layer (EIL), in order to improve efficiency and stability of an organic photoelectric device.

In such an organic light emitting diode, when a voltage is applied between an anode and a cathode, holes from the anode and electrons from the cathode are injected to an organic material layer and recombined to generate excitons having high energy. The generated excitons generate light having certain wavelengths while shifting to a ground state.

The light emitting material is classified as blue, green, and red light emitting materials according to emitted colors, and yellow and orange light emitting materials to emit colors approaching natural colors.

When one material is used as a light emitting material, a maximum light emitting wavelength is shifted to a long wavelength or color purity decreases because of interactions between molecules, or device efficiency decreases because of a light emitting quenching effect. Therefore, a host/dopant system is included as a light emitting material in order to improve color purity and increase luminous efficiency and stability through energy transfer.

In order to implement excellent performance of an an organic light emitting diode, a material constituting an organic material layer, for example a hole injection material, a hole transport material, a light emitting material, an electron transport material, an electron injection material, and a light emitting material such as a host and/or a dopant, should be stable and have good efficiency. However, development of an organic material layer forming material for an organic light emitting diode has thus far not been satisfactory and thus there is a need for a novel material. This material development is also required for other organic optoelectronic devices.

### [DISCLOSURE]

### [Technical Problem]

A compound for an organic optoelectronic device that may act as a light emitting, or hole injection and transport material, and also act as a light emitting host along with an appropriate dopant is provided.

An organic optoelectronic device including the compound for an organic optoelectronic device in a hole layer to provide improved characteristics is provided.

### [Technical Solution]

In one embodiment of the present invention, an organic optoelectronic device includes an anode, a cathode and at least one organic thin layer between the anode and the cathode, wherein the organic thin layer includes an emission layer, a hole transport layer (HTL), a hole injection layer (HIL), an electron transport layer (ETL), an electron injection layer (EIL) or a combination thereof, the organic thin layer includes an emission layer and a plurality of hole transport layer (HTL), the hole transport layer (HTL) adjacent to the emission layer of the plurality of hole transport layer (HTL) includes compound represented by the following Chemical Formula A-1, and one of the hole transport layers (HTL) that are not adjacent to the emission layer includes a compound represented by the following Chemical Formula B-1.

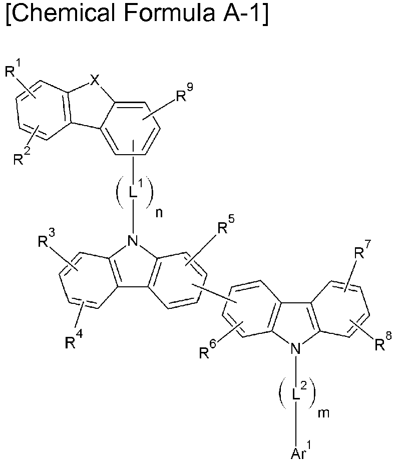

In the Chemical Formula A-1, X is -O-, -S-, -S(O)-, -S(O)₂- or -CR'R " -, R¹ to R⁹, R' and R " are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, Ar¹ is a substituted or unsubstituted C6 to C30 aryl group, n is an integer of 0 to 3, and m is an integer of 0 to 3.

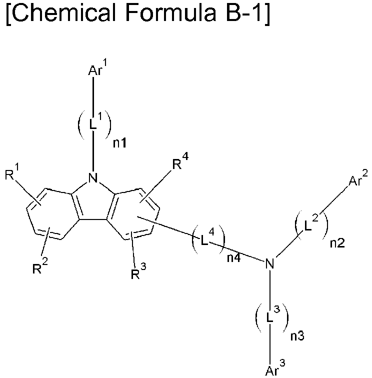

In the Chemical Formula B-1, R¹ to R⁴ are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, or R¹ and R² provide a fused ring, or R³ and R⁴ provide a fused ring, Ar¹ to Ar³ are independently a substituted or unsubstituted C6 to C30 aryl group, or a substituted or unsubstituted C2 to C30 heteroaryl group, L¹ to L⁴ are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, and n1 to n4 are independently integers of 0 to 3.

In another embodiment of the present invention, a display device including the organic optoelectronic device according to above one embodiment of the present invention is provided.

### [Advantageous Effects]

A compound for an organic optoelectronic device that may act as a light emitting, or hole injection and transport material, and also act as a light emitting host along with an appropriate dopant is provided.

An organic optoelectronic device including the compound for an organic optoelectronic device in a hole layer to provide improved characteristics is provided.

### [Description of the Drawings]

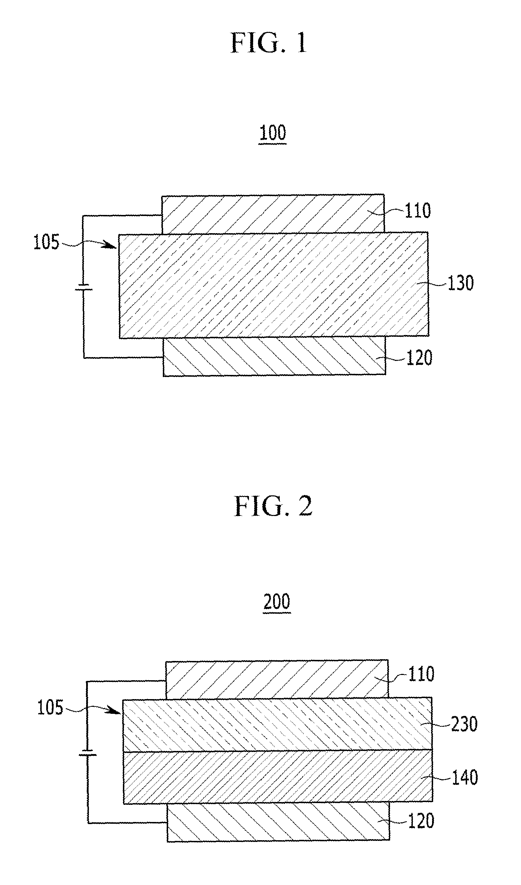

FIGS. 1 to 2 are cross-sectional views showing organic light emitting diodes according to various embodiments of the present invention according to one embodiment of the present invention.

### <Description of Reference Numerals Indicating Primary Elements in the Drawings>

- 100:: organic light emitting diode 200: organic light emitting diode
- 105:: organic layer
- 110:: cathode
- 120:: anode
- 130:: emission layer 230: emission layer
- 140:: hole auxiliary layer

### [Mode for Invention]

Hereinafter, embodiments of the present invention are described in detail. However, these embodiments are exemplary, and and the present invention is not limited thereto and is limited by the claims.

In the present specification, when specific definition is not otherwise provided, "hetero" refers to one including 1 to 3 hetero atoms selected from N, O, S, and P, and remaining carbons in one functional group.

In the present specification, when a definition is not otherwise provided, "combination thereof" refers to at least two substituents bound to each other by a linker, or at least two substituents condensed to each other.

In the present specification, when a definition is not otherwise provided, "alkyl group" refers to an aliphatic hydrocarbon group.

The alkyl group may be a C1 to C20 alkyl group. More specifically, the alkyl group may be a mid-sized C1 to C10 alkyl group. The alkyl group may be a lower C1 to C6 alkyl group.

For example, a C1 to C4 alkyl group may have 1 to 4 carbon atoms in alkyl chain which may be selected from methyl, ethyl, propyl, iso-propyl, n-butyl, iso-butyl, sec-butyl, and t-butyl.

Specific examples of the alkyl group may be one or more substituents selected from methyl, ethyl, propyl, isopropyl, butyl, isobutyl, t-butyl, pentyl, hexyl, cyclopropyl, cyclobutyl, cyclopentyl, cyclohexyl, and the like.

The alkyl group may be a branched, linear, or cyclic alkyl group.

"Alkenyl group" refers to a substituent of at least one carbon-carbon double bond of at least two carbon atoms, and "alkynyl group" refers to a substituent of at least one carbon-carbon triple bond of at least two carbon atoms.

"Aryl group" refers to an aryl group including a carbocyclic aryl (e.g., phenyl) having at least one ring having a covalent pi electron system. The term also refers to monocyclic or fusion ring polycyclic (i.e., rings sharing the adjacent pairs of carbon atoms) groups.

The term "heteroaryl group" refers to an aryl group including a heterocyclic aryl (e.g., pyridine) having at least one ring having a covalent pi electron system. The term also refers to monocyclic or fusion ring polycyclic (i.e., groups sharing the adjacent pairs of carbon atoms) groups.

In the present specification, when a definition is not otherwise provided, "substituted" refers to one substituted with a C1 to C30 alkyl group, a C1 to C10 alkylsilyl group, a C3 to C30 cycloalkyl group, a C6 to C30 aryl group, a C2 to C30 heteroaryl group, a C1 to C10 alkoxy group, a fluoro group, a C1 to C10 trifluoroalkyl group such as a trifluoromethyl group and the like, a C12 to C30 carbazole group, a C6 to C30 arylamine group, a C6 to C30 substituted or unsubstituted aminoaryl group or a cyano group.

In the present specification, more specifically, a substituted or unsubstituted C6 to C30 aryl group and/or a substituted or unsubstituted C2 to C30 heteroaryl group refer to a substituted or unsubstituted phenyl group, a substituted or unsubstituted naphthyl group, a substituted or unsubstituted anthracenyl group, a substituted or unsubstituted phenanthryl group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted chrysenyl group, a substituted or unsubstituted triphenylenyl group, a substituted or unsubstituted perylenyl group, a substituted or unsubstituted indenyl group, a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted fluorenyl group, or a combination thereof, but are not limited thereto.

In one embodiment of the present invention, an organic optoelectronic device includes an anode, a cathode and at least one organic thin layer between the anode and the cathode, wherein the organic thin layer includes an emission layer, a hole transport layer (HTL), a hole injection layer (HIL), an electron transport layer (ETL), an electron injection layer (EIL) or a combination thereof, the organic thin layer includes an emission layer and a plurality of hole transport layer (HTL), the hole transport layer (HTL) adjacent to the emission layer of the plurality of hole transport layer (HTL) includes compound represented by the following Chemical Formula A-1, and one of the hole transport layers (HTL) that are not adjacent to the emission layer includes a compound represented by the following Chemical Formula B-1.

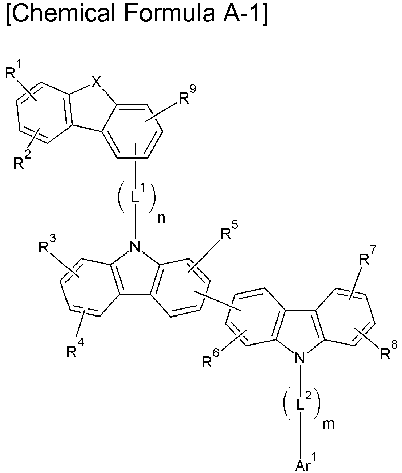

In the Chemical Formula A-1, X is -O-, -S-, -S(O)-, -S(O)₂- or -CR'R " -, R¹ to R⁹, R' and R " are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, Ar¹ is a substituted or unsubstituted C6 to C30 aryl group, n is an integer of 0 to 3, and m is an integer of 0 to 3.

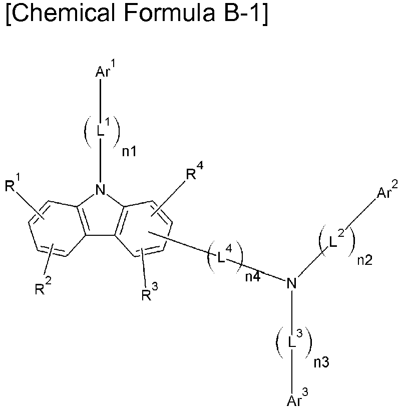

In the Chemical Formula B-1, R¹ to R⁴ are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, R¹ and R² provide a fused ring, R³ and R⁴ provide a fused ring, Ar¹ to Ar³ are independently a substituted or unsubstituted C6 to C30 aryl group, or a substituted or unsubstituted C2 to C30 heteroaryl group, L¹ to L⁴ are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, and n1 to n4 are independently integers of 0 to 3.

As described above, an organic optoelectronic device according to one embodiment of the present invention includes a plurality of hole transport layer (HTL). In this case, electron may hop easily and hole transport efficiency may be increased compared with a single hole transport layer (HTL). As described above, an organic optoelectronic device according to one embodiment of the present invention has excellent electrochemical and thermal stability and thus improves life-span characteristic, and has high luminous efficiency at a low driving voltage.

More specifically, the hole transport layer (HTL) adjacent to the emission layer of the plurality of hole transport layer (HTL) includes compound represented by the following Chemical Formula A-1

The compound represented by the Chemical Formula A-1 has a structure where a substituent is bonded with a core moiety including two carbazole groups bonded with each other.

The compound represented by the Chemical Formula A-1 includes a core moiety and various substituents for a substituent for substituting the core moiety and may have various energy bandgaps, and may satisfy various conditions required for a hole transport layer (HTL).

When the compound having an appropriate energy level depending on a substituent is used to manufacture an organic optoelectronic device, the compound reinforces hole transport capability and thus, brings about excellent effects in terms of efficiency and a driving voltage, and also, has excellent electrochemical and thermal stability and thus, may improve life-span characteristics of the organic optoelectronic device.

L¹ and L² of the Chemical Formula A-1 and L¹ to L⁴ of the Chemical Formula B-1 adjust a pi conjugation length (π-conjugation length) and increase a triplet energy bandgap, and thereby may be used for a hole layer of an organic optoelectronic device as a phosphorescent host.

More specifically, one of the hole transport layers (HTL) that are not adjacent to the emission layer may include a compound represented by the Chemical Formula B-1.

The compound represented by B-1 is an amine-based compound where at least one substituent of amine is substituted by a carbazole group.

In the B-1, R¹ and R² provide a fused ring, and R³ and R⁴ provide a fused ring. In this case, thermal stability increases, and electron transport and injection characteristics increase.

More specifically, when the compound represented by the A-1 and the compound represented by the B-1 are combined to form a plurality of hole transport layer (HTL) as in an organic optoelectronic device according to one embodiment of the present invention, energy level of a hole transport layer (HTL) may be optimized for electron hopping to provide excellent electrochemical and thermal stability. The organic optoelectronic device may have improved life-span characteristics, and high luminous efficiency at a low driving voltage.

More specifically, the compound represented by the Chemical Formula A-1 may be represented by the following Chemical Formula A-2.

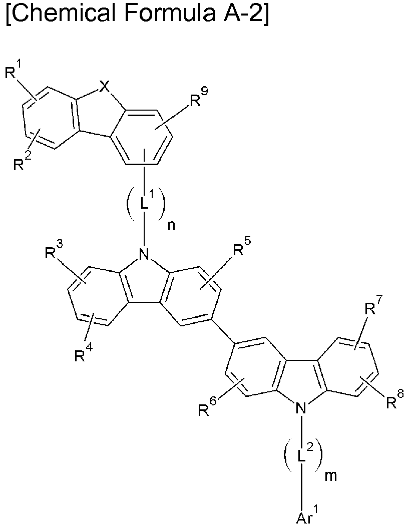

In the Chemical Formula A-2, X is -O-, -S-, -S(O)-, -S(O)₂- or -CR'R " -, R¹ to R⁹, R' and R " are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, Ar¹ is a substituted or unsubstituted C6 to C30 aryl group, n is an integer of 0 to 3, and m is an integer of 0 to 3.

When each carbazole is bonded at a 3 position as in the Chemical Formula A-2, it may be easily synthesized, and oxidation stability may increase by substituting hydrogen at a 3 position of the carbazole.

The compound represented by the Chemical Formula A-1 may be represented by the following Chemical Formula A-3.

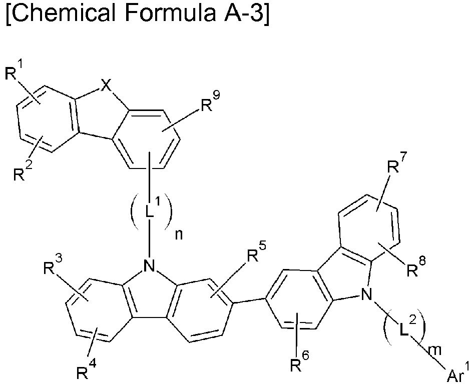

In the Chemical Formula A-3, X is -O-, -S-, -S(O)-, -S(O)₂- or -CR'R " -, R¹ to R⁹, R' and R " are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, Ar¹ is a substituted or unsubstituted C6 to C30 aryl group, n is an integer of 0 to 3, and m is an integer of 0 to 3.

In case of the structure as in the Chemical Formula A-3, it may be easily synthesized, hole transport capability increases, a driving voltage is lowered and simultaneously driving efficiency increases.

The compound represented by the Chemical Formula A-1 may be represented by the following Chemical Formula A-4.

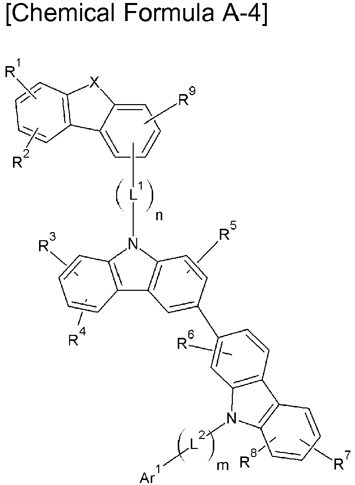

In the Chemical Formula A-4, X is -O-, -S-, -S(O)-, -S(O)₂- or -CR'R " -, R¹ to R⁹, R' and R " are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, Ar¹ is a substituted or unsubstituted C6 to C30 aryl group, n is an integer of 0 to 3, and m is an integer of 0 to 3.

In case of the compound having the structure of the Chemical Formula A-4, hole transport capability is improved, a driving voltage of an organic optoelectronic device is lowered, and efficiency increases.

The compound represented by the Chemical Formula A-1 may be represented by the following Chemical Formula A-5.

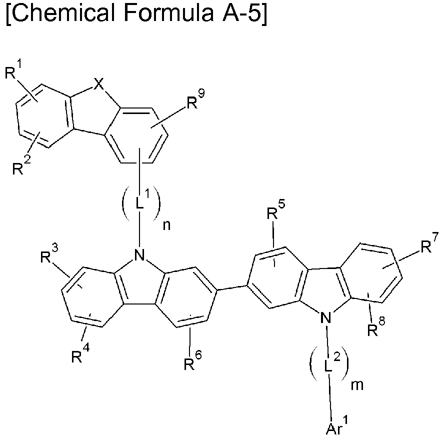

in the Chemical Formula A-5, X is -O-, -S-, -S(O)-, -S(O)₂- or -CR'R " -, R¹ to R⁹, R' and R " are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, Ar¹ is a substituted or unsubstituted C6 to C30 aryl group, n is an integer of 0 to 3, and m is an integer of 0 to 3.

The compound represented by in the Chemical Formula A-5 has increased thermal stability and improve a half-life life-span of an organic optoelectronic device.

More specifically, X of the Chemical Formula A-1 may be -O-. When using the compound, luminous efficiency of an organic optoelectronic device may be improved.

More specifically, X of the Chemical Formula A-1 may be -S-, and when using the compound, luminous efficiency and half-life life-span of an organic optoelectronic device may be improved.

More specifically, X of the Chemical Formula A-1 may be -CR'R"-, when using the compound, a half-life life-span of an organic optoelectronic device may be increased.

In one embodiment of the present invention, Ar¹ of the Chemical Formula A-1 may be a substituted or unsubstituted phenyl group.

In one embodiment of the present invention, L¹ and L² of the Chemical Formula A-1 may be independently a phenyl group.

In one embodiment of the present invention, X of the Chemical Formula A-1 may be -CR'R " -, wherein R' and R " are independently a substituted or unsubstituted methyl group, or a substituted or unsubstituted phenyl group.

As specific examples, the compound represented by the Chemical Formula A-1 may be represented by one of the following Chemical Formulae A-6 to A-26.

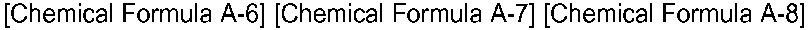

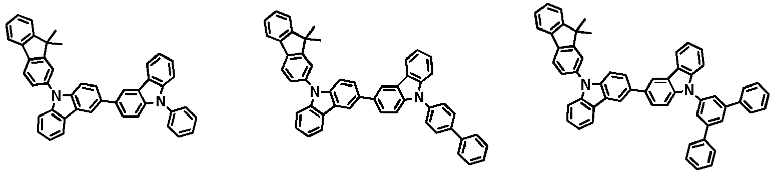

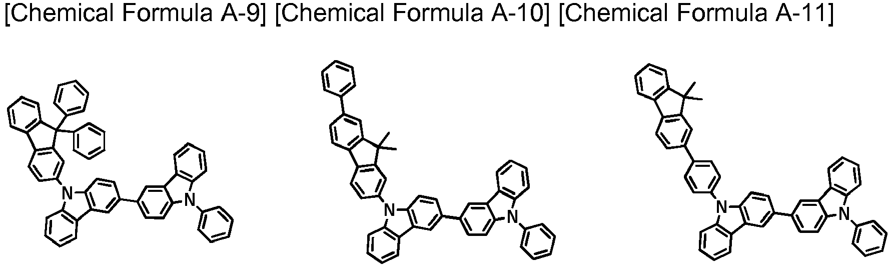

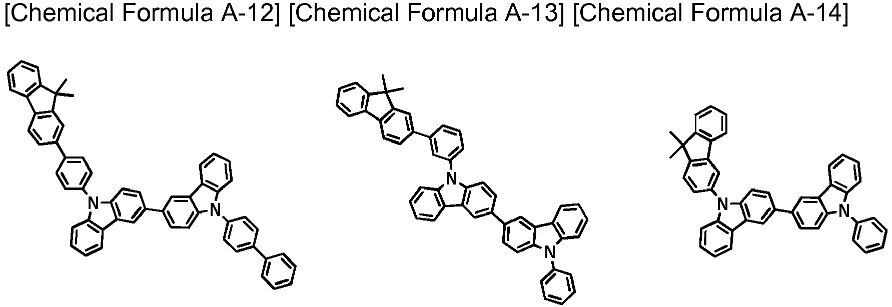

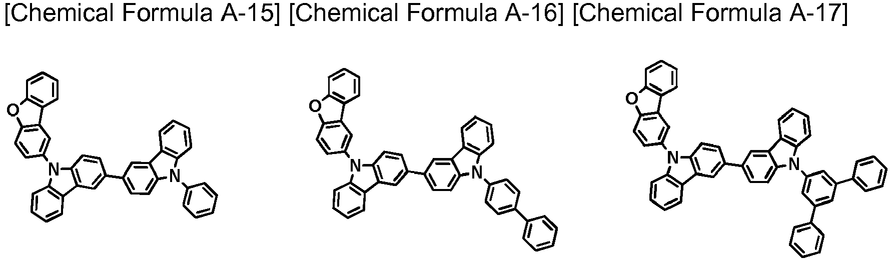

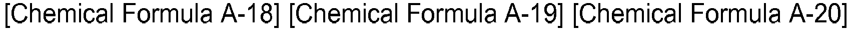

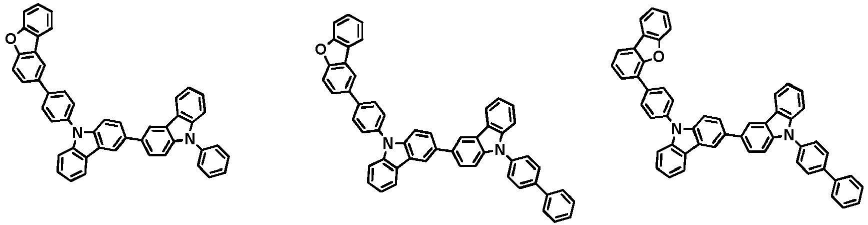

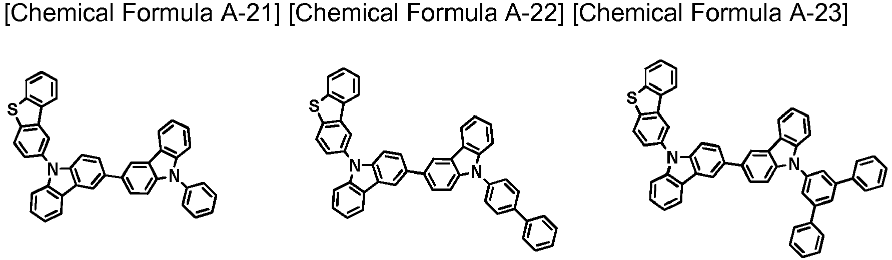

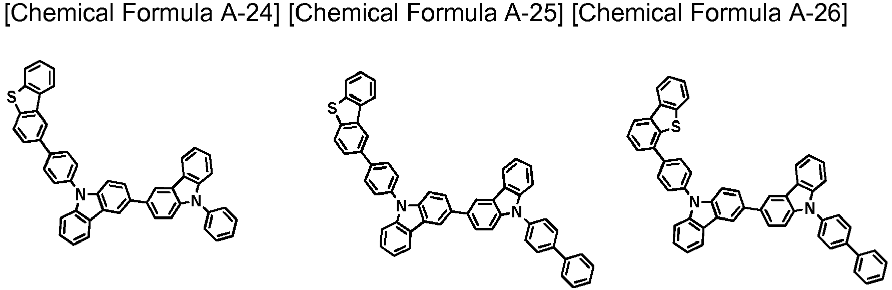

As specific examples, the compound represented by the Chemical Formula A-1 may be represented by one of the following Chemical Formulae A-27 to A-36.

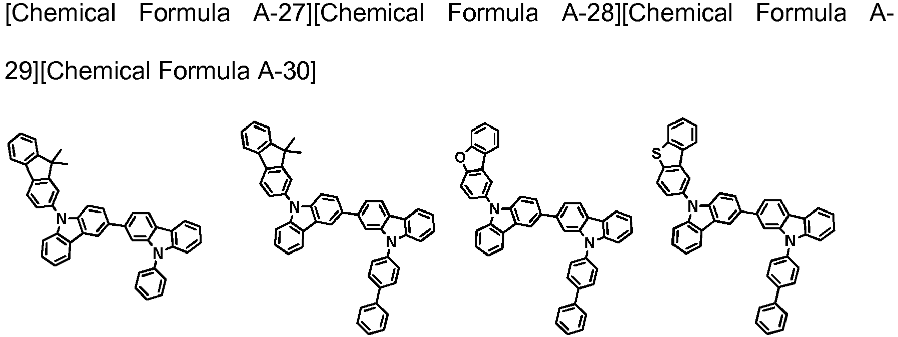

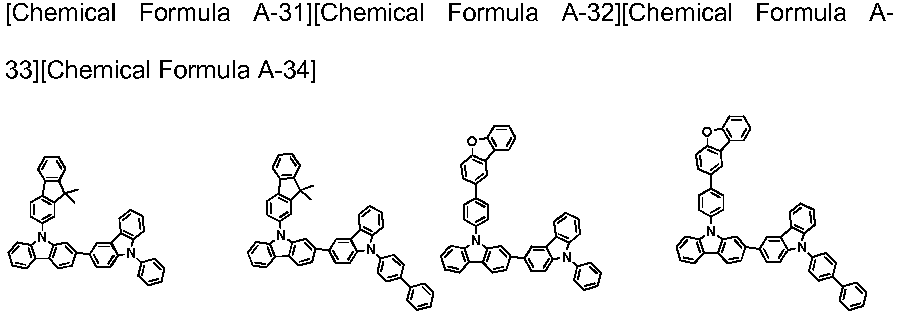

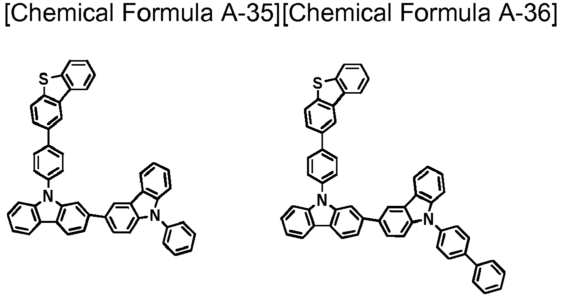

As specific examples, the compound represented by the Chemical Formula A-1 may be represented by one of the following Chemical Formulae A-37 to A-39.

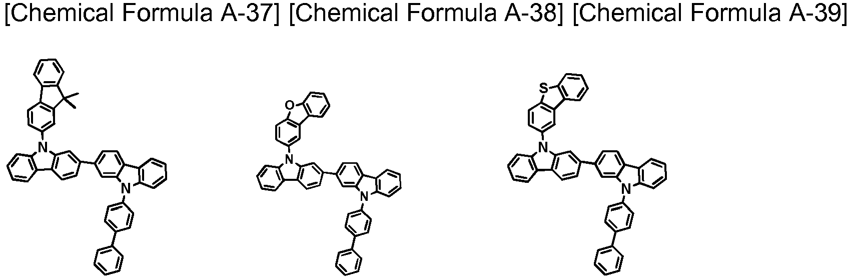

In an organic optoelectronic device according to one embodiment of the present invention, R¹ to R⁴ in the Chemical Formula B-1 are independently hydrogen, deuterium, a substituted or unsubstituted C1 to C10 alkyl group, a substituted or unsubstituted C6 to C30 aryl group, or a combination thereof, R¹ and R² provide a fused ring, or R³ and R⁴ provide a fused ring,

Ar¹ is a substituted or unsubstituted phenyl group or a substituted or unsubstituted naphthalene group,
Ar² and Ar³ are independently a substituted or unsubstituted phenyl group, a substituted or unsubstituted naphthalene group, a substituted or unsubstituted fluorene group, a substituted or unsubstituted bisfluorene group, a substituted or unsubstituted triphenylene group, a substituted or unsubstituted dibenzofuran group, or a substituted or unsubstituted dibenzothiophene group,
L¹ to L⁴ are independently a substituted or unsubstituted C6 to C30 arylene group, and
n1 to n4 are independently integers of 0 to 3.

As specific examples, the compound represented by the Chemical Formula B-1 may be represented by one of the following Chemical Formula J-1 to J-144, but is not limited thereto.

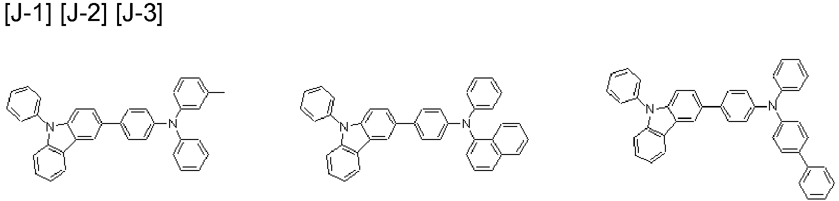

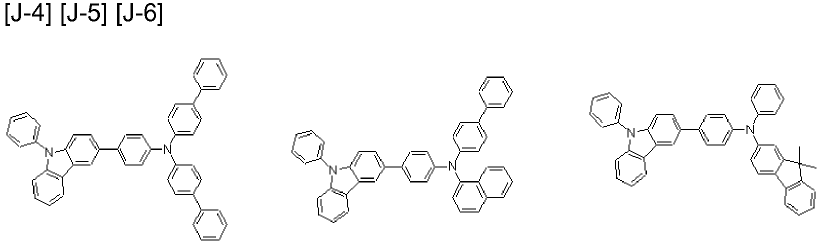

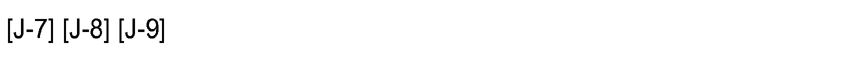

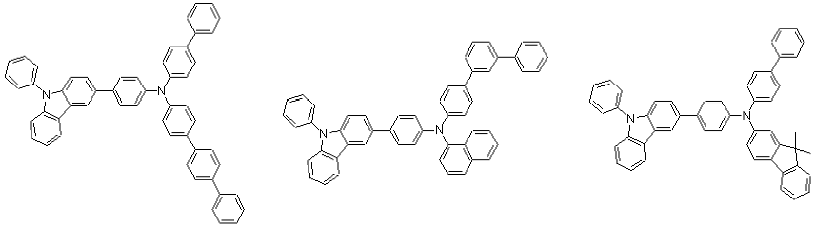

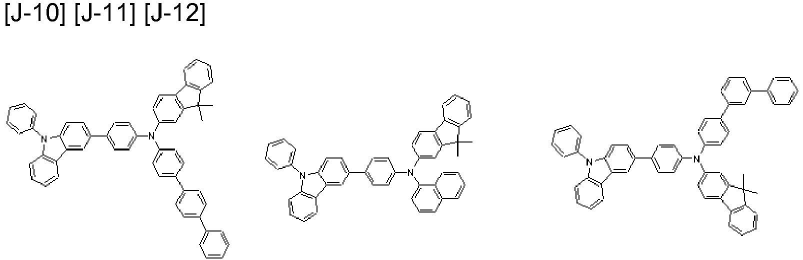

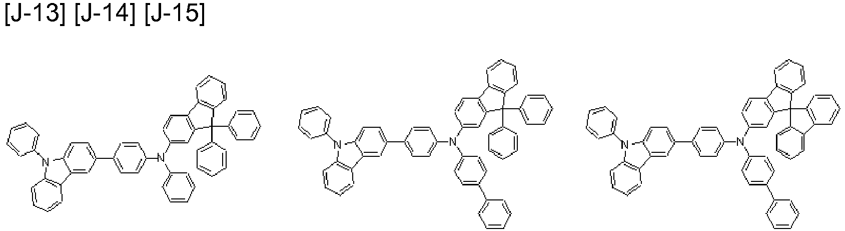

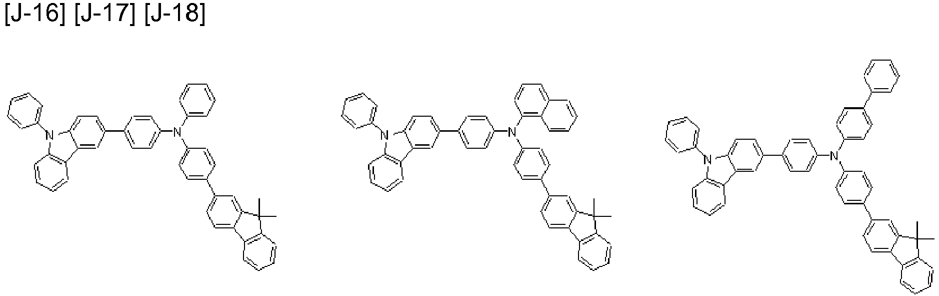

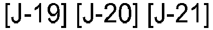

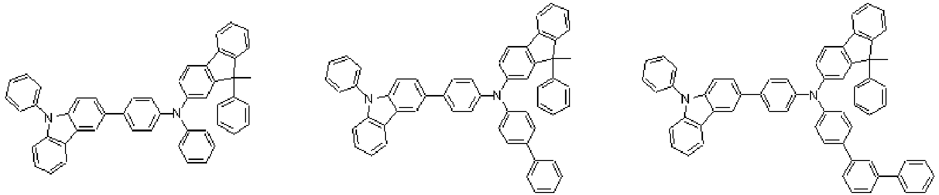

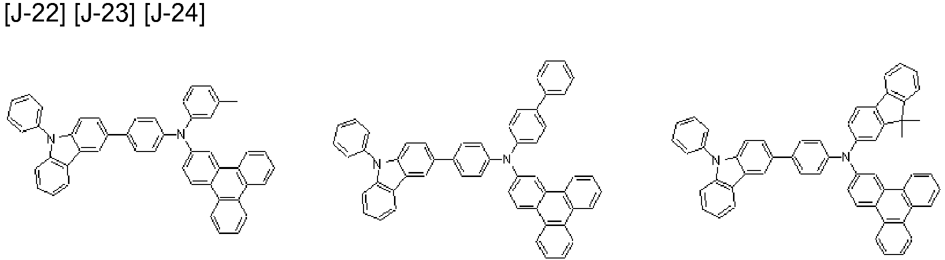

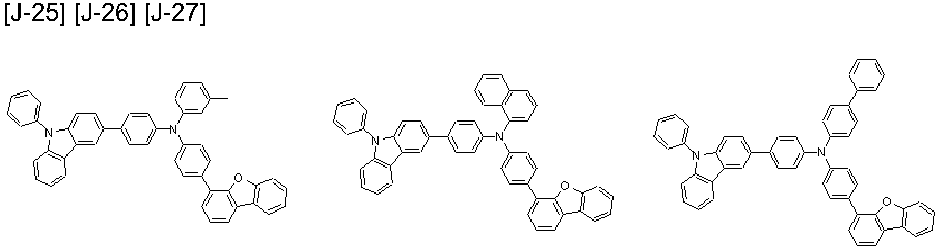

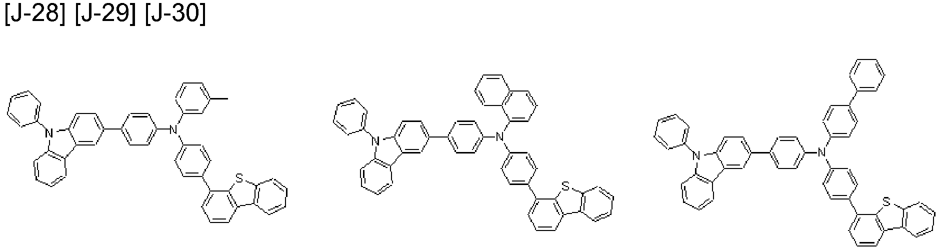

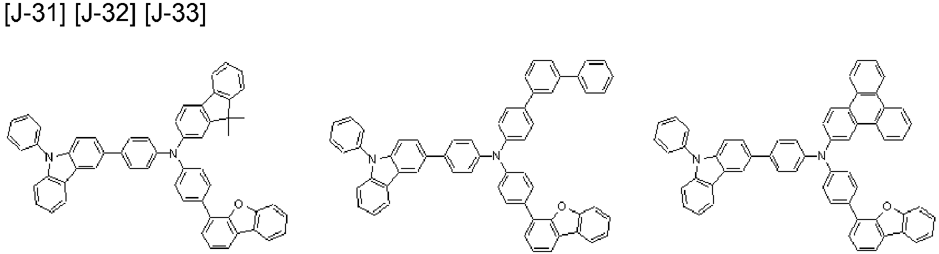

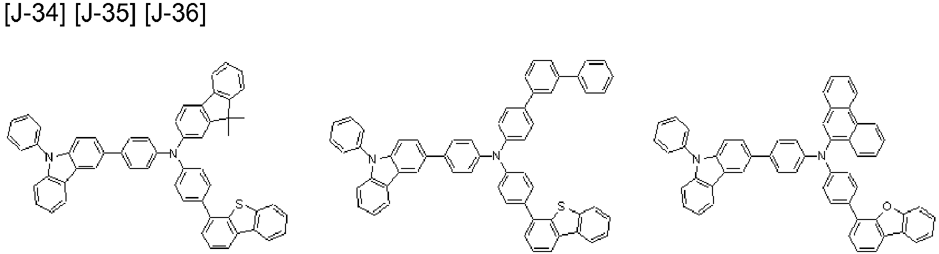

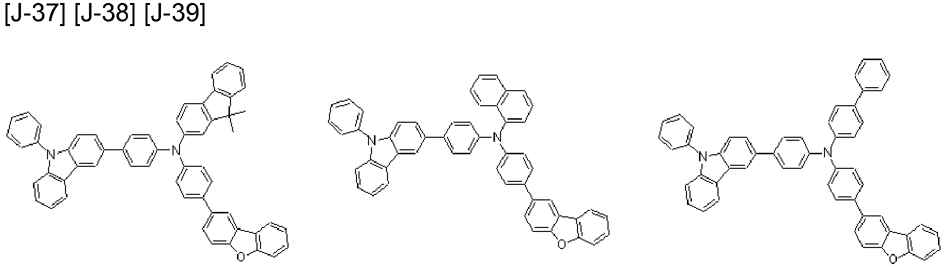

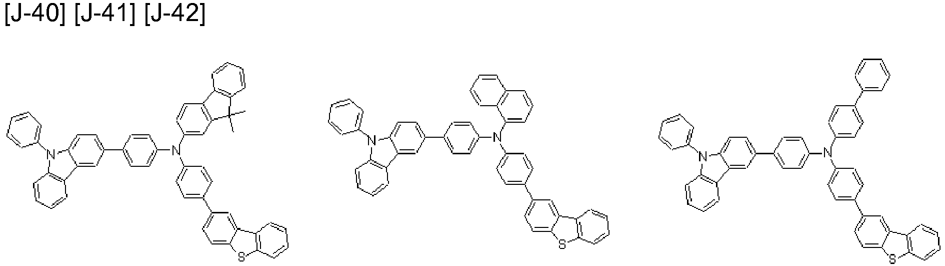

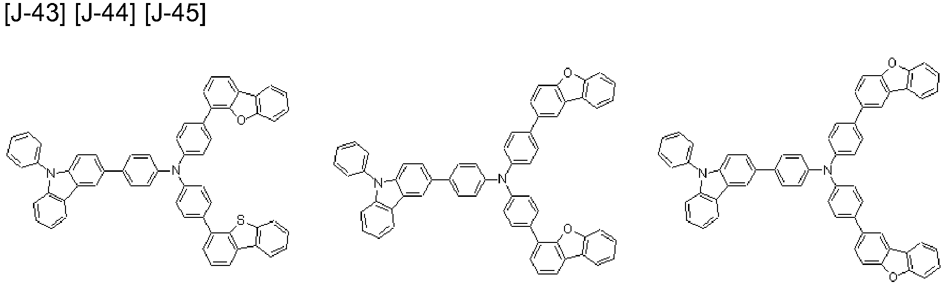

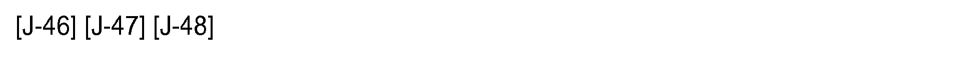

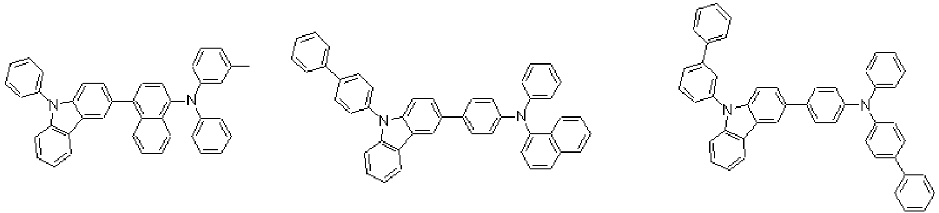

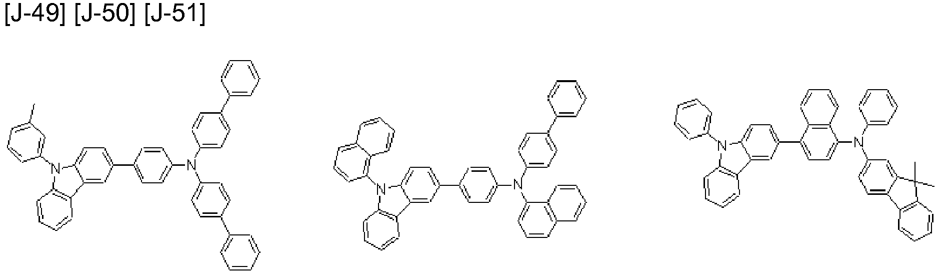

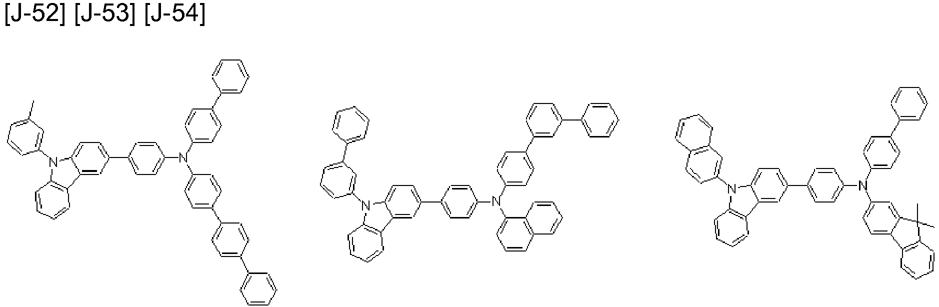

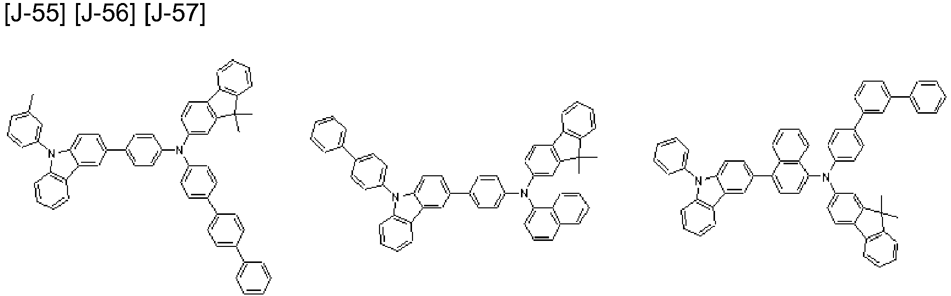

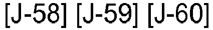

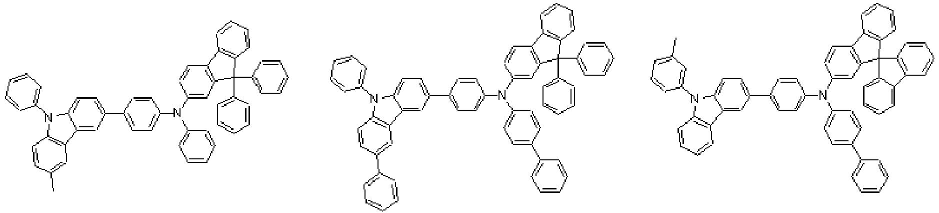

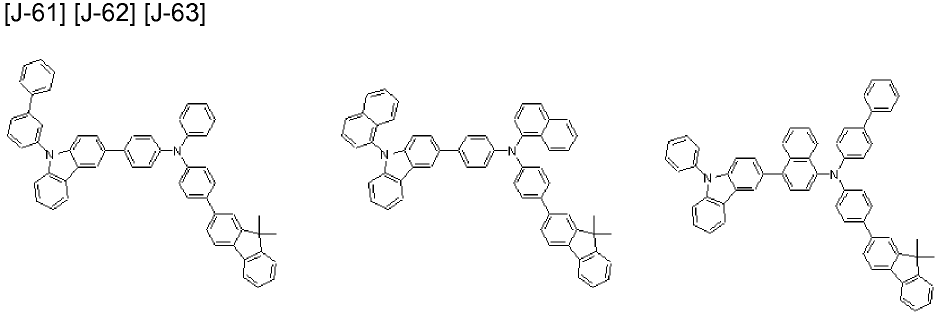

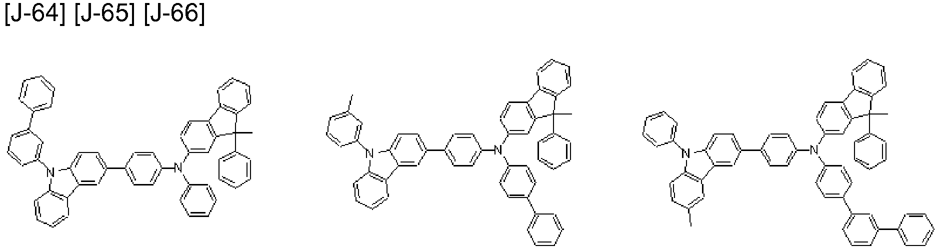

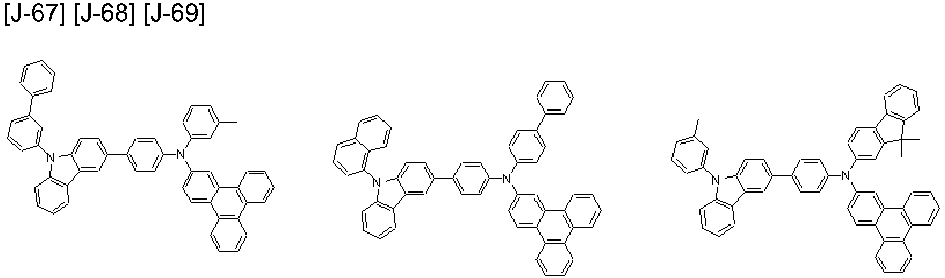

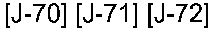

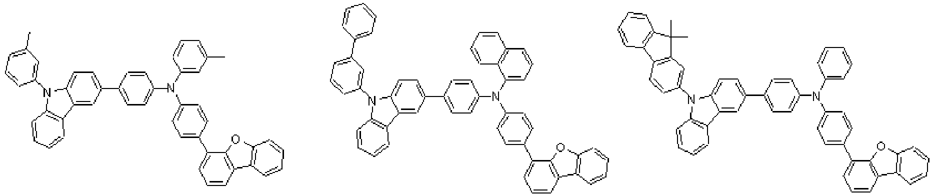

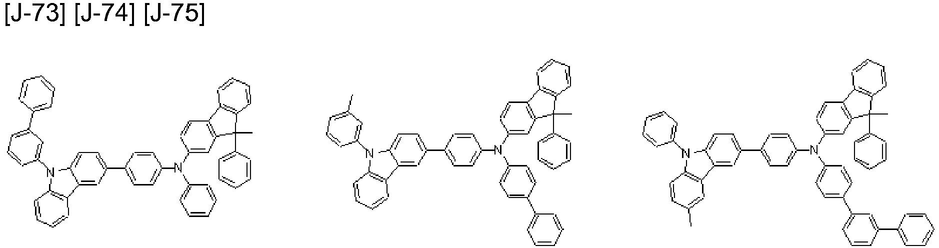

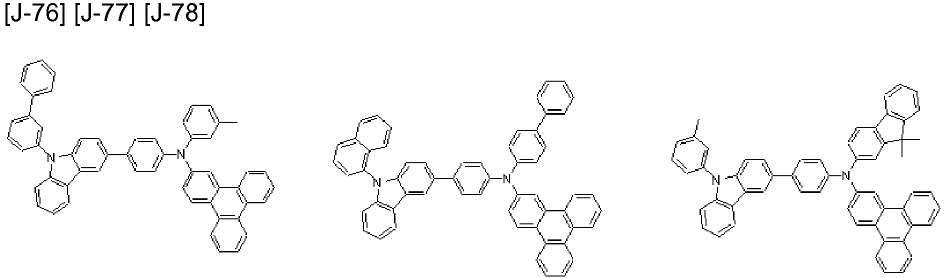

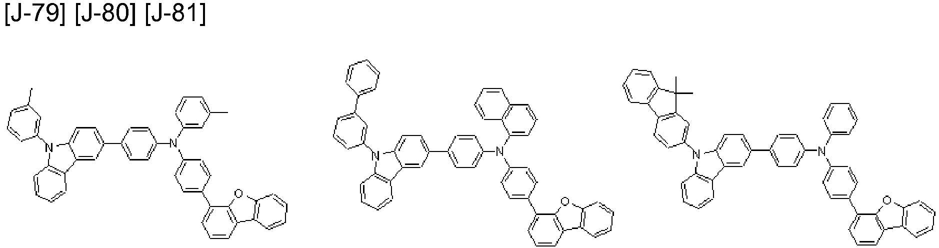

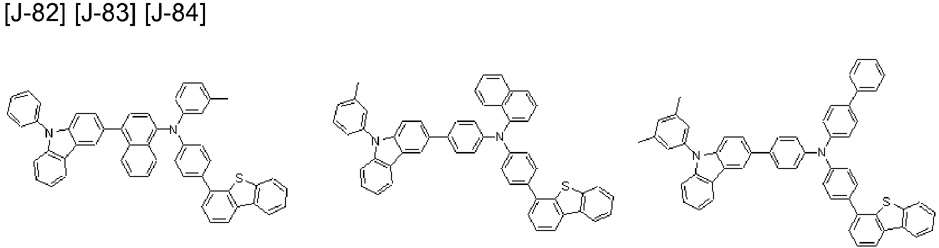

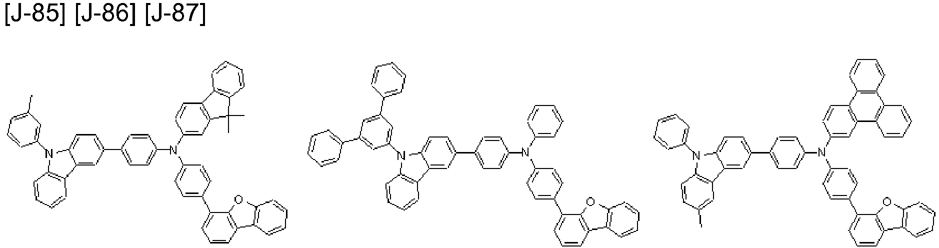

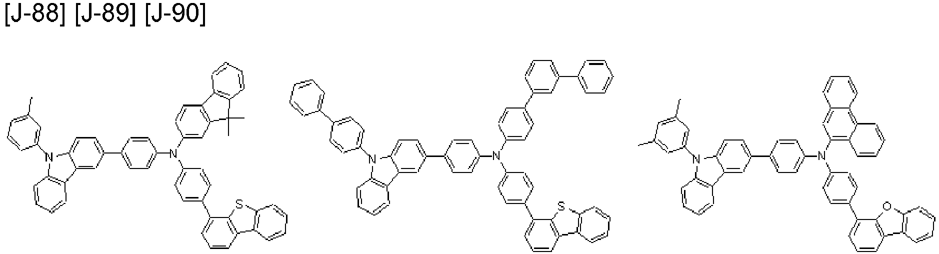

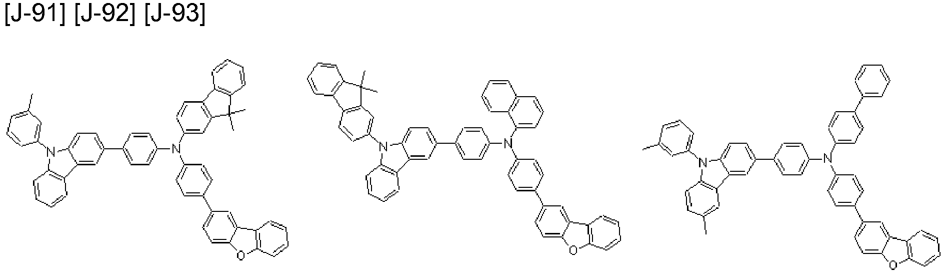

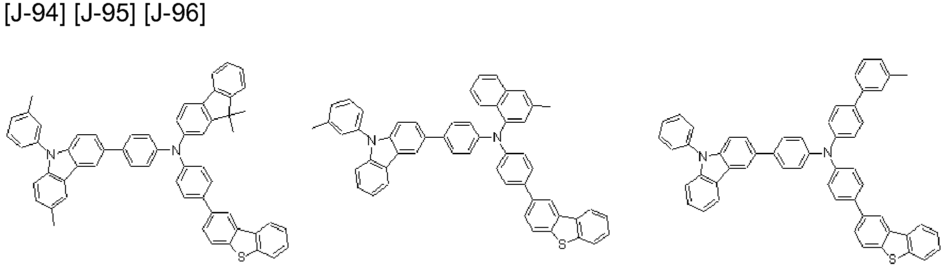

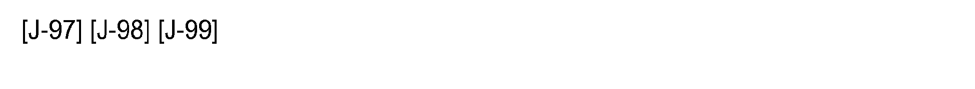

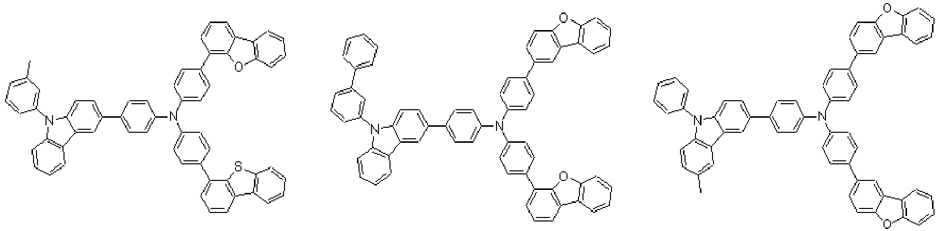

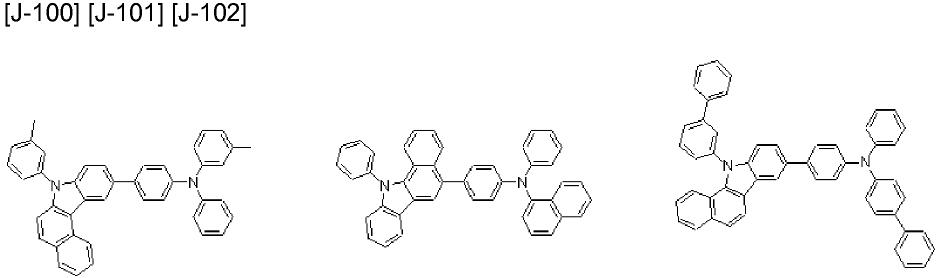

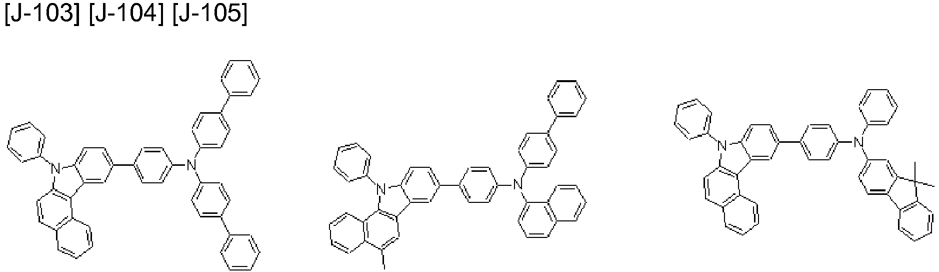

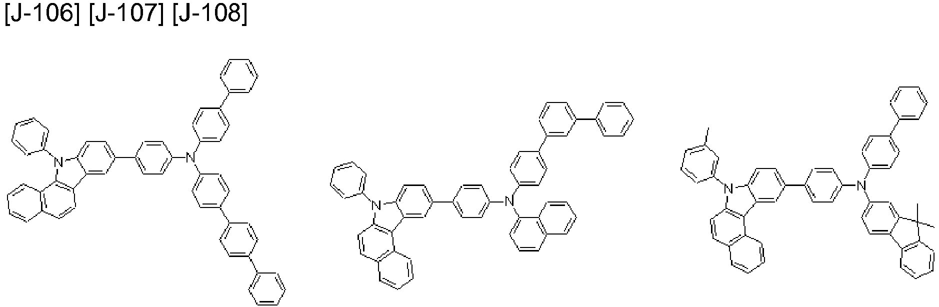

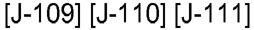

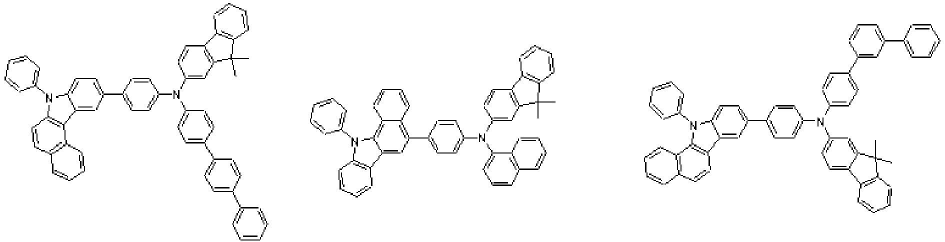

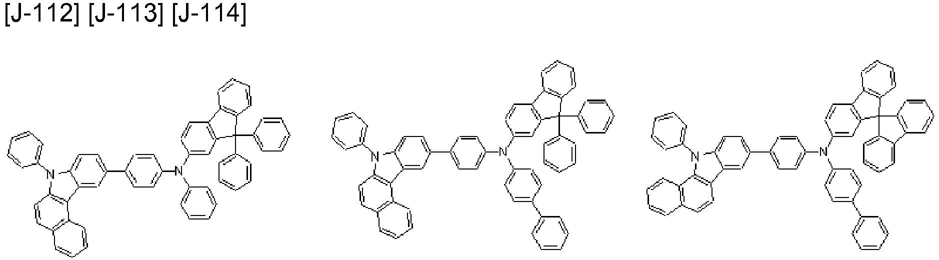

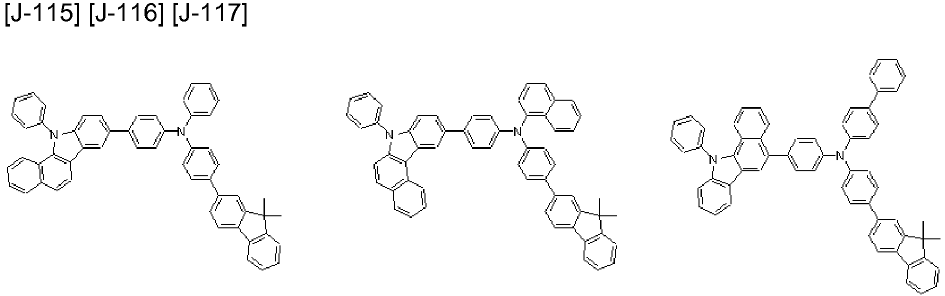

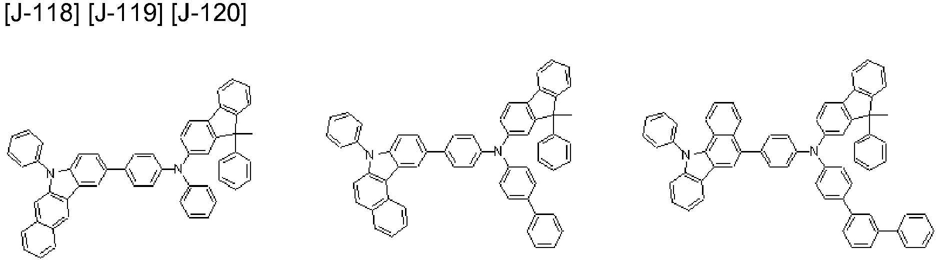

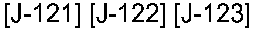

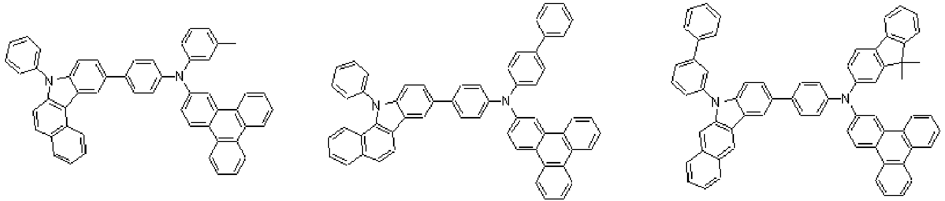

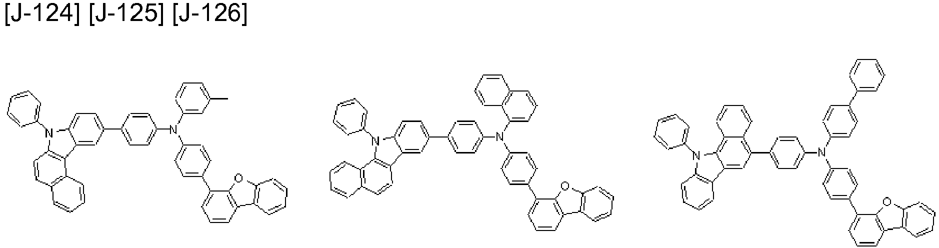

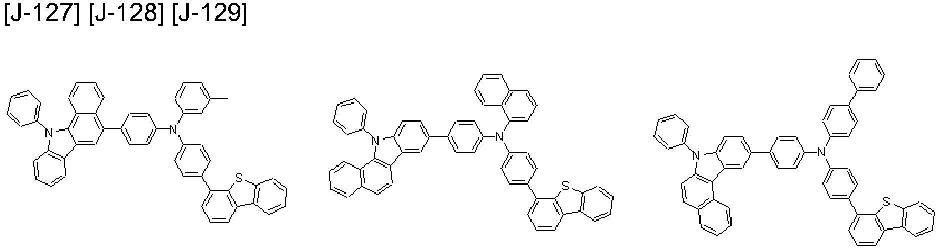

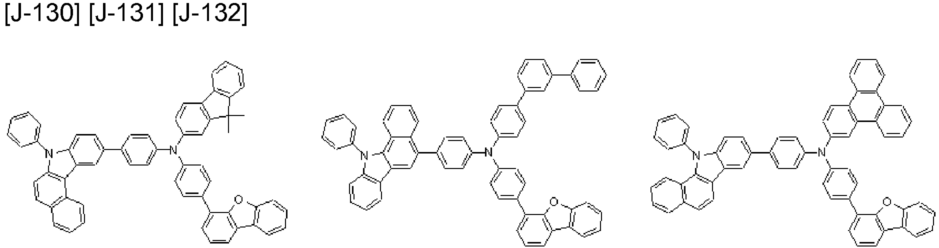

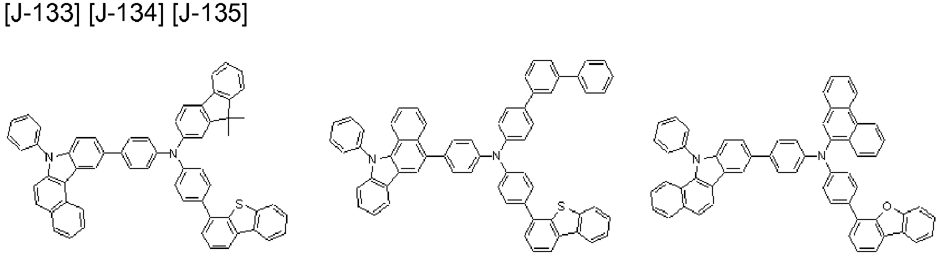

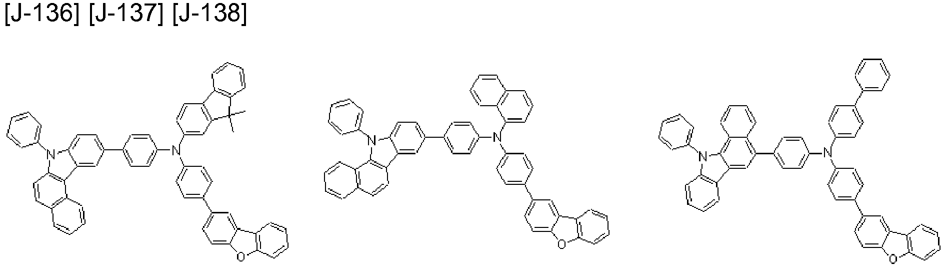

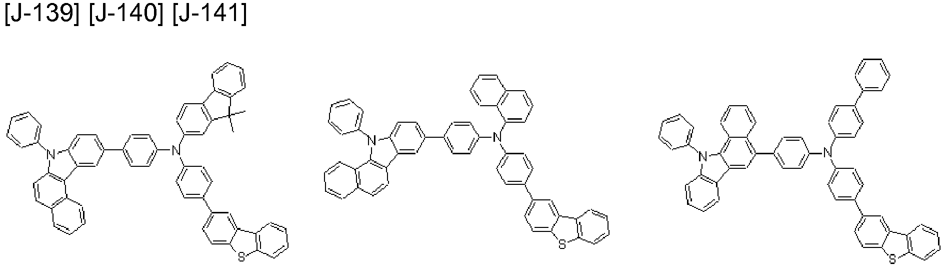

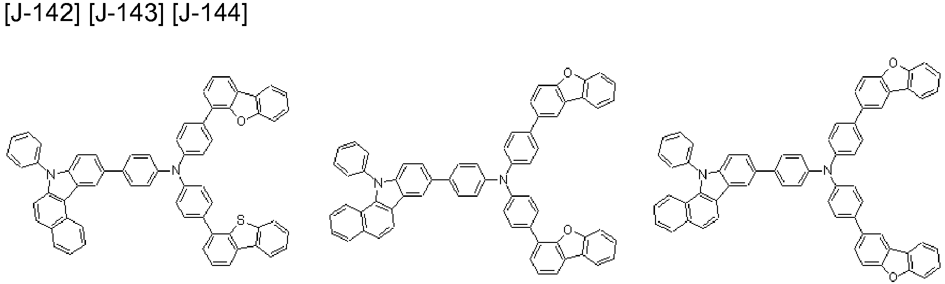

The compound for an organic optoelectronic device including the above compounds has a glass transition temperature of greater than or equal to 110 °C and a thermal decomposition temperature of greater than or equal to 400 °C,. Thereby, it is possible to produce an organic optoelectronic device having a high efficiency.

The compound for an organic optoelectronic device including the above compounds may play a role for emitting light or injecting and/or transporting electrons, and also act as a light emitting host with an appropriate dopant. In other words, the compound for an organic optoelectronic device may be used as a phosphorescent or fluorescent host material, a blue light emitting dopant material, or a hole transport material.

The compound for an organic optoelectronic device according to one embodiment of the present invention is used for an organic thin layer, and it may improve the life-span characteristics, efficiency characteristics, electrochemical stability, and thermal stability of an organic optoelectronic device and decrease the driving voltage.

The organic optoelectronic device according to one embodiment of the present invention may be an organic photoelectric device, an organic light emitting diode, an organic solar cell, an organic transistor, an organic photo conductor drum, or an organic memory device. Particularly, the compound for an organic optoelectronic device according to one embodiment may be included in an electrode or an electrode buffer layer in the organic solar cell to improve the quantum efficiency, and it may be used as an electrode material for a gate, a source-drain electrode, or the like in the organic transistor.

Hereinafter, an organic light emitting diode is specifically described.

In one embodiment of the present invention, the organic thin layer may include a layer selected from an emission layer, a hole transport layer (HTL), a hole injection layer (HIL), an electron transport layer (ETL), an electron injection layer (EIL), a hole blocking layer, and a combination thereof.

FIGS. 1 and 2 are cross-sectional views of each organic light emitting diode according to one embodiment.

Referring to FIG. 1, an organic optoelectric device 100 according to one embodiment includes an anode 120 and a cathode 110 facing each other and an organic layer 105 interposed between the anode 120 and cathode 110.

The anode 120 may be made of a conductor having a large work function to help hole injection, and may be for example metal, metal oxide and/or a conductive polymer. The anode 120 may be, for example a metal or an alloy thereof such as nickel, platinum, vanadium, chromium, copper, zinc, gold, and the like; metal oxide such as zinc oxide, indium oxide, indium tin oxide (ITO), indium zinc oxide (IZO), and the like; a combination of metal and oxide such as ZnO and Al or SnO₂ and Sb; a conductive polymer such as poly(3-methylthiophene), poly(3,4-(ethylene-1,2-dioxy)thiophene) (PEDT), polypyrrole, and polyaniline, but is not limited thereto. Preferably, the anode may be a transparent electrode including ITO (indium tin oxide).

The cathode 110 may be made of a conductor having a small work function to help electron injection, and may be for example metal, metal oxide and/or a conductive polymer. The cathode 110 may be for example a metal or an alloy thereof such as magnesium, calcium, sodium, potassium, titanium, indium, yttrium, lithium, gadolinium, aluminum silver, tin, lead, cesium, barium, and the like; a multi-layer structure material such as LiF/Al, LiO₂/Al, LiF/Ca, LiF/Al and BaF₂/Ca, but is not limited thereto. Preferably, the cathode may be a metal electrode such as aluminum.

Referring to FIG. 2, an organic light emitting diode 200 further includes a hole auxiliary layer 140 as well as an emission layer 130. The hole auxiliary layer 140 may further increase hole injection and/or hole mobility between the anode 120 and emission layer 130 and block electrons. The hole auxiliary layer 140 may be, for example a hole transport layer (HTL), a hole injection layer (HIL), and/or an electron blocking layer, and may include at least one layer. The compound may be included in the emission layer 230 and/or the hole auxiliary layer 140.

Even though not shown in FIG. 1 or 2, the organic layer 105 may further include an electron injection layer (EIL), an electron transport layer (ETL), an auxiliary electron transport layer (ETL), a hole transport layer (HTL), an auxiliary hole transport layer (HTL), a hole injection layer (HIL) or a combination thereof. The compound of the present invention may be included in the organic layer. The organic light emitting diodes 100 and 200 may be manufactured by: forming an anode or a cathode on a substrate; forming an organic thin layer in accordance with a dry coating method such as evaporation, sputtering, plasma plating, and ion plating or a wet coating method such as spin coating, dipping, and flow coating; and providing a cathode or an anode thereon.

In one embodiment of the present invention, the compound represented by the Chemical Formula A-1 may have a HOMO level of greater than or equal to 5.4eV and less than or equal to 5.8eV.

In one embodiment of the present invention, the compound represented by the Chemical Formula A-1 may have triplet exciton energy (T1) of greater than or equal to 2.5eV and less than or equal to 2.9eV.

In one embodiment of the present invention, the compound represented by the Chemical Formula B-1 may have a HOMO level of greater than or equal to 5.2eV and less than or equal to 5.6eV.

According to another embodiment of the present invention, a display device including the organic light emitting diode is provided.

Hereinafter, the embodiments are illustrated in more detail with reference to examples. These examples, however, should not in any sense be interpreted as limiting the scope of the present invention.

### (Preparation of Compound)

### Synthesis Example 1: Preparation of Compound Represented by Compound A-6

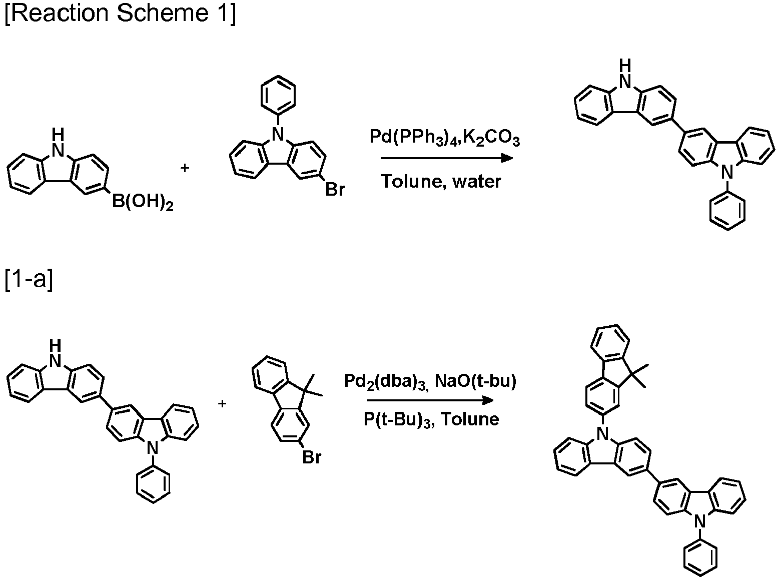

### First step; Synthesis of Intermediate Product (1-a)

10 g (47.39 mmol) of carbazole-3-boronic acid (UMT CO.,Ltd.), 16.80g (52.13 mmol) of 9-phenyl-3-bromo carbazole (UMT CO.,Ltd.), 0.548 g (0.47 mmol) of Pd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18.0 g (yield : 93%) of an intermediate product (1-a).

### Second step; Synthesis of Compound A-6

10.0 g (24.48 mmol) of the intermediate product (1-a), 7.02 g (25.70 mmol) of 2-bromo dimethylfluorene (Wischem Co., Ltd.), 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added, and agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 14.4g (yield 98%) of a target compound A-6 (LC Mass measurement: 601 g/mol).

### Synthesis Example 2: Preparation of Compound Represented by Compound A-7

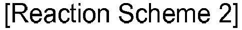

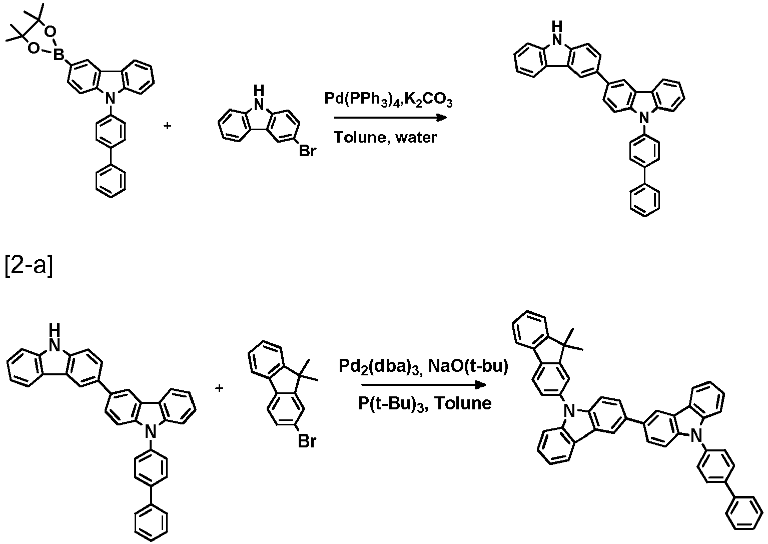

### First step; Synthesis of Intermediate Product (2-a)

20.0 g (44.91 mmol) of 9-biphenylcarbazole-3-pinacolboronic ester (Wischem Co., Ltd.), 11.6 g (47.39 mmol) of 3-bromo carbazole (Aldrich), 0.519 g (0.45 mmol) of Pd(PP₃)₄ and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (2-a).

### Second step; Synthesis of Compound A-7

10.0 g (20.64 mmol) of the intermediate product (2-a), 5.92 g (21.67 mmol) of 2-bromo dimethylfluorene, 2.18 g (22.70 mmol) of NaO(t-Bu) and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 13.5 g (yield 97%) of a target compound A-7 (LC Mass measurement: 677 g/mol).

### Synthesis Example 3: Preparation of Compound Represented by Compound A-8

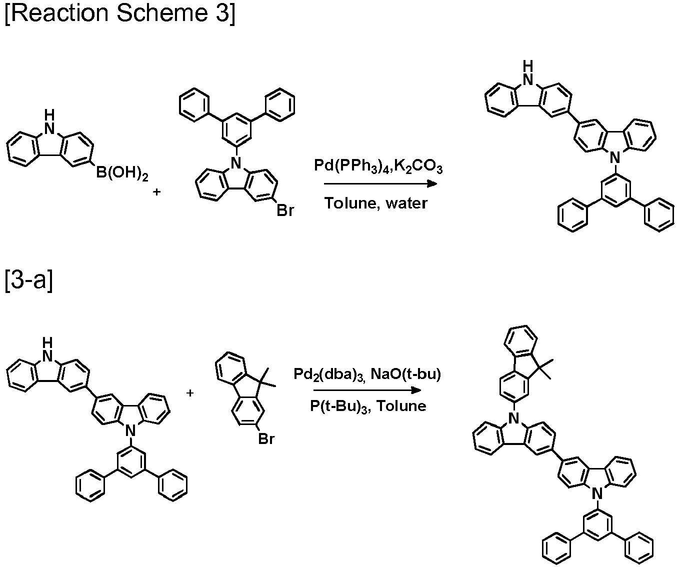

### First step; Synthesis of Intermediate Product (3-a)

10 g (47.39 mmol) of carbazole-3-boronic acid, 9-terphenyl-3-bromo carbazole (WO 2001/72927) 24.73 g (52.13 mmol), 0.548 g (0.47 mmol) of Pd(PP₃)₄ and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate to obtain 22 g (yield : 83%) of an intermediate product (3-a).

### Second step; Synthesis of Compound A-8

10.0 g (17.84 mmol) of the intermediate product (3-a), 5.12 g (18.73 mmol) of 2-bromo dimethylfluorene, 1.89 g (19.62 mmol) of NaO(t-Bu), 0.163 g (0.18 mmmol) of Pd₂(dba)₃ were suspended in 100 mL of toluene, 0.11 mL (0.54 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 13.0 g (yield 97%) of a target compound A-8 (LC Mass measurement: 754 g/mol).

### Synthesis Example 4: Preparation of Compound Represented by Compound A-9

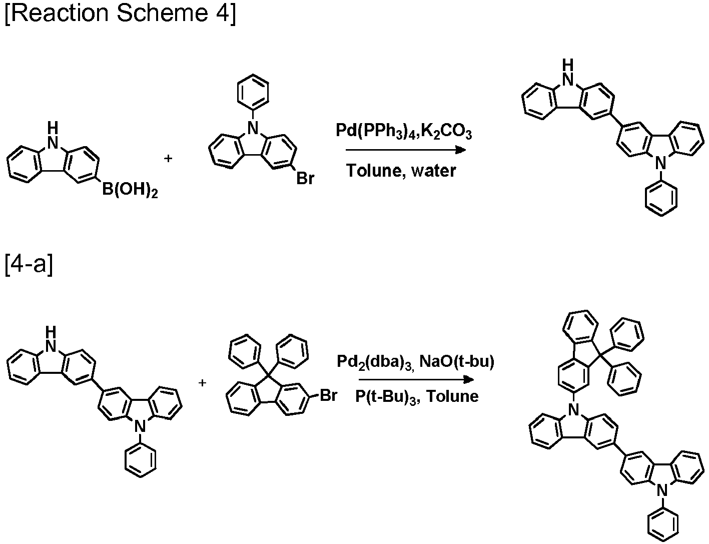

### First step; Synthesis of Intermediate Product (4-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, K₂CO₃ 13.10 g (94.78 mmmol) were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18 g (yield : 93%) of an intermediate product (4-a).

### Second step; Synthesis of Compound A-9

10.0 g (24.48 mmol) of the intermediate product (4-a), 10.21 g (25.70 mmol) of 2-bromo diphenylfluorene (Wischem Co., Ltd.), 2.59 g (26.93 mmol) of NaO(t-Bu), and 0.224 g (0.24 mmmol) of Pd₂(dba)₃ were suspended in 100 mL of toluene, 0.15 mL (0.73 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 17.2g (yield 97%) of a target compound A-9 (LC Mass measurement: 724 g/mol).

### Synthesis Example 5: Preparation of Compound Represented by Compound A-10

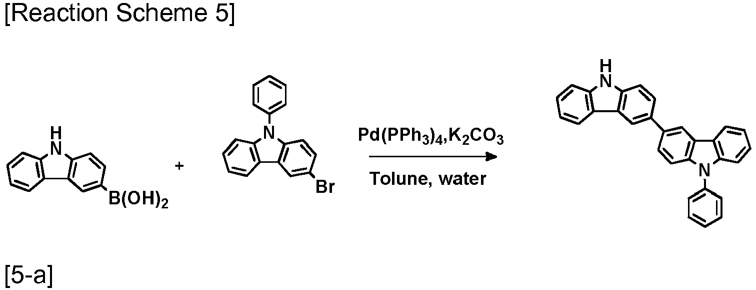

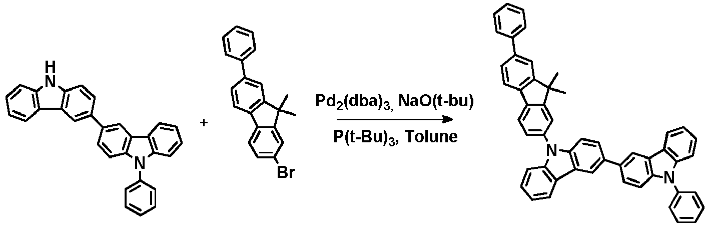

### First step; Synthesis of Intermediate Product (5-a)

10 g (47.39 mmol) of carbazole-3-boronic acid, 16.80 g (52.13 mmol) of 9-phenyl-3-bromo carbazole, 0.548 g (0.47 mmol) of Pd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining an intermediate product (5-a) 18 g (yield : 93%).

### Second step; Synthesis of Compound A-10

10.0 g (24.48 mmol) of the intermediate product (5-a), 8.98 g (25.70 mmol) of 2-bromo-7phenyl-dimethylfluorene (Wischem Co., Ltd.), 2.59 g (26.93 mmol) of NaO(t-Bu), and 0.224 g (0.24 mmmol) of Pd₂(dba)₃ were suspended in 100 mL of toluene, 0.15 mL (0.73 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 15.8 g (yield 95%) of a target compound A-10 (LC Mass measurement: 677 g/mol).

### Synthesis Example 6: Preparation of Compound Represented by Compound A-11

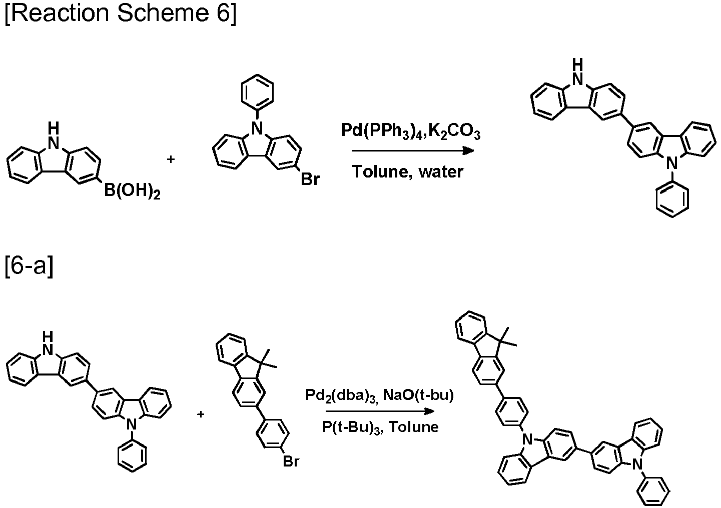

### First step; Synthesis of Intermediate Product (6-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining an intermediate product (6-a) 18 g (yield : 93%).

### Second step; Synthesis of Compound A-11

10.0 g (24.48 mmol) of the intermediate product (6-a), 8.98 g (25.70 mmol) of 2-bromo phenyl-dimethylfluorene (Wischem Co., Ltd.), 2.59 g (26.93 mmol) of NaO(t-Bu), and 0.224 g (0.24 mmmol) of Pd₂(dba)₃ were suspended in 100 mL of toluene, 0.15 mL (0.73 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using a silica gel column chromatography and was recrystallized with dichloromethane and acetone, obtaining 16.0 g (yield 97%) of a target compound A-11 (LC Mass measurement: 677 g/mol).

### Synthesis Example 7: Preparation of Compound Represented by Compound A-12

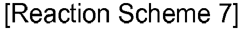

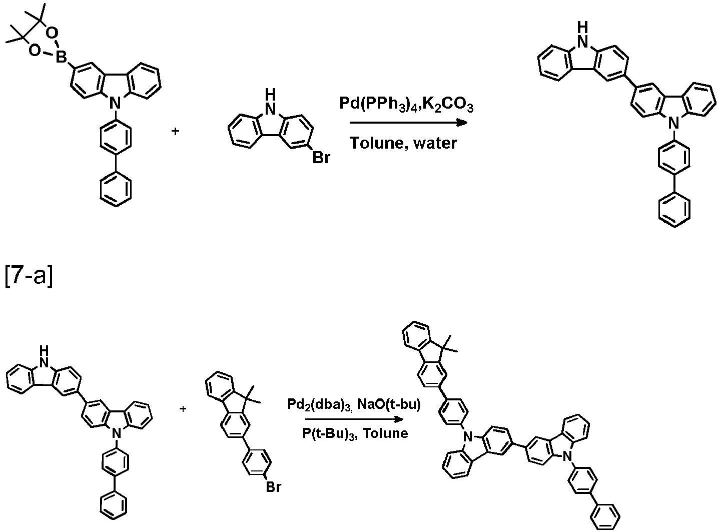

### First step; Synthesis of Intermediate Product (7-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (7-a).

### Second step; Synthesis of Compound A-12

10.0 g (20.64 mmol) of the intermediate product (7-a), 7.57 g (21.67 mmol) of 2-bromophenyl-dimethylfluorene, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 15.1g (yield 97%) of a target compound A-12 (LC Mass measurement: 753 g/mol).

### Synthesis Example 8: Preparation of Compound Represented by Compound A-13

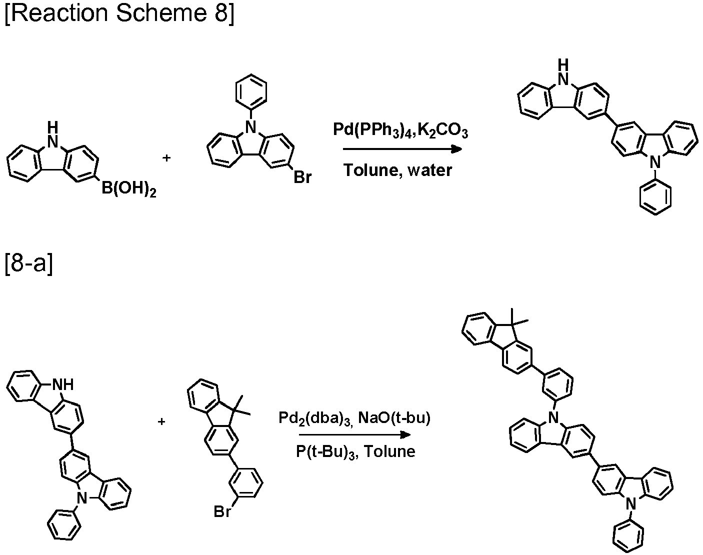

### First step; Synthesis of Intermediate Product (8-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, K₂CO₃ 13.10 g (94.78 mmmol) were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18 g (yield : 93%) of an intermediate product (8-a).

### Second step; Synthesis of Compound A-13

10.0 g (24.48 mmol) of the intermediate product (8-a), 8.98 g (21.67 mmol) of 2-(2-bromo-phenyl)-dimethylfluorene (Wischem Co., Ltd.), 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using a silica gel column chromatography and was recrystallized with dichloromethane and acetone, obtaining 15.8 g (yield 95%) of a target compound A-13 (LC Mass measurement: 677 g/mol).

### Synthesis Example 9: Preparation of Compound Represented by Compound A-14

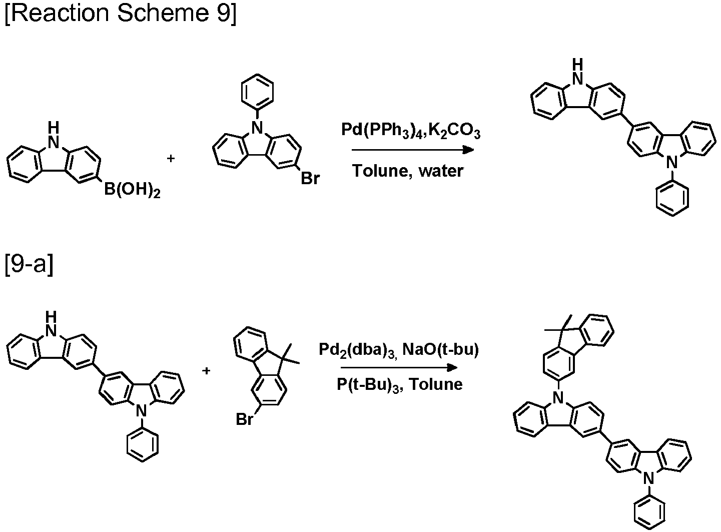

### First step; Synthesis of Intermediate Product (9-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18.0 g (yield : 93%) of an intermediate product (9-a).

### Second step; Synthesis of Compound A-14

10.0 g (24.48 mmol) of the intermediate product (9-a), 7.02 g (25.70 mmol) of 3-bromo dimethylfluorene (Wischem Co., Ltd.), 2.59 g (26.93 mmol) of NaO(t-Bu), and 0.224 g (0.24 mmmol) of Pd₂(dba)₃ were suspended in 100 mL of toluene, 0.15 mL (0.73 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using a silica gel column chromatography and was recrystallized with dichloromethane and acetone, obtaining 12.2g (yield 83%) of a target compound A-14 (LC Mass measurement: 601 g/mol).

### Synthesis Example 10: Preparation of Compound Represented by Compound A-15

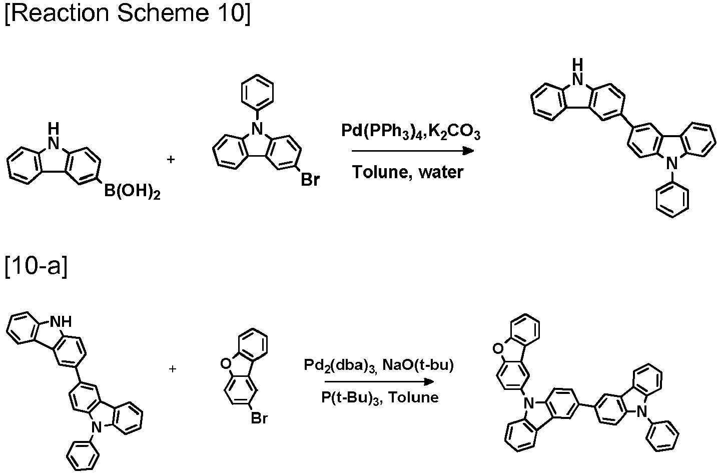

### First step; Synthesis of Intermediate Product (10-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18 g (yield : 93%) of an intermediate product (10-a).

### Second step; Synthesis of Compound A-15

10.0 g (24.48 mmol) of intermediate product (10-a), 6.35 g (21.67 mmol) of 2-bromo dibenzofuran (Wischem Co., Ltd.), 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 12.7g (yield 90%) of a target compound A-15 (LC Mass measurement: 575 g/mol).

### Synthesis Example 11: Preparation of Compound Represented by Compound A-16

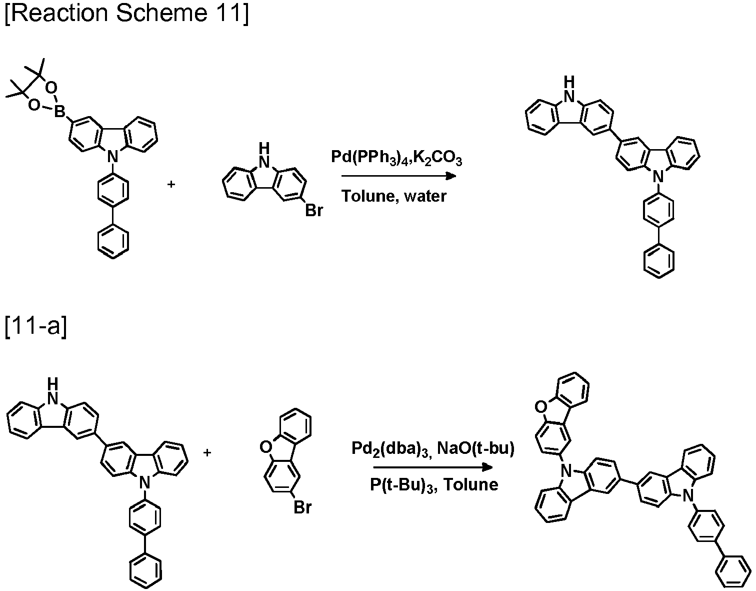

### First step; Synthesis of Intermediate Product (11-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (11-a).

### Second step; Synthesis of Compound A-16

10.0 g (20.64 mmol) of the intermediate product (11-a), 5.35 g (21.67 mmol) of 2-bromo dibenzofuran, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 11.4g (yield 96%) of a target compound A-16 (LC Mass measurement: 651 g/mol).

### Synthesis Example 12: Preparation of Compound Represented by Compound A-17

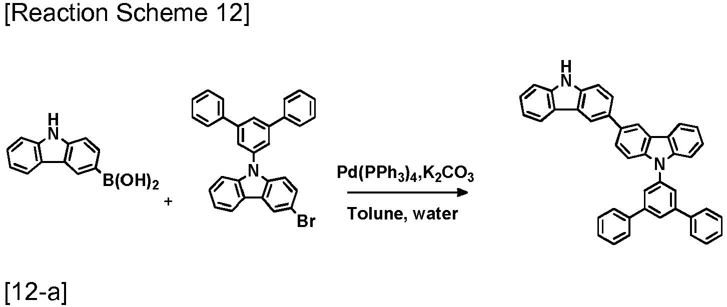

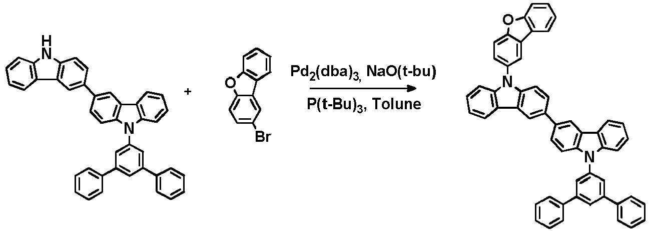

### First step; Synthesis of Intermediate Product (12-a)

10 g (47.39 mmol) of carbazole-3-boronic acid, 24.73 g (52.13 mmol) of 9-terphenyl-3-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 22 g (yield : 83%) of an intermediate product (12-a).

### Second step; Synthesis of Compound A-17

10.0 g (17.84 mmol) of the intermediate product (12-a), 4.63 g (18.73 mmol) of 2-bromo dibenzofuran, 1.89 g (19.62 mmol) of NaO(t-Bu), and 0.163 g (0.18 mmmol) of Pd₂(dba)₃ were suspended in 75 mL of toluene, 0.11 mL (0.54 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using a silica gel column chromatography and was recrystallized with dichloromethane and acetone, obtaining 11.9 g (yield 92%) of a target compound A-17 (LC Mass measurement: 727 g/mol).

### Synthesis Example 13: Preparation of Compound Represented by Compound A-18

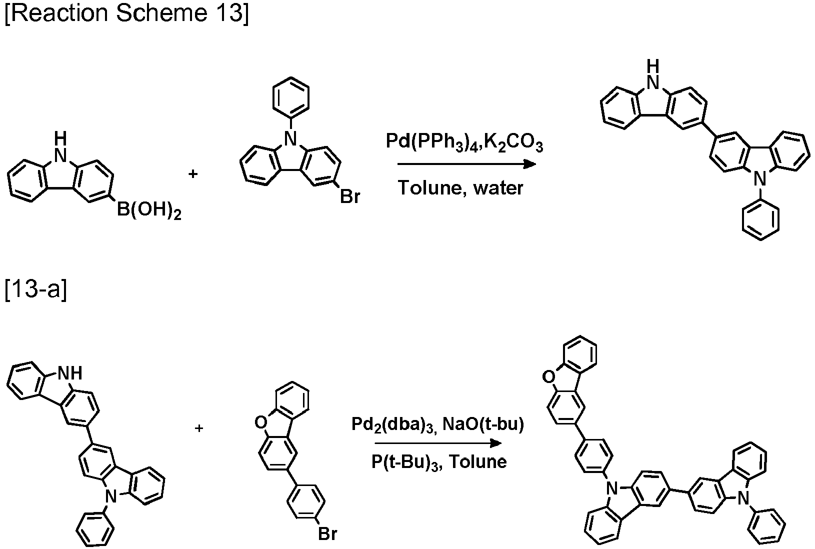

### First step; Synthesis of Intermediate Product (13-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, and K₂CO₃ 13.10 g (94.78 mmmol) were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 18 g (yield : 93%) of an intermediate product (13-a).

### Second step; Synthesis of Compound A-18

10.0 g (24.48 mmol) of the intermediate product (13-a), 8.31 g (25.7 mmol) of 2-(4-bromo phenyl) dibenzofuran (Wischem Co., Ltd.), 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 13.5g (yield 85%) of a target compound A-18 (LC Mass measurement: 651 g/mol).

### Synthesis Example 14: Preparation of Compound Represented by Compound A-19

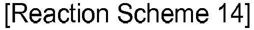

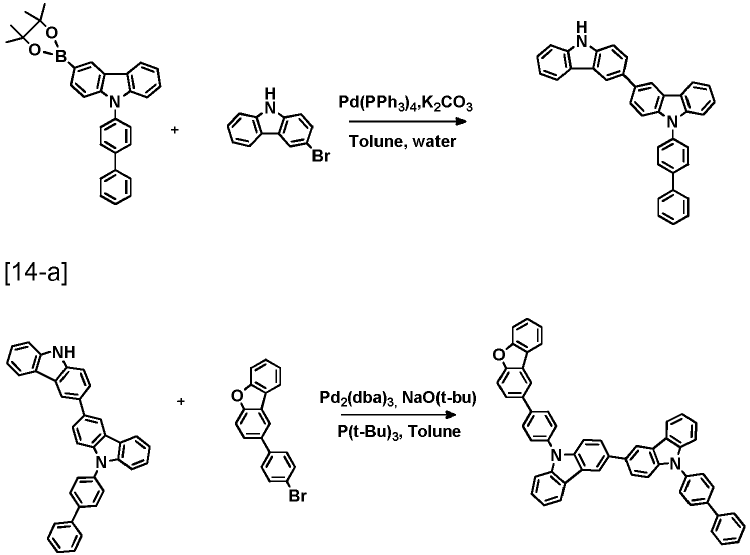

### First step; Synthesis of Intermediate Product (14-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (14-a).

### Second step; Synthesis of Compound A-19

10.0 g (20.64 mmol) of the intermediate product (14-a), 7.00 g (21.67 mmol) of 2-(4bromo phenyl) dibenzofuran, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 12.7g (yield 85%) of a target compound A-19 (LC Mass measurement: 727 g/mol).

### Synthesis Example 15: Preparation of Compound Represented by Compound A-20

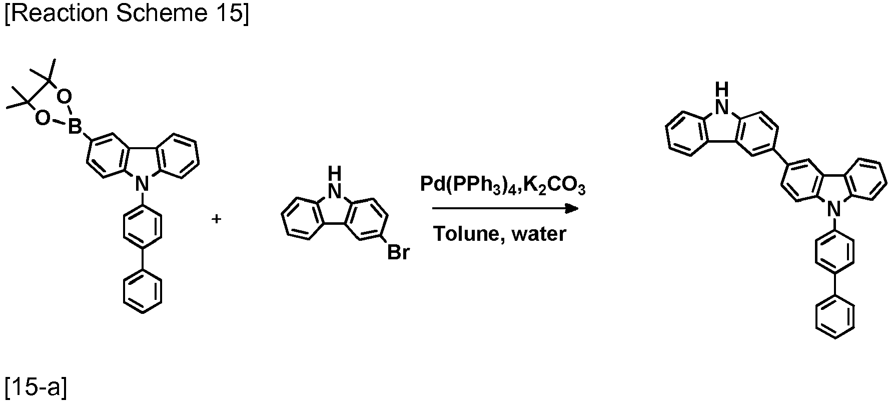

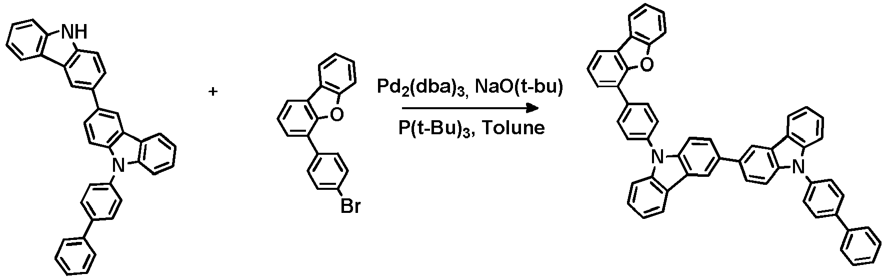

### First step; Synthesis of Intermediate Product (15-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (15-a).

### Second step; Synthesis of Compound A-20

10.0 g (20.64 mmol) of the intermediate product (15-a), 7.00 g (21.67 mmol) of 4-(4bromo phenyl) dibenzofuran (Wischem Co., Ltd.), 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 12.0g (yield 80%) of a target compound A-20 (LC Mass measurement: 727 g/mol).

### Synthesis Example 16: Preparation of Compound Represented by Compound A-21

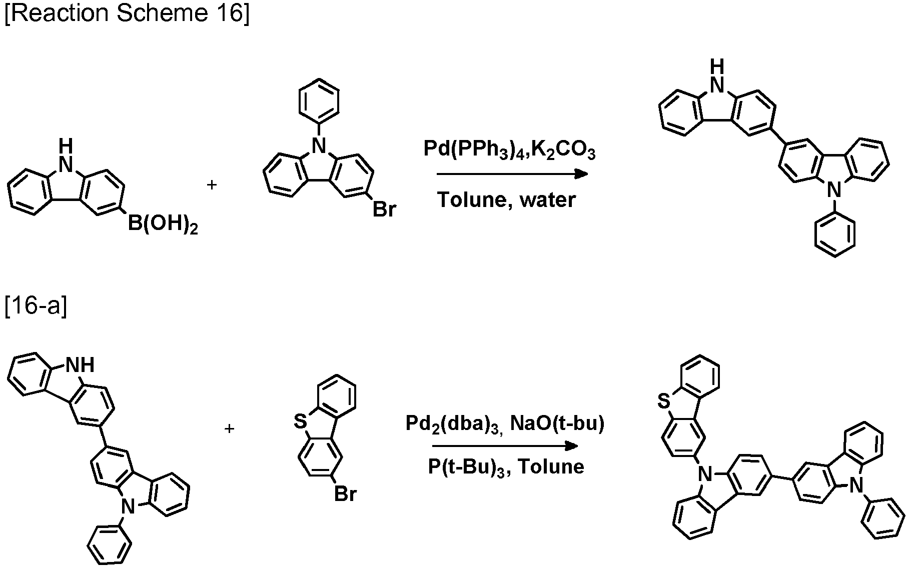

### First step; Synthesis of Intermediate Product (16-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18 g (yield : 93%) of an intermediate product (16-a).

### Second step; Synthesis of Compound A-21

10.0 g (24.48 mmol) of the intermediate product (16-a), 6.76 g (25.7 mmol) of 2-bromo dibenzothiophene (Wischem Co., Ltd.), 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 14.0g (yield 97%) of a target compound A-21 (LC Mass measurement: 591 g/mol).

### Synthesis Example 17: Preparation of Compound Represented by Compound A-22

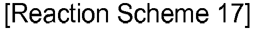

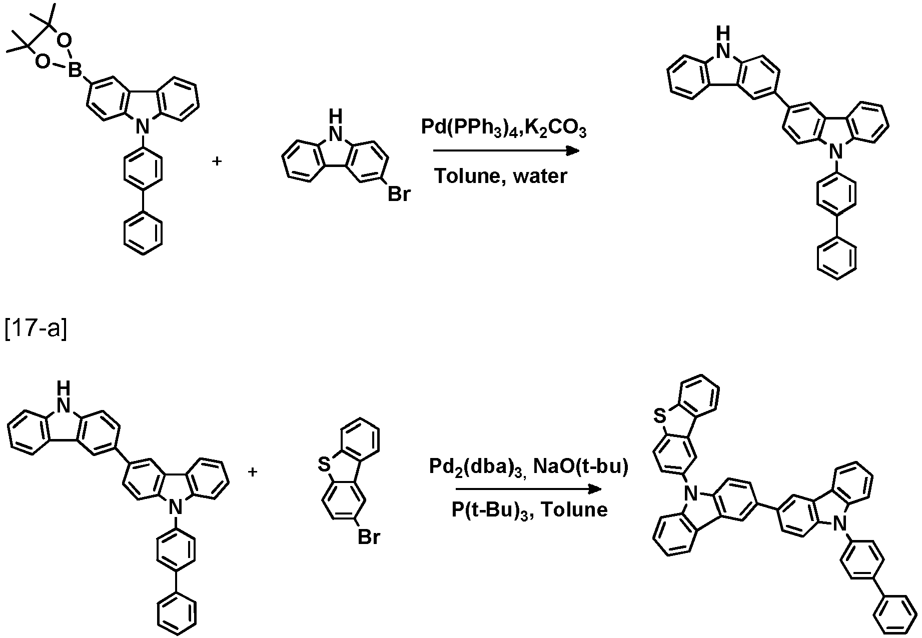

### First step; Synthesis of Intermediate Product (17-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (17-a).

### Second step; Synthesis of Compound A-22

10.0 g (20.64 mmol) of the intermediate product (17-a), 5.35 g (21.67 mmol) of 2-bromo dibenzothiophene, 2.18 g (22.70 mmol) of NaO(t-Bu), 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 12.7g (yield 92%) of a target compound A-22 (LC Mass measurement: 667 g/mol).

### Synthesis Example 18: Preparation of Compound Represented by Compound A-23

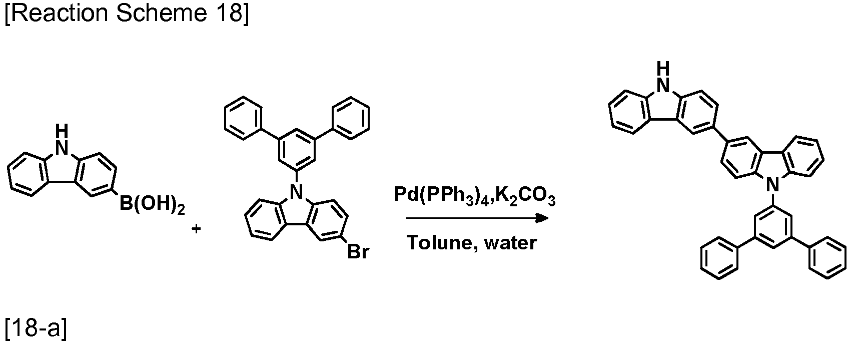

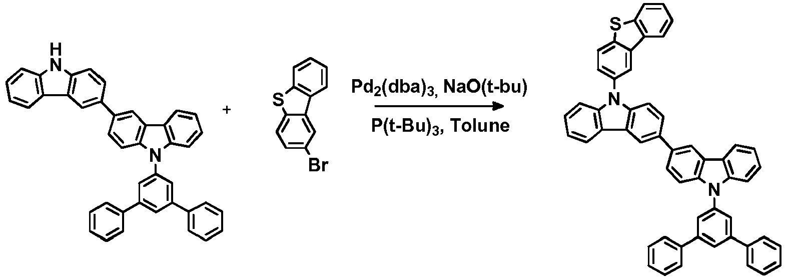

### First step; Synthesis of Intermediate Product (18-a)

10 g (47.39 mmol) of carbazole-3-boronic acid, 24.73 g (52.13 mmol) of 9-terphenyl-3-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 22 g (yield : 83%) of an intermediate product (18-a).

### Second step; Synthesis of Compound A-23

10.0 g (17.84 mmol) of the intermediate product (18-a), 4.93 g (18.73 mmol) of 2-bromo dibenzothiophene, 1.89 g (19.62 mmol) of NaO(t-Bu), and 0.163 g (0.18 mmmol) of Pd₂(dba)₃ were suspended in 75 mL of toluene, 0.11 mL (0.54 mmol) of tri-tertiary-butylphosphine was added, and the resultant was agitated for 18 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using a silica gel column chromatography and was recrystallized with dichloromethane and acetone, obtaining 11.9g (yield 90%) of a target compound A-23 (LC Mass measurement: 743 g/mol).

### Synthesis Example 19: Preparation of Compound Represented by Compound A-24

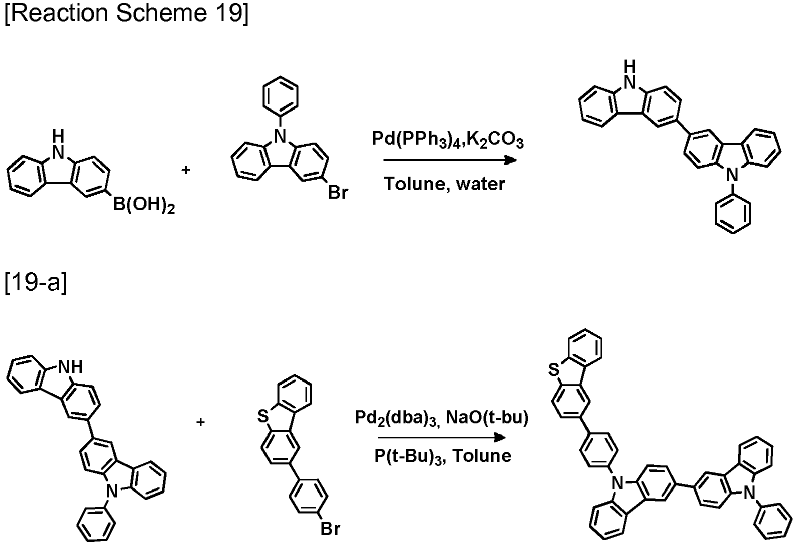

### First step; Synthesis of Intermediate Product (19-a)

10 g (47.39 mmol) of carbazole-3-boronic acid, 16.80 g (52.13 mmol) of 9-phenyl-3-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 18 g (yield : 93%) of an intermediate product (19-a).

### Second step; Synthesis of Compound A-24

10.0 g (24.48 mmol) of the intermediate product (19-a), 8.72 g (25.7 mmol) of 2-(4bromo phenyl) dibenzothiophene (Wischem Co., Ltd.), 2.59 g (26.93 mmol) of NaO(t-Bu), and 0.224 g (0.24 mmmol) of Pd₂(dba)₃ were suspended in 100 mL of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 13.1g (yield 80%) of a target compound A-24 (LC Mass measurement: 667 g/mol).

### Synthesis Example 20: Preparation of Compound Represented by Compound A-25

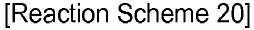

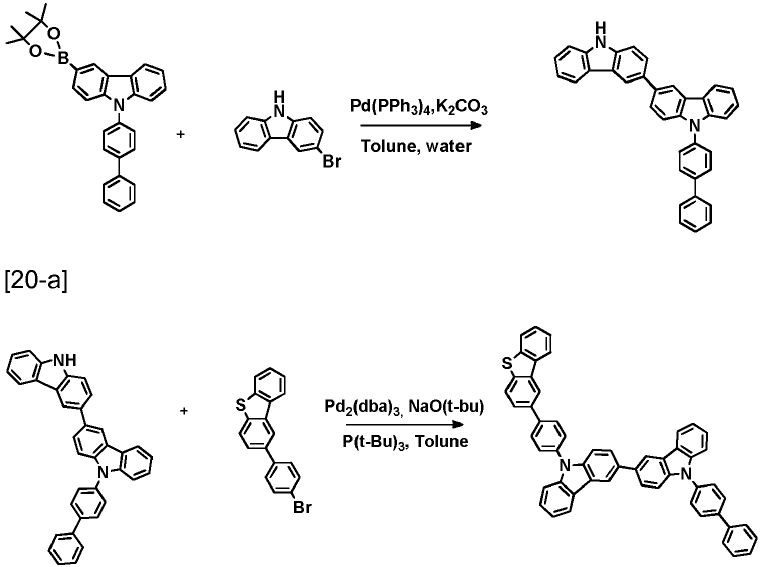

### First step; Synthesis of Intermediate Product (20-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (20-a).

### Second step; Synthesis of Compound A-25

10.0 g (20.64 mmol) of the intermediate product (20-a), 7.35 g (21.67 mmol) of 2- (4bromo phenyl) dibenzothiophene, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 13.0g (yield 85%) of a target compound A-25 (LC Mass measurement: 743 g/mol).

### Synthesis Example 21: Preparation of Compound Represented by Compound A-26

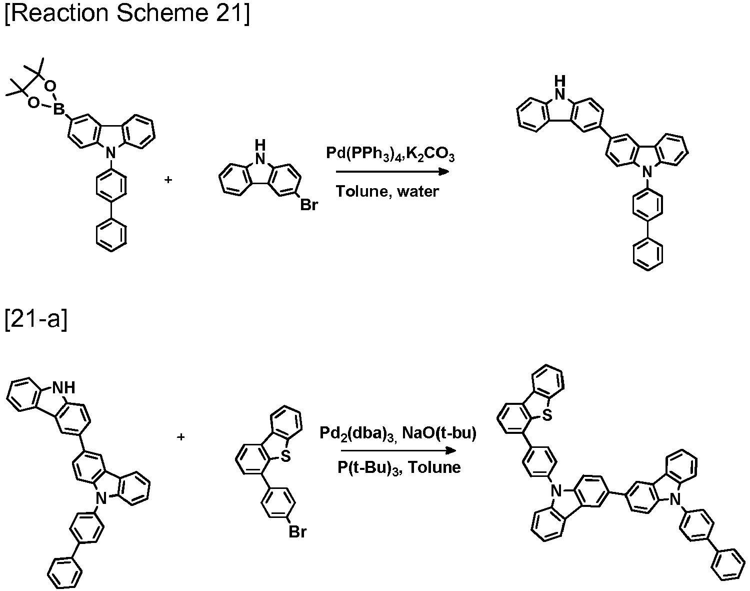

### First step; Synthesis of Intermediate Product (21-a)

20.0 g (44.91 mmol) of 9-biphenylcarbazole-3-boronic ester, 11.6 g (47.39 mmol) of 3-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.8 g (yield : 60%) of an intermediate product (21-a).

### Second step; Synthesis of Compound A-26

10.0 g (20.64 mmol) of the intermediate product (21-a), 7.00 g (21.67 mmol) of 4-(4bromo phenyl) dibenzothiophene (Wischem Co., Ltd.), 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and acetone, obtaining 12.7g (yield 83%) of a target compound A-26 (LC Mass measurement: 743 g/mol).

### Synthesis Example 22: Preparation of Compound Represented by Compound A-27

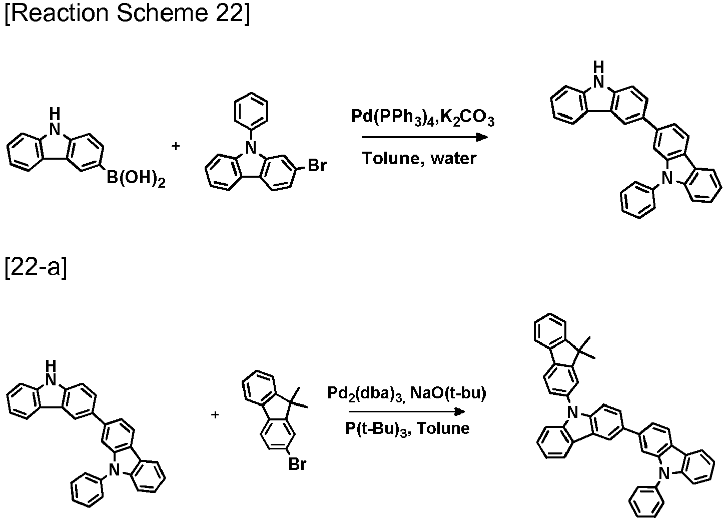

### First step; Synthesis of Intermediate Product (22-a)

10 g (47.39 mmol) of carbazole-3-boronic acid(Aldrich), 16.80 g (52.13 mmol) of 9-phenyl-2-bromo carbazole (UMT CO., Ltd.), 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 16.0 g (yield : 83%) of an intermediate product (22-a).

### Second step; Synthesis of Compound A-27

10.0 g (24.48 mmol) of the intermediate product (22-a), 7.02 g (25.70 mmol) of 2-bromo dimethylfluorene, 2.59 g (26.93 mmol) of NaO(t-Bu), and 0.224 g (0.24 mmmol) of Pd₂(dba)₃ were suspended in 100 mL of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 12.6 g (yield 86%) of a target compound A-27 (LC Mass measurement: 601 g/mol).

### Synthesis Example 23: Preparation of Compound Represented by Compound A-28

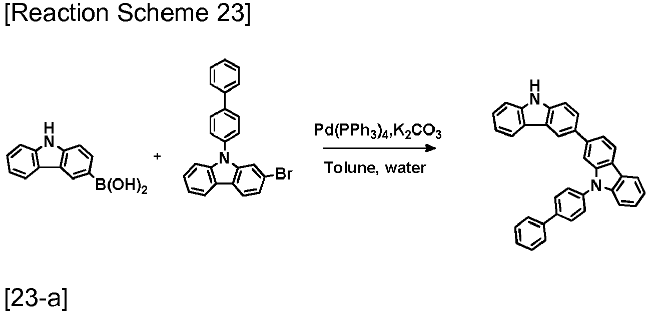

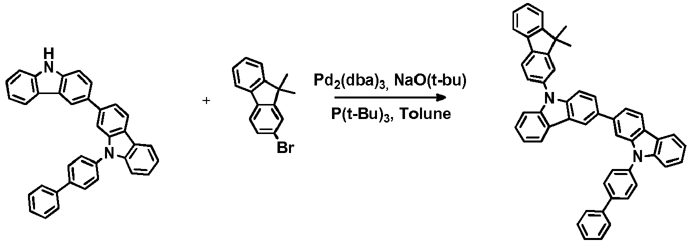

### First step; Synthesis of Intermediate Product (23-a)

10 g (47.39 mmol) of carbazole-3-boronic acid, 20.76 g (52.13 mmol) of 9-biphenyl-2-bromo carbazole (UMT CO., Ltd.), 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 16.1 g (yield : 70%) of an intermediate product (23-a).

### Second step; Synthesis of Compound A-28

10.0 g (20.64 mmol) of the intermediate product (23-a), 5.92 g (21.67 mmol) of 2-bromo dimethylfluorene, 2.59 g (26.93 mmol) of NaO(t-Bu), and 0.224 g (0.24 mmmol) of Pd₂(dba)₃ were suspended in 85 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 11.8g (yield 84%) of a target compound A-28 (LC Mass measurement: 677 g/mol).

### Synthesis Example 24: Preparation of Compound Represented by Compound A-29

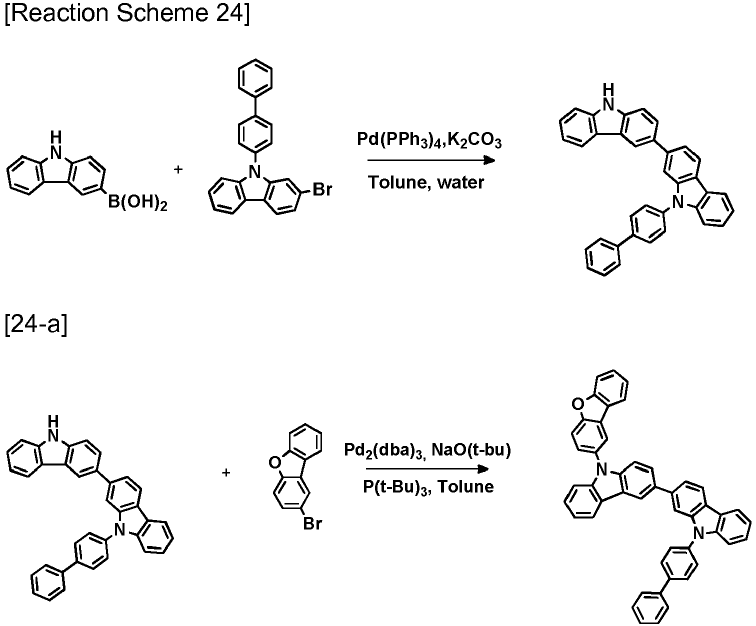

### First step; Synthesis of Intermediate Product (24-a)

10 g (47.39 mmol) of carbazole-3-boronic acid, 20.76 g (52.13 mmol) of 9-biphenyl-2-bromo carbazole, 0.548 g (0.47 mmol) ofDeletedTextsPd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 16.1 g (yield : 70%) of intermediate product (24-a).

### Second step; Synthesis of Compound A-29

10.0 g (20.64 mmol) of the intermediate product (24-a), 5.35 g (21.67 mmol) of 2-bromo dibenzofuran, 2.59 g (26.93 mmol) of NaO(t-Bu), and 0.224 g (0.24 mmmol) of Pd₂(dba)₃ were were suspended in 85 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 11.5g (yield 86%) of a target compound A-29 (LC Mass measurement: 651 g/mol).

### Synthesis Example 25: Preparation of Compound Represented by Compound A-30

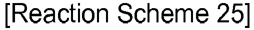

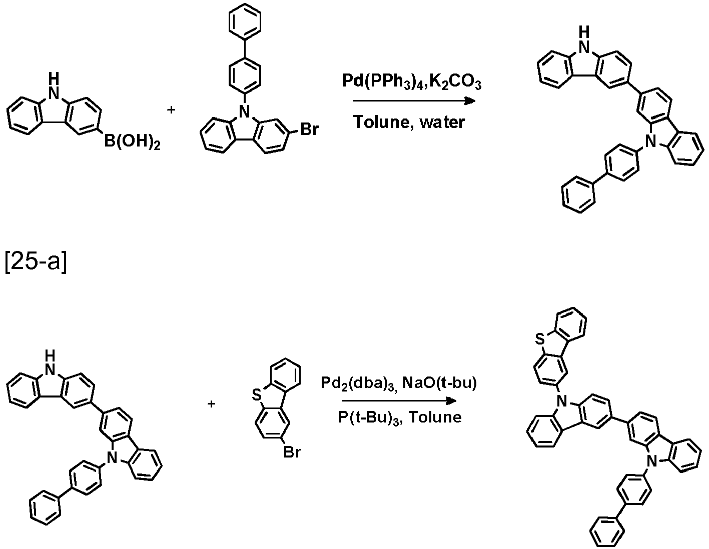

### First step; Synthesis of Intermediate Product (25-a)

10 g (47.39 mmol) of carbazole-3-boronic acid, 20.76 g (52.13 mmol) of 9-biphenyl-2-bromo carbazole, 0.548 g (0.47 mmol) of Pd(PP₃)₄, and 13.10 g (94.78 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 16.1 g (yield : 70%) of an intermediate product (25-a).

### Second step; Synthesis of Compound A-30

10.0 g (20.64 mmol) of the intermediate product (25-a), 5.70 g (21.67 mmol) of 2-bromo dibenzothiophene, 2.59 g (26.93 mmol) of NaO(t-Bu), and 0.224 g (0.24 mmmol) of Pd₂(dba)₃ were suspended in 85 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 11.7g (yield 85%) of a target compound A-30 (LC Mass measurement: 651 g/mol).

### Synthesis Example 26: Preparation of Compound Represented by Compound A-31

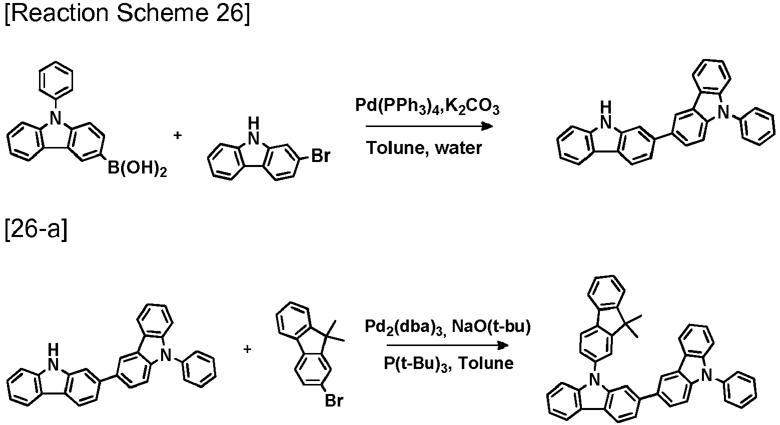

### First step; Synthesis of Intermediate Product (26-a)

10 g (34.83 mmol) of 9-phenyl carbazole-3-boronic acid (UMT CO., Ltd.), 9.43 g (38.31 mmol) of 2-bromo carbazole, 0.402 g (0.35 mmol) of Pd(PP₃)₄, and 9.63 g (69.66 mmmol) of K₂CO₃ were suspended in 150 mL of toluene and 75 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 11.0 g (yield : 77%) of an intermediate product (26-a).

### Second step; Synthesis of Compound A-31

10.0 g (24.48 mmol) of the intermediate product (26-a), 7.02 g (25.70 mmol) of 2-bromo dimethylfluorene, 2.59 g (26.93 mmol) of NaO(t-Bu), and 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 11.6g (yield 79%) of a target compound A-31 (LC Mass measurement: 601 g/mol).

### Synthesis Example 27: Preparation of Compound Represented by Compound A-32

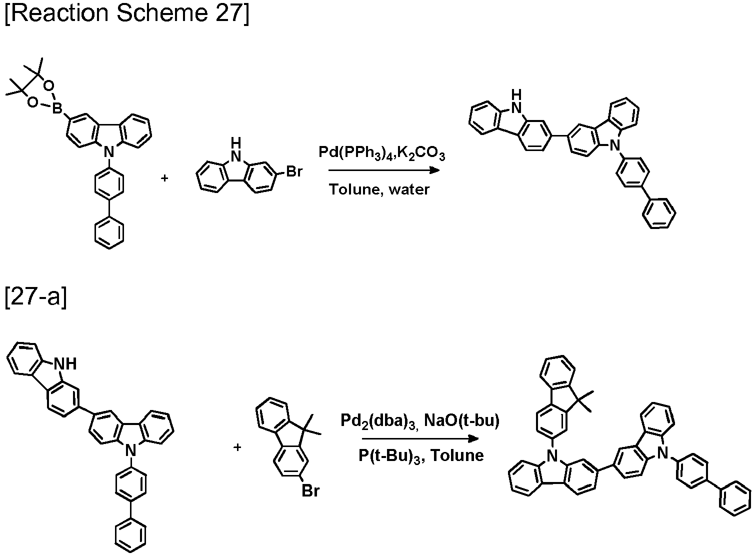

### First step; Synthesis of Intermediate Product (27-a)

20.0 g (44.91 mmol) of 9-biphenylcarbazole-3-boronic ester, 12.166 g (49.4 mmol) of 2-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.3 g (yield : 61%) of an intermediate product (27-a).

### Second step; Synthesis of Compound A-32

10.0 g (20.64 mmol) of the intermediate product (27-a), 5.92 g (21.67 mmol) of 2-bromo dimethylfluorene 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 11.2g (yield 80%) of a target compound A-32 (LC Mass measurement: 677 g/mol).

### Synthesis Example 28: Preparation of Compound Represented by Compound A-33

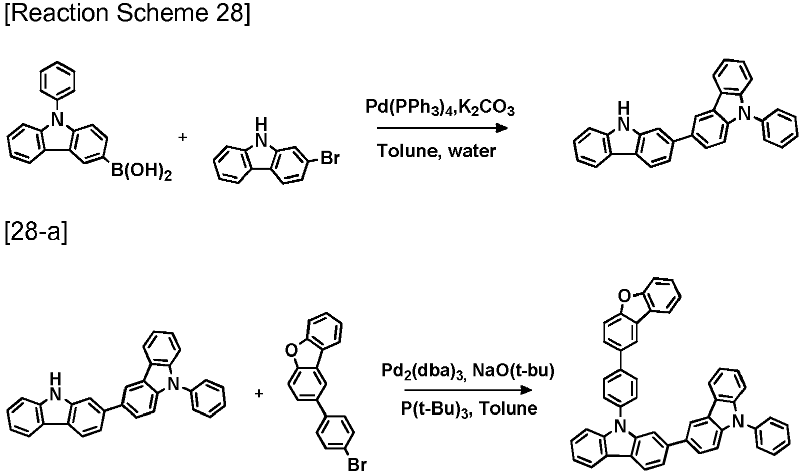

### First step; Synthesis of Intermediate Product (28-a)

10 g (34.83 mmol) of 9-phenyl carbazole-3-boronic acid, 9.43 g (38.31 mmol) of 2-bromo carbazole, 0.402 g (0.35 mmol) ofDeletedTextsPd(PP₃)₄, and 9.63 g (69.66 mmmol) of K₂CO₃ were suspended in 150 mL of toluene and 75 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 11.0 g (yield : 77%) of an intermediate product (28-a).

### Second step; Synthesis of Compound A-33

10.0 g (24.48 mmol) of the intermediate product (28-a), 8.31 g (25.70 mmol) of 2-(4-bromo phenyl) dibenzofuran, 2.59 g (26.93 mmol) of NaO(t-Bu), 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 12.0g (yield 75%) of a target compound A-33 (LC Mass measurement: 651 g/mol).

### Synthesis Example 29: Preparation of Compound Represented by Compound A-34

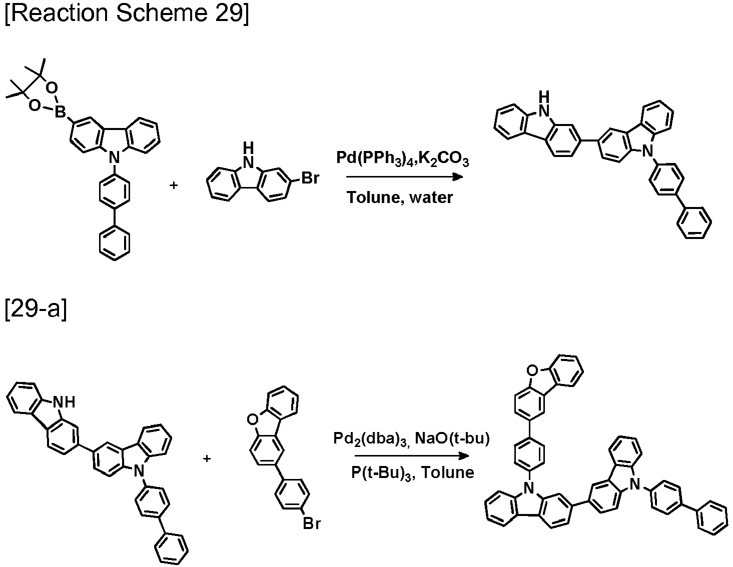

### First step; Synthesis of Intermediate Product (29-a)

20.0 g (44.91 mmol) of 9-biphenylcarbazole-3-boronic ester, 12.16 g (49.4 mmol) pf 2-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 13.3 g (yield : 61%) of an intermediate product (29-a).

### Second step; Synthesis of Compound A-34

10.0 g (20.64 mmol) of the intermediate product (29-a), 7.00 g (21.67 mmol) of 2-(4-bromo phenyl) dibenzofuran, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 12.7g (yield 85%) of a target compound A-34 (LC Mass measurement: 727 g/mol).

### Synthesis Example 30: Preparation of Compound Represented by Compound A-35

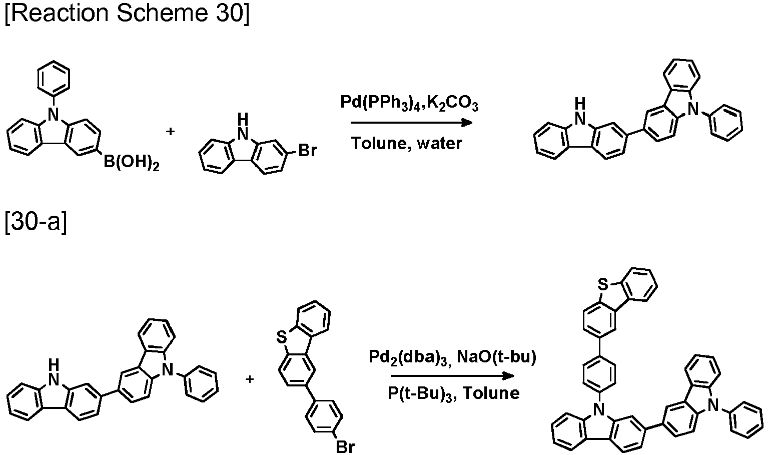

### First step; Synthesis of Intermediate Product (30-a)

10 g (34.83 mmol) of 9-phenyl carbazole-3-boronic acid, 9.43 g (38.31 mmol) of 2-bromo carbazole, 0.402 g (0.35 mmol) of Pd(PP₃)₄, and 9.63 g (69.66 mmmol) of K₂CO₃ were suspended in 150 mL of toluene and 75 mL of water, and the resultant was agitated under nitrogen stream for 18 hours while refluxing. When the reaction was terminated, the resultant was extracted with toluene and distilled water, an organic layer was dried and filtered using magnesium sulfate and the filtrated solution was concentrated under a reduced pressure. The organic solution was removed, silica gel column was performed with hexane : dichloromethane = 8 : 2(v/v) and a product solid was recrystallized with dichloromethane and ethylacetate, obtaining 11.0 g (yield : 77%) of an intermediate product (30-a).

### Second step; Synthesis of Compound A-35

10.0 g (24.48 mmol) of the intermediate product (30-a), 8.72 g (25.70 mmol) of 2-(4-bromo phenyl) dibenzothiophene, 2.59 g (26.93 mmol) of NaO(t-Bu), 0.224 g (0.24 mmmol) of Pd₂(dba)₃ were suspended in 100 ml of toluene, 0.15 mL (0.73 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 13.1g (yield 80%) of a target compound A-35 (LC Mass measurement: 667 g/mol).

### Synthesis Example 31: Preparation of Compound Represented by Compound A-36 of Compound

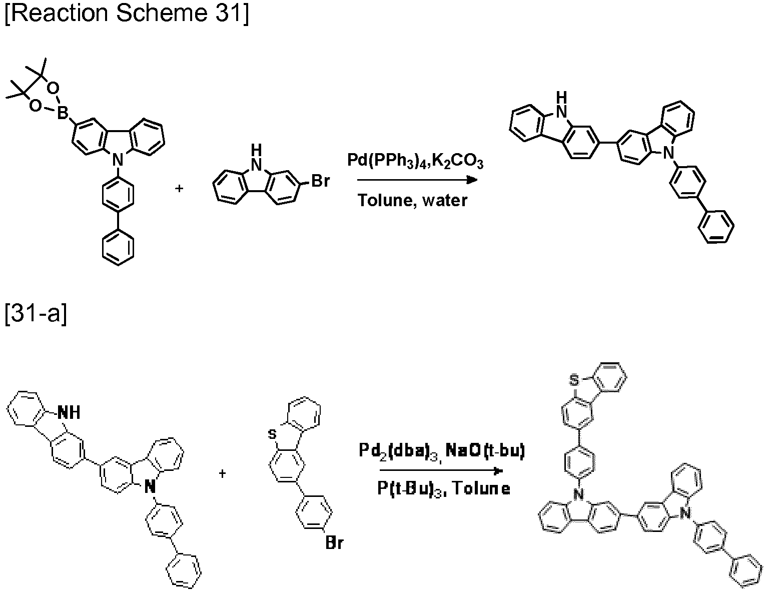

### First step; Synthesis of Intermediate Product (31-a)

20.0 g (44.91 mmol) of 9-biphenylcarbazole-3-boronic ester, 12.16 g (49.4 mmol) of , 2-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed, the resultant was recrystallized with dichloromethane, obtaining 13.3 g (yield : 61%) of an intermediate product (31-a).

### Second step; Synthesis of Compound A-36

10.0 g (20.64 mmol) of the intermediate product (31-a), 7.35 g (21.67 mmol) of 2-(4-bromo phenyl) dibenzofuran, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 12.2g (yield 80%) of a target compound A-36 (LC Mass measurement: 743 g/mol).

### Synthesis Example 32: Preparation of Compound Represented by Compound A-37

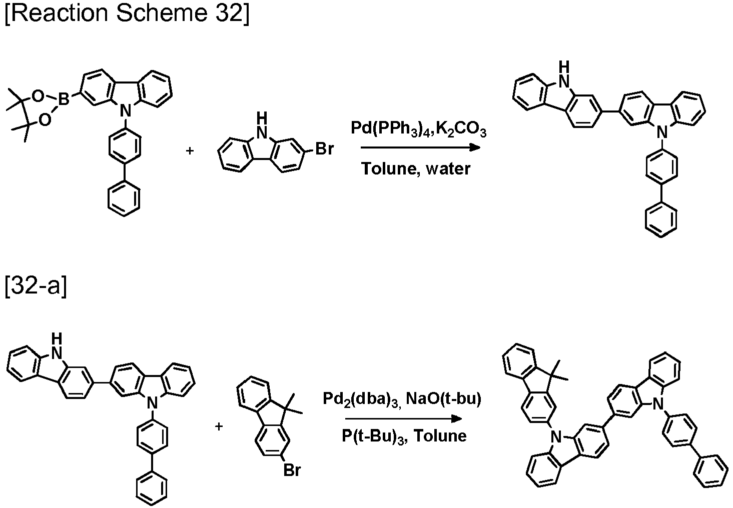

### First step; Synthesis of Intermediate Product (32-a)

20.0 g (44.91 mmol) of 9-biphenylcarbazole-2-boronic ester (UMT CO., Ltd.), 12.16 g (49.4 mmol) of 2-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 15.0 g (yield : 69%) of an intermediate product (32-a).

### Second step; Synthesis of Compound A-37

10.0 g (20.64 mmol) of the intermediate product (32-a), 5.92 g (21.67 mmol) of 2-bromo dimethylfluorene, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 12.0g (yield 86%) of a target compound A-37 (LC Mass measurement: 677 g/mol).

### Synthesis Example 33: Preparation of Compound Represented by Compound A-38

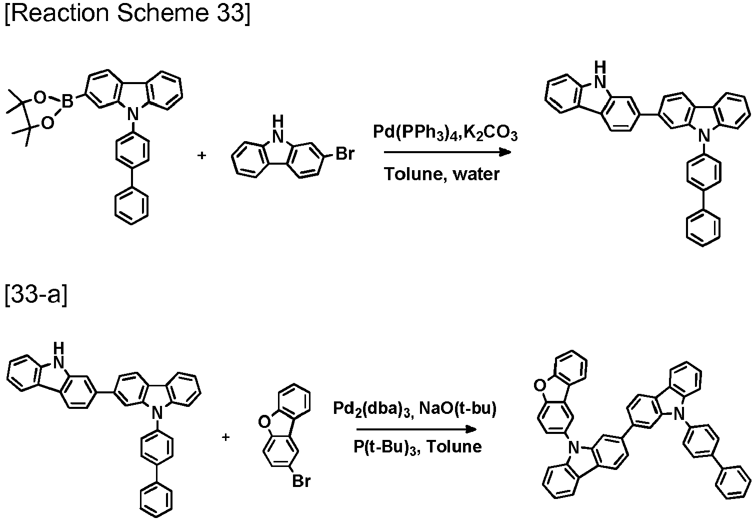

### First step; Synthesis of Intermediate Product (33-a)

20.0 g (44.91 mmol) of 9-biphenylcarbazole-2-boronic ester, 12.16 g (49.4 mmol) of 2-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 15.0 g (yield : 69%) of an intermediate product (33-a).

### Second step; Synthesis of Compound A-38

10.0 g (20.64 mmol) of the intermediate product (33-a), 5.35 g (21.67 mmol) of 2-bromo dibenzofuran, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 11.4g (yield 85%) of a target compound A-38 (LC Mass measurement: 651 g/mol).

### Synthesis Example 34: Preparation of Compound Represented by Compound A-39

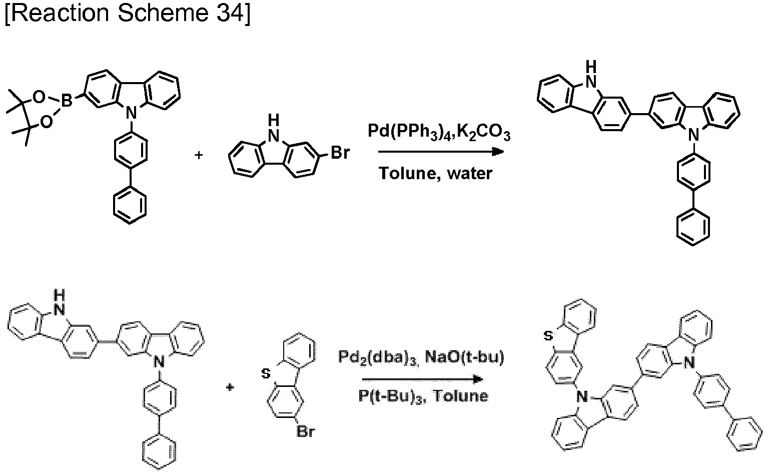

### First step; Synthesis of Intermediate Product (34-a)

20.0 g (44.91 mmol) of 9-biphenylcarbazole-2-boronic ester, 12.16 g (49.4 mmol) of 2-bromo carbazole, 0.519 g (0.45 mmol) of Pd(PP₃)₄, and 12.41 g (89.81 mmmol) of K₂CO₃ were suspended in 200 mL of toluene and 100 mL of water, and the resultant was agitated under nitrogen stream for 18 hours while refluxing. When the reaction was terminated, the resultant was extracted with toluene and distilled water, the resultant crystal was dissolved in monochlorobenzene and filtered, and the filtrated solution was concentrated under a reduced pressure. The organic solution was removed and recrystallized with dichloromethane, obtaining 15.0 g (yield : 69%) of an intermediate product (34-a).

### Second step; Synthesis of Compound A-39

10.0 g (20.64 mmol) of the intermediate product (34-a), 5.70 g (21.67 mmol) of 2-bromo dibenzothiophene, 2.18 g (22.70 mmol) of NaO(t-Bu), and 0.189 g (0.21 mmmol) of Pd₂(dba)₃ were suspended in 85 mL of toluene, 0.125 mL (0.62 mmol) of tri-tertiary-butylphosphine was added, and the resultant was agitated for 12 hours while refluxing.

When the reaction was terminated, the resultant was extracted with toluene and distilled water, an organic layer was dried and filtered using magnesium sulfate and the filtrated solution was concentrated under a reduced pressure. The product was purified with n-hexane/ dichloromethane (8:2 volume ratio) using silica gel column chromatography and recrystallized with dichloromethane and ethylacetate, obtaining 12.2g (yield 89%) of a target compound A-39 (LC Mass measurement: 667 g/mol).

### Electrochemical Characteristics of Prepared Compounds

The electrochemical characteristics of the compounds according to the Synthesis Example 1, 2, 13, 16, 23, 29 and 34 were measured using cyclic voltammetry equipment (C3 cell stand, wonatech), and the results are shown in the following Table 1.

**[Table 1]**

| Synthesis Example | Synthesis Example 1 | Synthesis Example 2 | Synthesis Example 13 | Synthesis Example 16 | Synthesis Example 23 | Synthesis Example 29 | Synthesis Example 34 |
|---|---|---|---|---|---|---|---|
| HOMO (eV) | 5.59 | 5.56 | 5.56 | 5.59 | 5.55 | 5.57 | 5.57 |
| LUMO (eV) | 2.24 | 2.21 | 2.20 | 2.23 | 2.21 | 2.22 | 2.25 |
| Band gap(eV) | 3.35 | 3.35 | 3.36 | 3.36 | 3.36 | 3.35 | 3.32 |

Referring to the Table 1, the compounds according to the Synthesis Example 1, 2, 13, 16, 23, 29 and 34 may be used in a hole transport layer and an electron blocking layer.

### (Manufacture of Organic Light Emitting Diode)

### Manufacture of Green Organic Light Emitting Diode

### Example 1

A glass substrate coated with ITO (Indium tin oxide) to be 1500 A thick was ultrasonic wave-washed with a distilled water. Subsequently, the glass substrate was ultrasonic wave-washed with a solvent such as isopropyl alcohol, acetone, methanol, and the like, moved to a plasma cleaner, cleaned by using oxygen plasma for 10 minutes, and then, moved to a vacuum depositor. This obtained ITO transparent electrode was used as a anode, HT-1 was vacuum-deposited on the ITO substrate to form a 700Å-thick hole injection and transport layer. Then, the compound of Synthesis Example 1 was vacuum-deposited thereon to form a 100Å-thick auxiliary hole transport layer. On the auxiliary hole transport layer, a 400Å-thick emission layer was formed by vacuum-depositing 4,4'-N,N'-dicarbazole)biphenyl [CBP] as a host doped with 5 wt% of tris (2-phenylpyridine)iridium(III) [Ir(ppy)3] as a dopant.

Subsequently, biphenoxy-bis(8-hydroxyquinoline)aluminum [Balq] was vacuum-deposited on the emission layer to form a 50Å**-**thick hole blocking layer. Tris (8-hydroxyquinoline)aluminum [Alq3] was vacuum-deposited on the the hole blocking layer to form a 250Å-thick electron transport layer, LiF 10Å and Al 1000Å were sequentially vacuum-deposited on the electron transport layer (ETL) to form a cathode, manufacturing an organic light emitting diode.

The organic light emitting diode had a five-layered organic thin film structure and specifically,
a structure of Al 1000Å/LiF 10Å/Alq3 250Å/Balq 50Å/EML[CBP:Ir(ppy)3=95:5] 300Å/ auxiliary HTL 100Å/HT-1 700Å/ITO 1500Å.

### Example 2

An organic light emitting diode was manufactured according to the same method as Example 1 except for using Synthesis Example 2 instead of Synthesis Example 1.

### Example 3

An organic light emitting diode was manufactured according to the same method as Example 1 except for using Synthesis Example 13 instead of Synthesis Example 1.

### Example 4

An organic light emitting diode was manufactured according to the same method as Example 1 except for using Synthesis Example 16 instead of Synthesis Example 1.

### Example 5

An organic light emitting diode was manufactured according to the same method as Example 1 except for using Synthesis Example 23 instead of Synthesis Example 1.

### Example 6

An organic light emitting diode was manufactured according to the same method as Example 1 except for using Synthesis Example 29 instead of Synthesis Example 1.

### Example 7

An organic light emitting diode was manufactured according to the same method as Example 1 except for using Synthesis Example 34 instead of Synthesis Example 1.

### Comparative Example 1

An organic light emitting diode was manufactured according to the same method as Example 1 except for N,N'-di(1-naphthyl)-N,N'-diphenylbenzidine [NPB] instead of HT-1, and N,N'-di (1-naphthyl)-N,N'-diphenylbenzidine [NPB] instead of Synthesis Example 1.

### Comparative Example 2

An organic light emitting diode was manufactured according to the same method as Example 1 except for N,N'-di(1-naphthyl)-N,N'-diphenylbenzidine [NPB] instead of HT-1, and tris (4,4',4"- (9-carbazolyl))-triphenylamine [TCTA] instead of Synthesis Example 1.

### Comparative Example 3

An organic light emitting diode was manufactured according to the same method as Example 1 except for using HT-1 instead of Synthesis Example 1.

### Manufacture of Red Organic Light Emitting Diode

### Example 8

A glass substrate coated with ITO (indium tin oxide) to be 1500 Å thick was ultrasonic wave-washed with a distilled water. Subsequently, the glass substrate was ultrasonic wave-washed with a solvent such as isopropyl alcohol, acetone, methanol, and the like, moved to a plasma cleaner, cleaned by using oxygen plasma for 10 minutes, and then, moved to a vacuum depositor. This obtained ITO transparent electrode was used as a anode, and 4,4'-bis[N-[4-{N,N-bis(3-methylphenyl)amino}-phenyl]-N-phenylamino]biphenyl [DNTPD] was vacuum-deposited on the ITO substrate to form 600Å-thick hole injection layer. Then, HT-1 was vacuum-deposited thereon to form a 200Å-thick hole transport layer. On the hole transport layer, the compound of Synthesis Example 1 was vacuum-deposited to form a 100Å-thick auxiliary hole transport layer. On the auxiliary hole transport layer, a 300Å-thick emission layer was formed by vacuum-depositing (4,4'-N,N'-dicarbazole)biphenyl [CBP] as a host doped with 7 wt% of bis (2-phenylquinoline) (acetylacetonate)iridium(III) [Ir(pq)2acac] as a dopant.

Subsequently, biphenoxy-bis(8-hydroxyquinoline)aluminum [Balq] was vacuum-deposited on the emission layer to form a 50Å-thick hole blocking layer. Tris (8-hydroxyquinoline)aluminum [Alq3] was vacuum-deposited on the the hole blocking layer to form a 250Å-thick electron transport layer (ETL), LiF 10Å and Al 1000Å were sequentially vacuum-deposited on the electron transport layer (ETL) to form a cathode, manufacturing an organic light emitting diode.

The organic light emitting diode had a six-layered organic thin film structure and specifically,
a structure of Al 1000Å/LiF 10Å/Alq3 250Å/Balq 50Å/EML[CBP: Ir(pq)2acac =93:7] 300Å/ auxiliary HTL 100Å/HT-1 700Å/ DNTPD 600Å/ITO 1500Å.

### Example 9

An organic light emitting diode was manufactured according to the same method as Example 8 except for using Synthesis Example 8 instead of Synthesis Example 1.

### Example 10

An organic light emitting diode was manufactured according to the same method as Example 8 except for using Synthesis Example 13 instead of Synthesis Example 1.

### Example 11

An organic light emitting diode was manufactured according to the same method as Example 8 except for using Synthesis Example 16 instead of Synthesis Example 1.

### Example 12

An organic light emitting diode was manufactured according to the same method as Example 8 except for using Synthesis Example 23 instead of Synthesis Example 1.

### Example 13

An organic light emitting diode was manufactured according to the same method as Example 8 except for using Synthesis Example 29 instead of Synthesis Example 1.

### Example 14

An organic light emitting diode was manufactured according to the same method as Example 8 except for using Synthesis Example 34 instead of Synthesis Example 1.

### Comparative Example 4

An organic light emitting diode was manufactured according to the same method as Example 5 except for N,N'-di(1-naphthyl)-N,N'-diphenylbenzidine [NPB] instead of HT-1, and N,N'-di (1-naphthyl)-N,N'-diphenylbenzidine [NPB] instead of Synthesis Example 1.

### Comparative Example 5

An organic light emitting diode was manufactured according to the same method as Example 5 except for N,N'-di(1-naphthyl)-N,N'-diphenylbenzidine [NPB] instead of HT-1, and tris (4,4',4"- (9-carbazolyl))-triphenylamine [TCTA] instead of Synthesis Example 1.

### Comparative Example 6

An organic light emitting diode was manufactured according to the same method as Example 5 except for using HT-1 instead of Synthesis Example 1.

The structures of the DNTPD, NPB, HT-1, TCTA, CBP, Balq, Alq3, Ir(ppy)3, and Ir(pq)2acac used for manufacturing the organic light emitting diode were as follows.

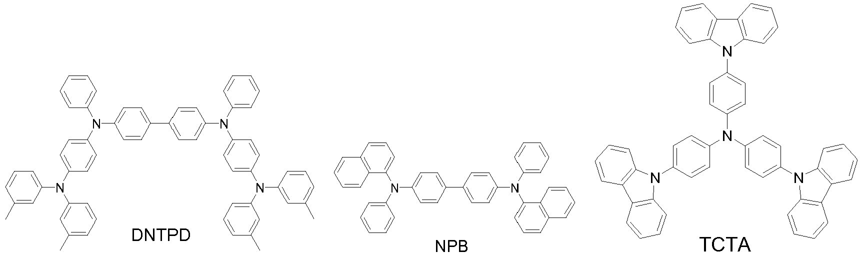

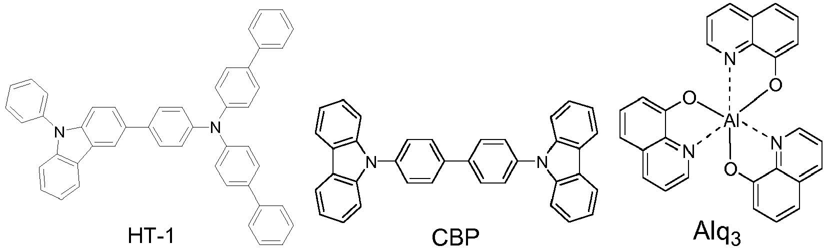

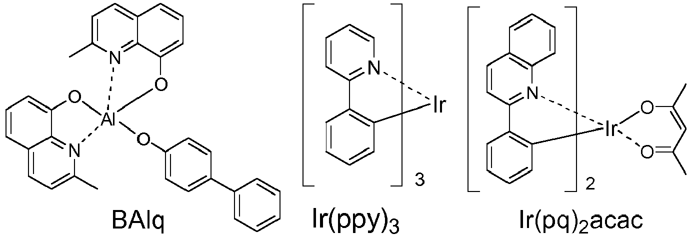

### (Performance Measurement of Organic Light Emitting Diode)

Current density and luminance changes depending on a voltage and luminous efficiency of each organic light emitting diode according to Examples 1 to 14 and Comparative Examples 1 to 6 were measured. The measurements were specifically performed in the following method, and the results were provided in the following Tables 2 and 3.

### (1) Measurement of Current Density Change Defending on Voltage Change

The obtained organic light emitting diodes were measured for current value flowing in the unit device while increasing the voltage from 0 V to 10 V using a current-voltage meter (Keithley 2400), the measured current value was divided by area to provide the results.

### (2) Measurement of Luminance Change Depending on Voltage Change

Luminance was measured by using a luminance meter (Minolta Cs-1000A), while the voltage of the organic light emitting diodes was increased from 0 V to 10 V.

### (3) Measurement of Luminous Efficiency

Current efficiency (cd/A) at the same luminance (cd/m²) were calculated by using the luminance, current density, and voltages (V) from the items (1) and (2).

### (4) Measurement of Life-span

Using a Polaronix life-span measurement system, the green organic light emitting diodes of Examples 1 to 7 and Comparative Examples 1 to 3 emittted light at initial luminance of 3,000nit, and then half-life life-spans were considered to be times when the luminance became 1/2 of the initial luminance, and the red organic light emitting diodes of Examples 8 to 14 and Comparative Examples 4 to 6 emittted light at initial luminance of 1,000nit, and then T80 life-spans were considered to be times when the luminance became 80% of the initial luminance.

**[Table 2]**

| Device | HTL | Auxiliary HTL | Driving voltage (V) | Luminous efficiency (cd/A) | EL peak (nm) | Half-life life-span(h) @3000nit |
|---|---|---|---|---|---|---|
| Example 1 | HT-1 | Synthesis Example1 | 8.0 | 40.4 | 516 | 265 |
| Example 2 | HT-1 | Synthesis Example2 | 7.0 | 53.2 | 516 | 224 |
| Example 3 | HT-1 | Synthesis Example13 | 7.1 | 50.8 | 516 | 238 |
| Example 4 | HT-1 | Synthesis Example16 | 7.2 | 43.7 | 516 | 225 |
| Example 5 | HT-1 | Synthesis Example23 | 7.0 | 53.2 | 516 | 230 |
| Example 6 | HT-1 | Synthesis Example29 | 7.0 | 49.4 | 516 | 225 |
| Example 7 | HT-1 | Synthesis Example34 | 7.3 | 44.1 | 516 | 235 |
| Comparative Example 1 | NPB | NPB | 8.2 | 25.8 | 516 | 175 |
| Comparative Example 2 | NPB | TCTA | 7.1 | 45.0 | 516 | 181 |
| Comparative Example 3 | HT-1 | HT-1 | 7.4 | 37.2 | 516 | 220 |

### Driving voltage and luminous efficiency were measured at 1,000nit

Referring to the Table 2, the green phosphorescence organic light emitting diodes including the compound of the present invention in the auxiliary hole transport layer according to Examples 1 to 7 showed improved luminous efficiency and life-span compared with the green phosphorescence organic light emitting diodes according to Comparative Example 1 or Comparative Example 3 without the auxiliary hole transport layer (HTL). Particularly, Examples of the present invention showed minimum 10% to maximum 40% or more of remarkably increased luminous efficiency comprared with Comparative Example 3, and Examples of the present invention showed minimum 20% to maximum 50% or more compared with Comparative Example 2 including a conventional TCTA in a auxiliary hole transport layer (HTL), which indicates that the device results of Examples are considered to be sufficient for device commercialization because a life-span of a device are a requirement for actual device commercialization.

**[Table 3]**

| Device | HTL | Auxiliary HTL | Driving voltage (V) | Luminous efficiency (cd/A) | EL pea k (nm) | T80life-span(h) @1000nit |
|---|---|---|---|---|---|---|
| Example 8 | HT-1 | Synthesis Example1 | 8.7 | 19.9 | 600 | 848 |
| Example 9 | HT-1 | Synthesis Example2 | 8.3 | 21.1 | 600 | 805 |
| Example 10 | HT-1 | Synthesis Example13 | 8.2 | 20.3 | 600 | 812 |
| Example 11 | HT-1 | Synthesis Example16 | 8.4 | 19.8 | 600 | 824 |
| Example 12 | HT-1 | Synthesis Example23 | 8.2 | 20.7 | 600 | 817 |
| Example 13 | HT-1 | Synthesis Example29 | 8.3 | 20.0 | 600 | 825 |
| Example 14 | HT-1 | Synthesis Example34 | 8.2 | 19.9 | 600 | 810 |
| Comparative Example 4 | NPB | NPB | 8.7 | 15.1 | 600 | 720 |
| Comparative Example 5 | NPB | TCTA | 9.1 | 17.3 | 600 | 650 |
| Comparative Example 6 | HT-1 | HT-1 | 8.5 | 16.5 | 600 | 800 |

### Driving voltage and luminous efficiency were measured at 800nit

Referring to the Table 3, the red phosphorescence organic light emitting diodes including the compound of the present invention in the auxiliary hole transport layer according to Examples 8 to 14 showed improved luminous efficiency and life-span compared with the red organic light emitting diode without the auxiliary hole transport layer (HTL) according to Comparative Example 4 or Comparative Example 6.

Particularly, Examples of the present invention showed minimum 10% to maximum 30% or more of remarkably increased luminous efficiency comprared with Comparative Example 4, Examples of the present invention showed minimum 5% to maximum 20% or more compared with Comparative Example 5, life-spans of light emitting diodes showed minimum 20% to maximum 40% or more, and driving voltages were lowered, which indicates remarkablely improvement of improtant characteristics of red phosphorescent devices.

The device results of Examples are considered to be sufficient for device commercialization because a life-span of a device is a requirement for actual device commercialization.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims. Therefore, the aforementioned embodiments should be understood to be exemplary but not limiting the present invention in any way.

## Claims

1. An organic optoelectronic device comprising
an anode, a cathode and at least one organic thin layer between the anode and the cathode,
the organic thin layer comprises an emission layer, a hole transport layer (HTL), a hole injection layer (HIL), an electron transport layer (ETL), an electron injection layer (EIL) or a combination thereof,
the organic thin layer comprises an emission layer and a plurality of hole transport layer (HTL), and
the hole transport layer (HTL) adjacent to the emission layer of the plurality of hole transport layer (HTL) comprises a compound represented by the following Chemical Formula A-1, and one of the hole transport layers (HTL) that are not adjacent to the emission layer comprises a compound represented by the following Chemical Formula B-1: 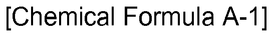 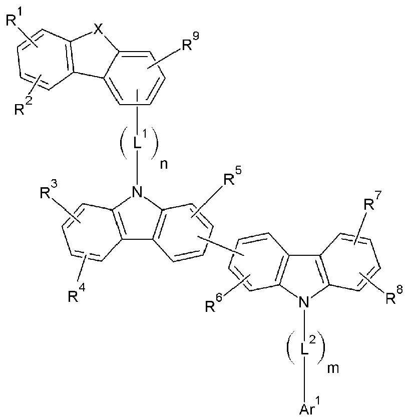 wherein, in the Chemical Formula A-1,
X is -O-, -S-, -S(O)-, -S(O)₂- or -CR'R " -,
R¹ to R⁹, R' and R" are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof,
L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof,
Ar¹ is a substituted or unsubstituted C6 to C30 aryl group,
n is an integer of 0 to 3, and
m is an integer of 0 to 3: 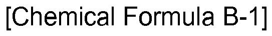 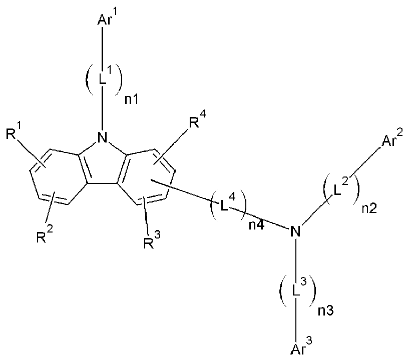 wherein, in the Chemical Formula B-1,
R¹ to R⁴ are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof, R¹ and R² provide a fused ring, R³ and R⁴ provide a fused ring,
Ar¹ to Ar³ are independently a substituted or unsubstituted C6 to C30 aryl group, or a substituted or unsubstituted C2 to C30 heteroaryl group,
L¹ to L⁴ are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof, and
n1 to n4 are independently integers of 0 to 3.

2. The organic optoelectronic device of claim 1, wherein the compound represented by the Chemical Formula A-1 is represented by the following Chemical Formula A-2, A-3, A-4 or A-5: 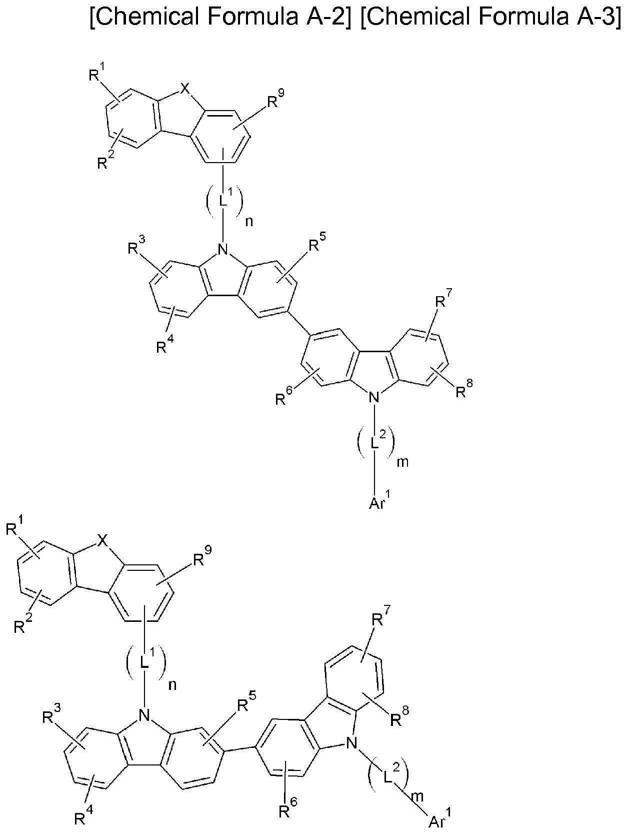 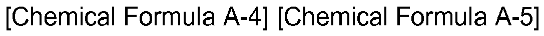 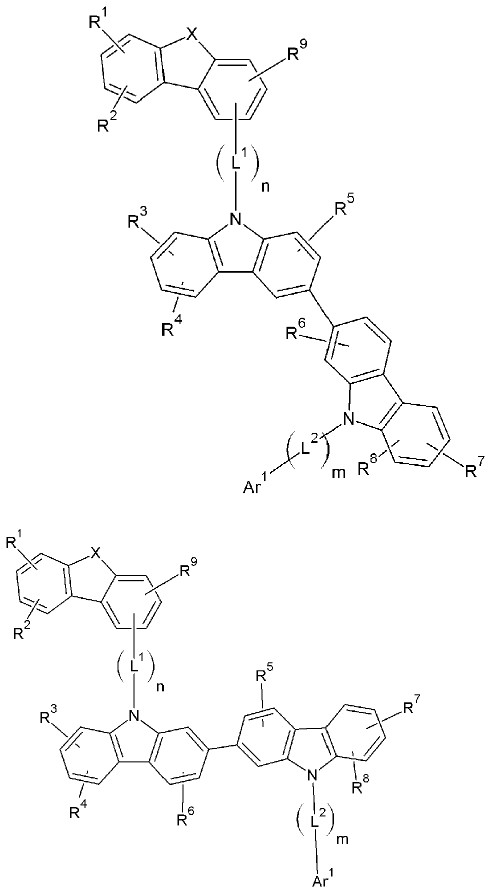 wherein, in the Chemical Formulae A-2, A-3, A-4 and A-5,
X is -O-, -S-, -S(O)-, -S(O)₂- or -CR'R " -,
R¹ to R⁹, R' and R" are independently hydrogen, deuterium, a substituted or unsubstituted C1 to C10 alkyl group, a substituted or unsubstituted C6 to C30 aryl group, a substituted or unsubstituted C2 to C30 heteroaryl group, or a combination thereof,
L¹ and L² are independently a substituted or unsubstituted C2 to C10 alkenylene group, a substituted or unsubstituted C2 to C10 alkynylene group, a substituted or unsubstituted C6 to C30 arylene group, a substituted or unsubstituted C2 to C30 heteroarylene group, or a combination thereof,
Ar¹ is a substituted or unsubstituted C6 to C30 aryl group,
n is an integer of 0 to 3, and
m is an integer of 0 to 3.

3. The organic optoelectronic device of claim 1, wherein Ar¹ of the Chemical Formula A-1 is a substituted or unsubstituted phenyl group.

4. The organic optoelectronic device of claim 1, wherein L¹ and L² of the Chemical Formula A-1 are independently a substituted or unsubstituted phenyl group.

5. The organic optoelectronic device of claim 1, wherein X of the Chemical Formula A-1 is -CR'R " -, wherein R' and R " are independently a substituted or unsubstituted methyl group, or a substituted or unsubstituted phenyl group.

6. The organic optoelectronic device of claim 1, wherein the compound represented by the Chemical Formula A-1 is represented by one of the following Chemical Formulae A-6 to A-26:

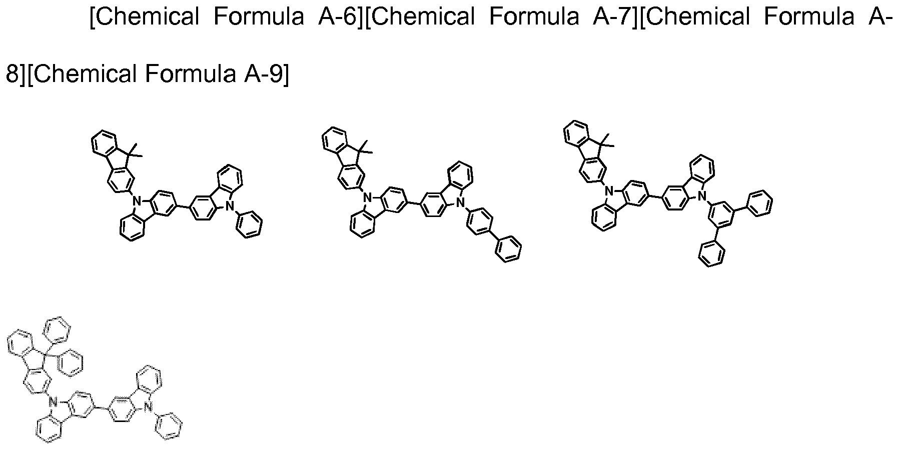

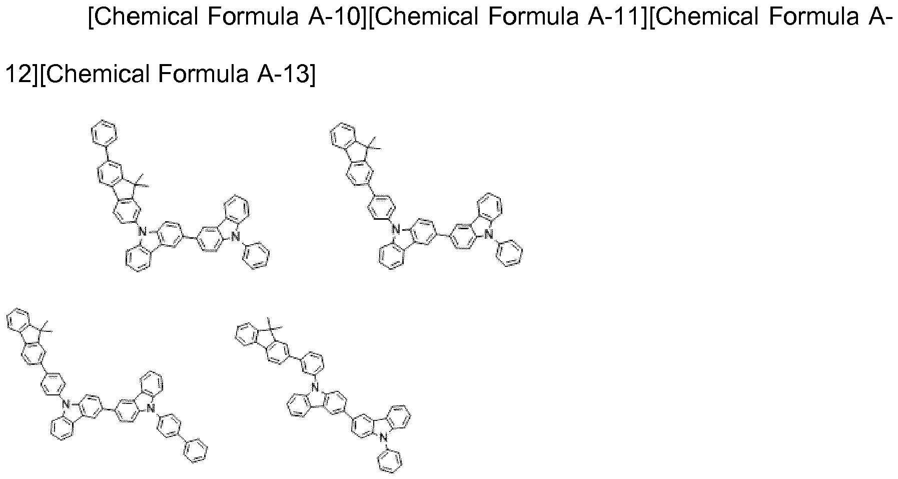

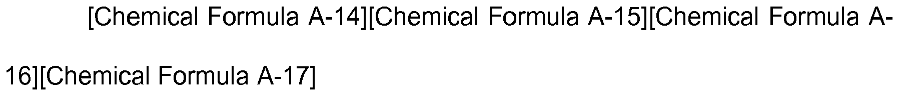

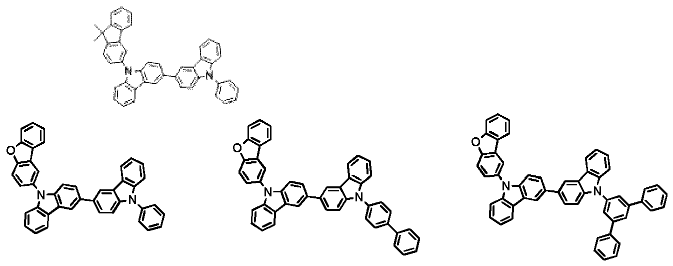

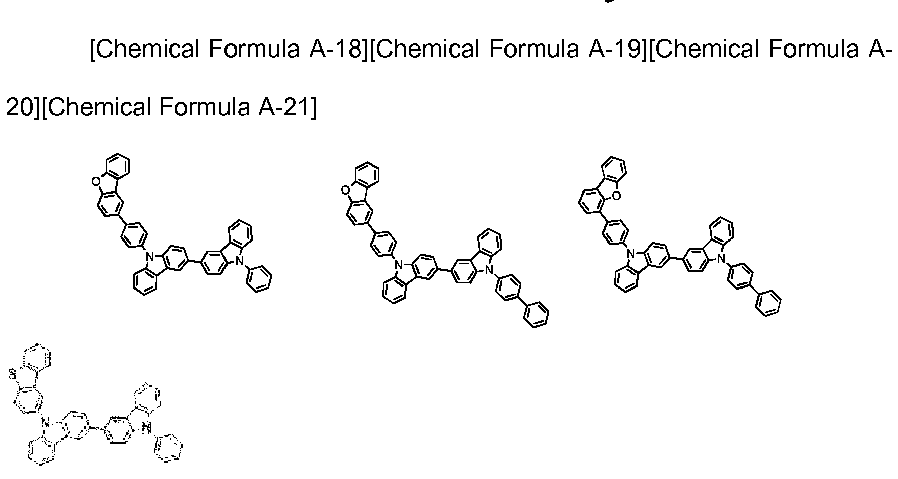

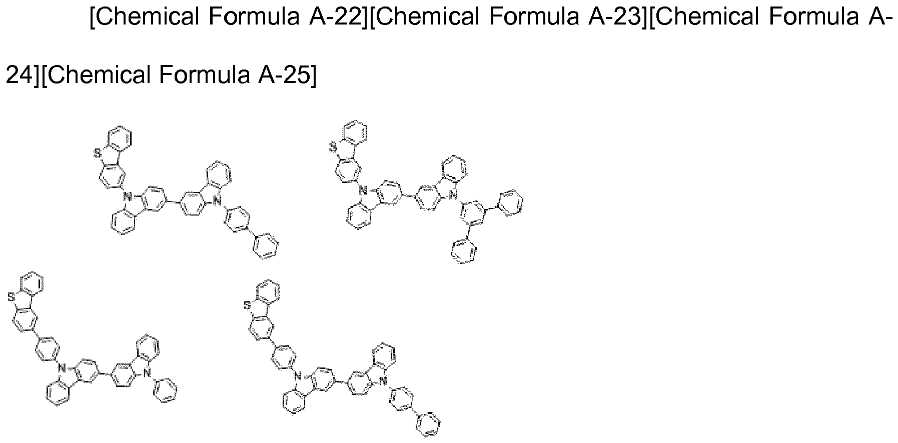

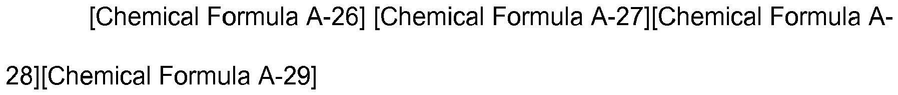

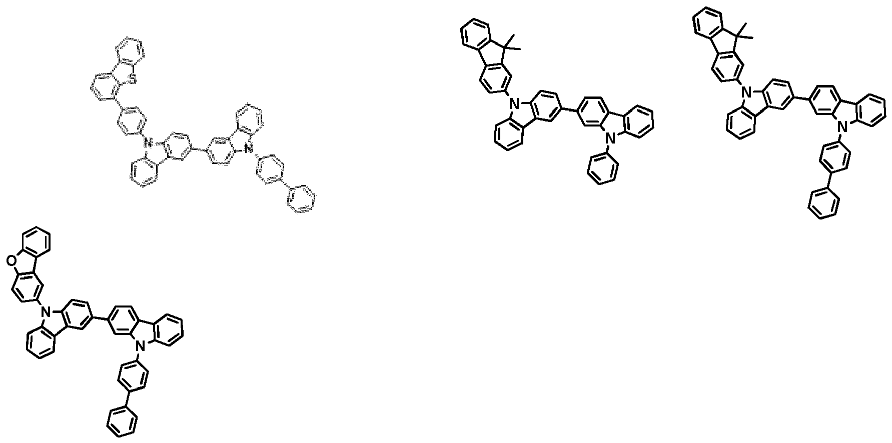

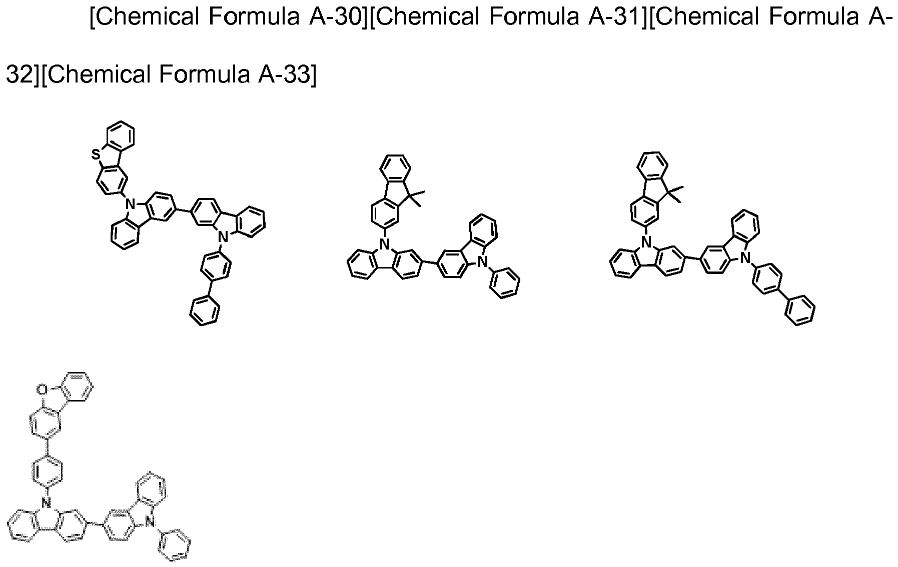

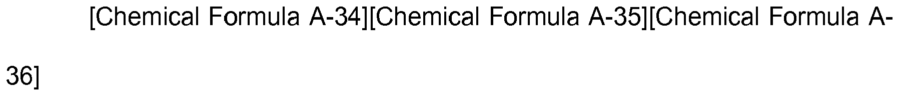

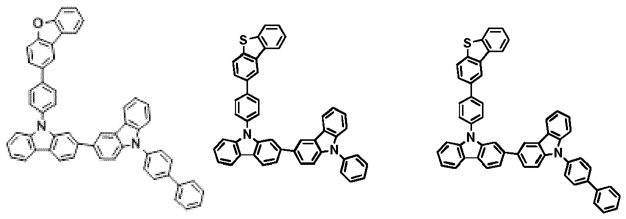

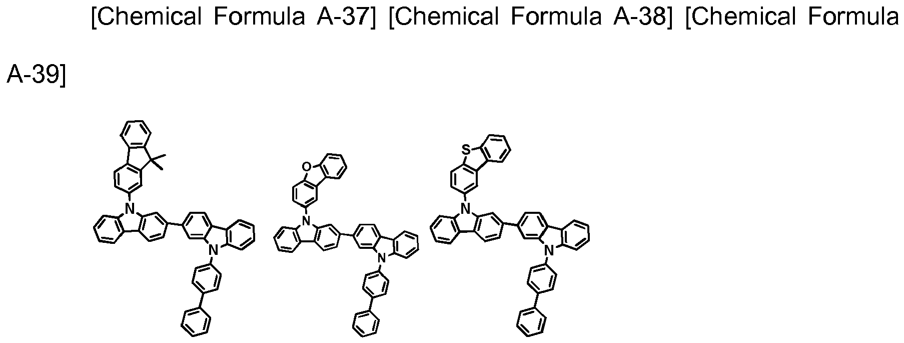

7. The organic optoelectronic device of claim 1, wherein in the Chemical Formula B-1,
R¹ to R⁴ are independently hydrogen, deuterium, a substituted or unsubstituted C1 to C10 alkyl group, a substituted or unsubstituted C6 to C30 aryl group, or a combination thereof, R¹ and R² provide a fused ring, R³ and R⁴ provide a fused ring,
Ar¹ is a substituted or unsubstituted phenyl group, or a substituted or unsubstituted naphthalene group,
Ar² and Ar³ are independently a substituted or unsubstituted phenyl group, a substituted or unsubstituted naphthalene group, a substituted or unsubstituted fluorene group, a substituted or unsubstituted bisfluorene group, a substituted or unsubstituted triphenylene group, a substituted or unsubstituted dibenzofuran group, or a substituted or unsubstituted dibenzothiophene group,
L¹ to L⁴ are independently a substituted or unsubstituted C6 to C30 arylene group, and
n1 to n4 are independently integers of 0 to 3.

8. The organic optoelectronic device of claim 1, wherein the compound represented by the Chemical Formula B-1 is represented by one of the following Chemical Formulae J-1 to J-144:

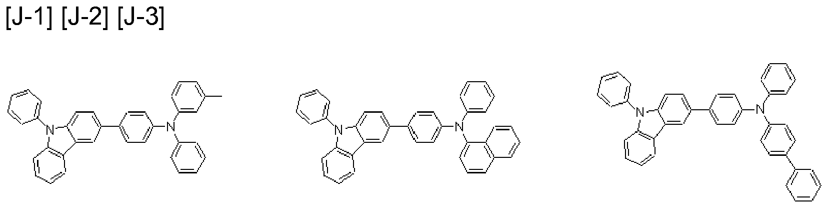

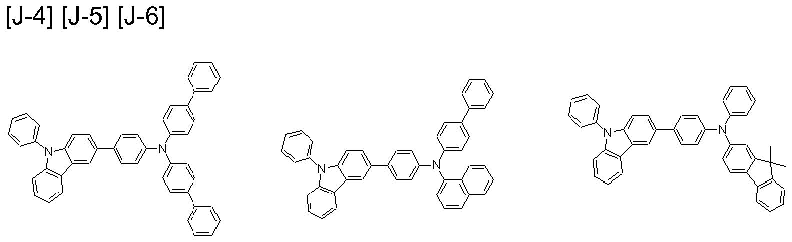

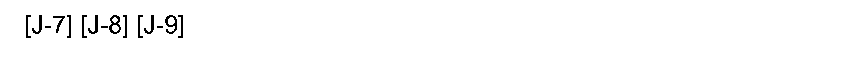

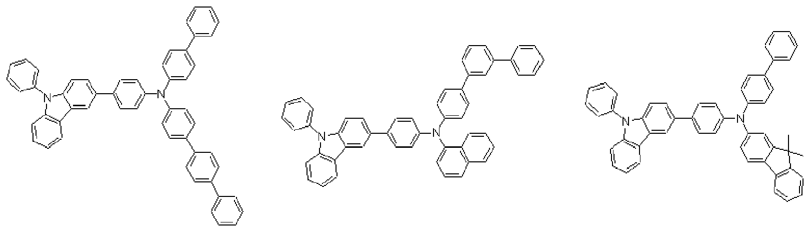

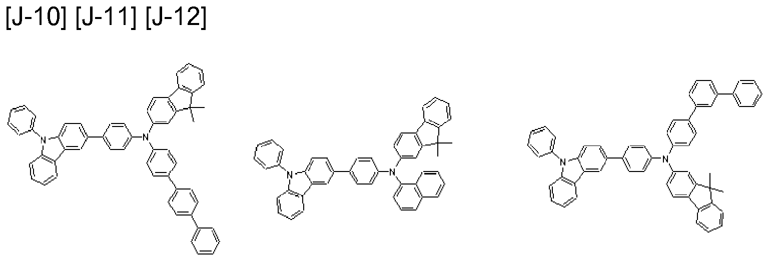

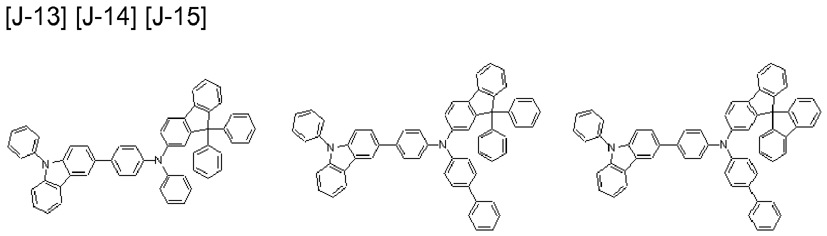

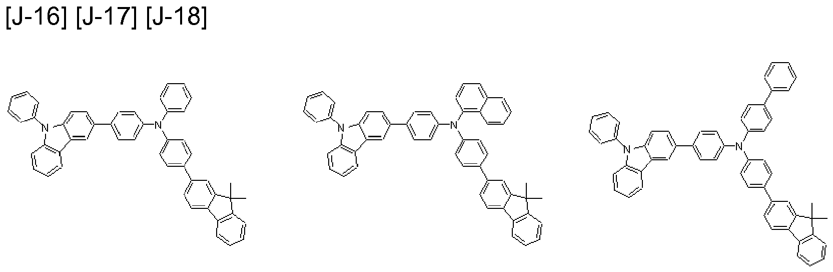

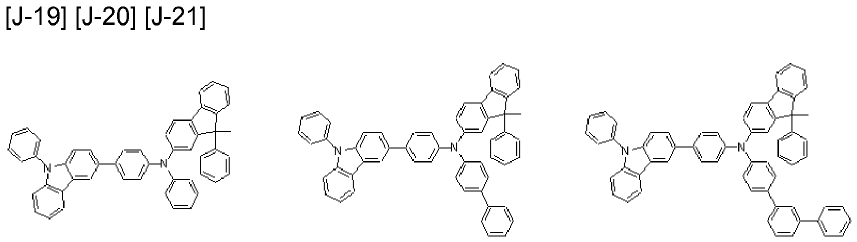

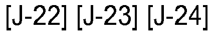

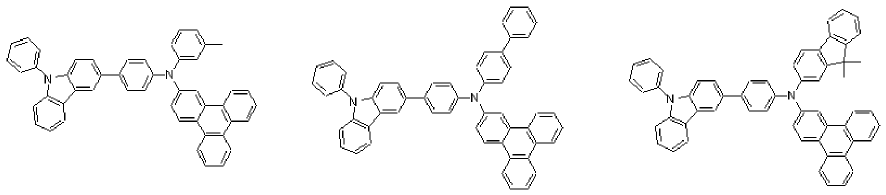

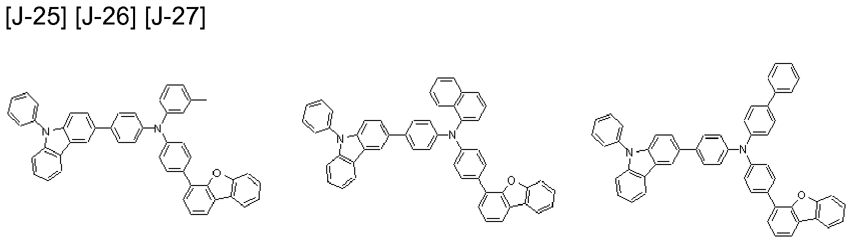

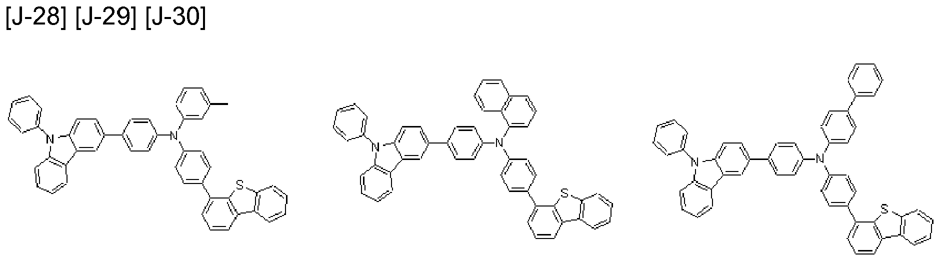

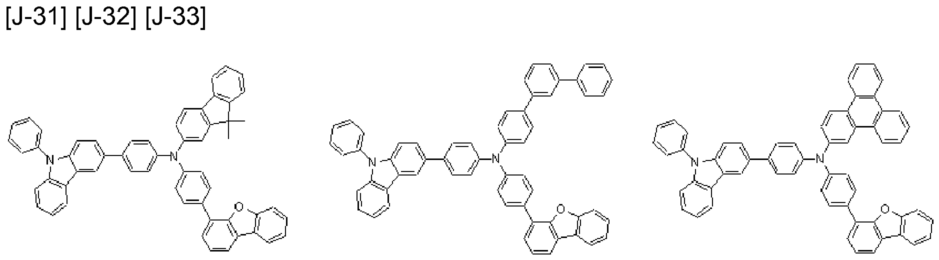

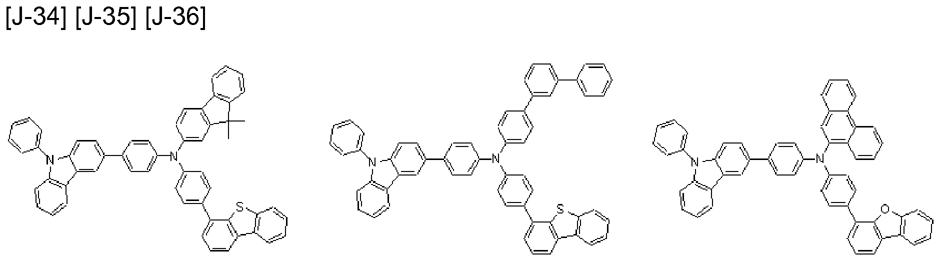

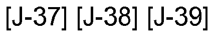

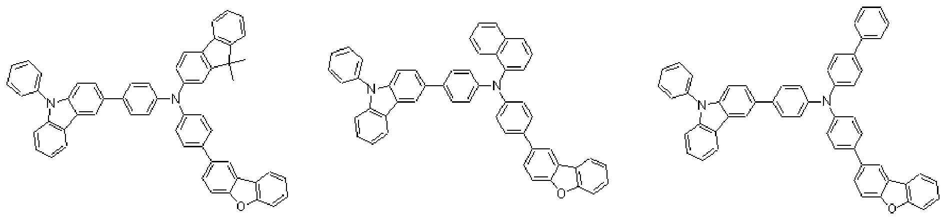

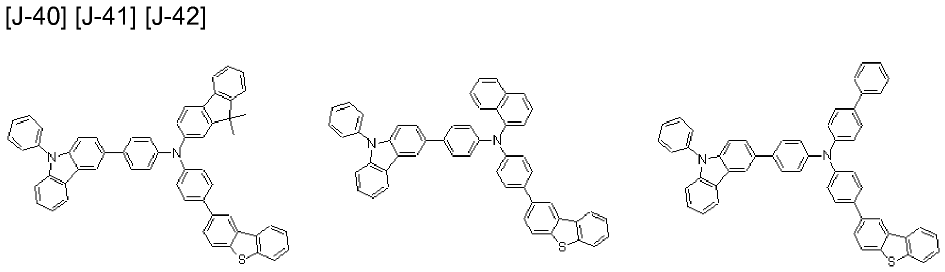

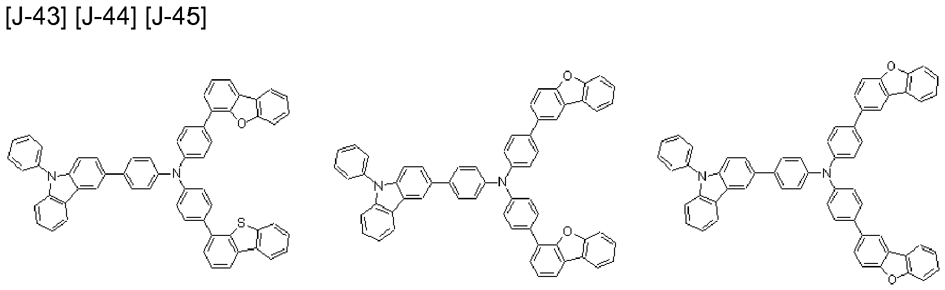

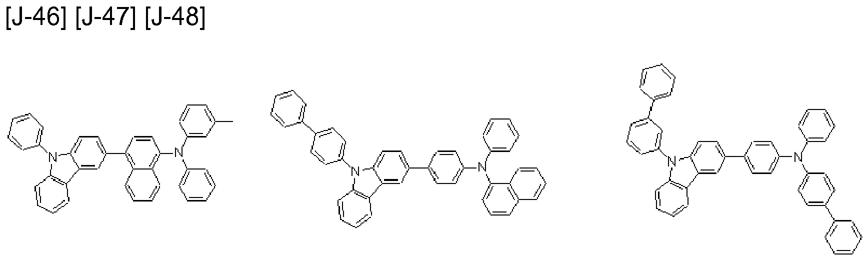

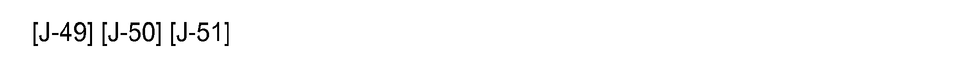

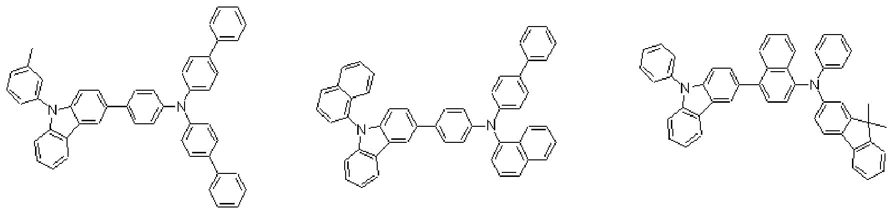

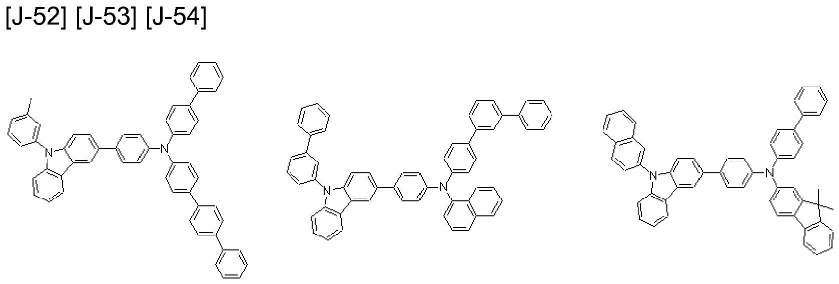

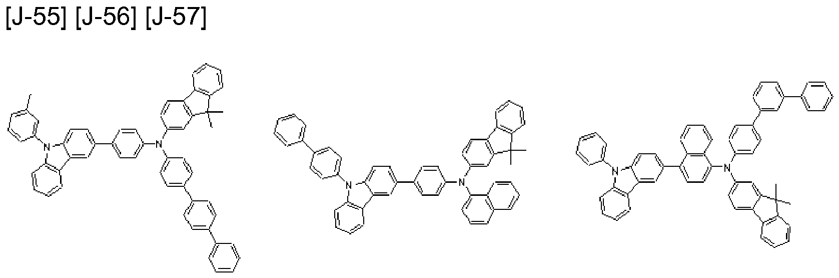

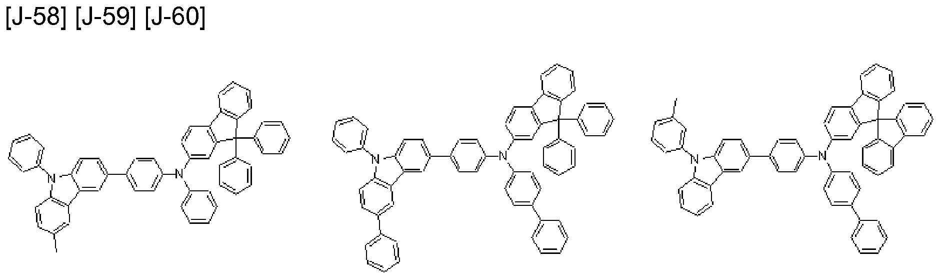

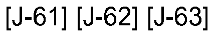

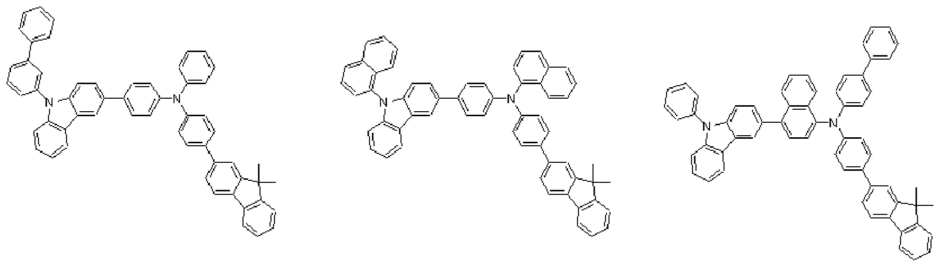

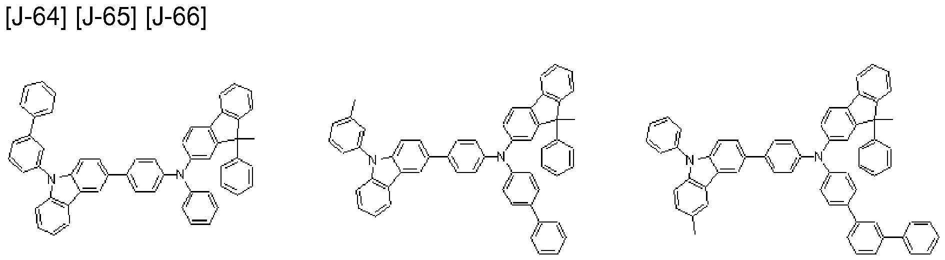

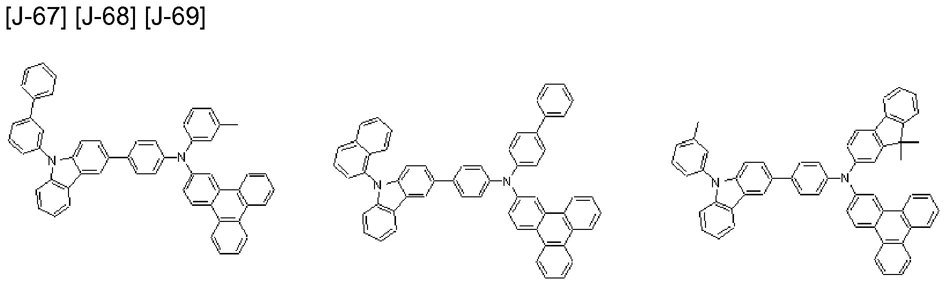

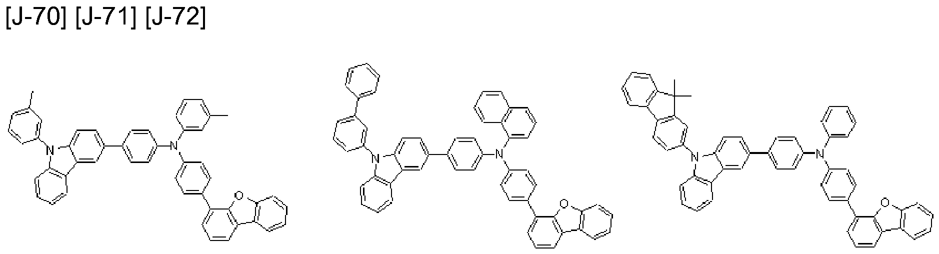

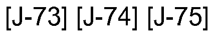

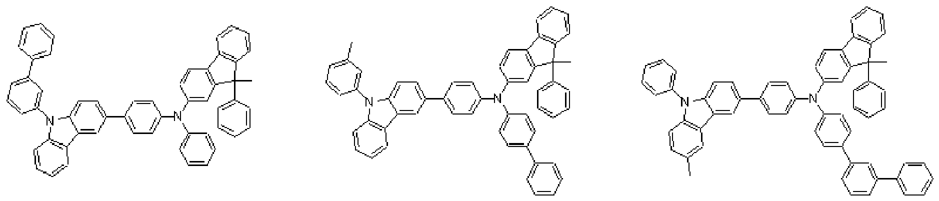

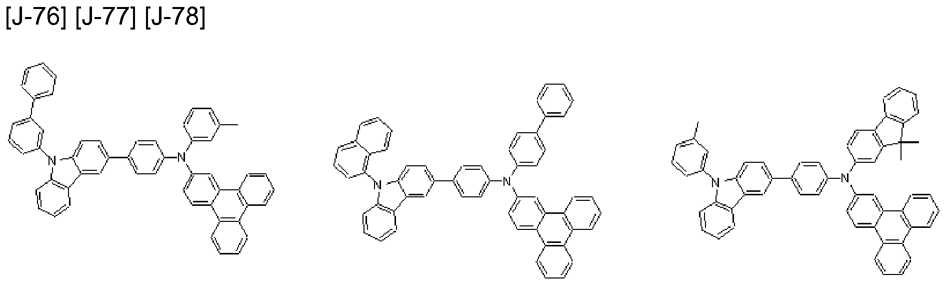

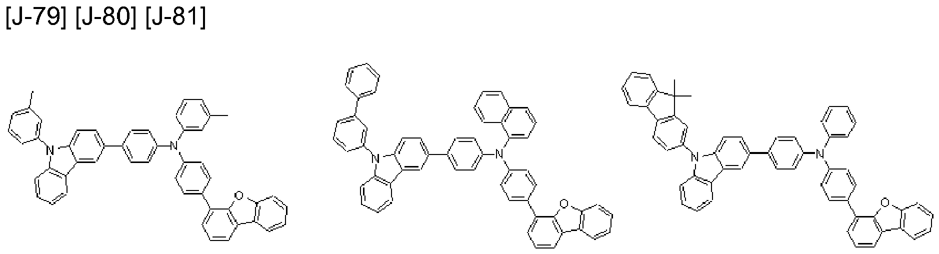

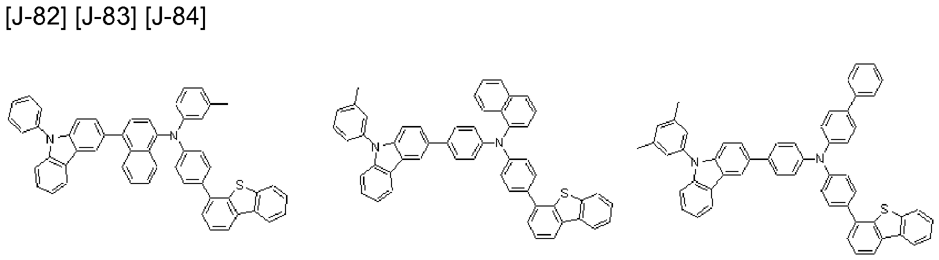

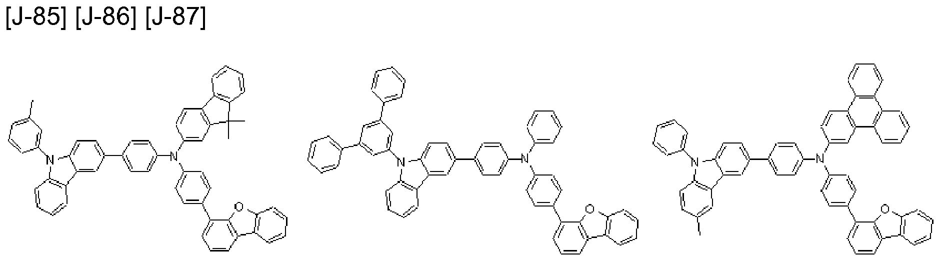

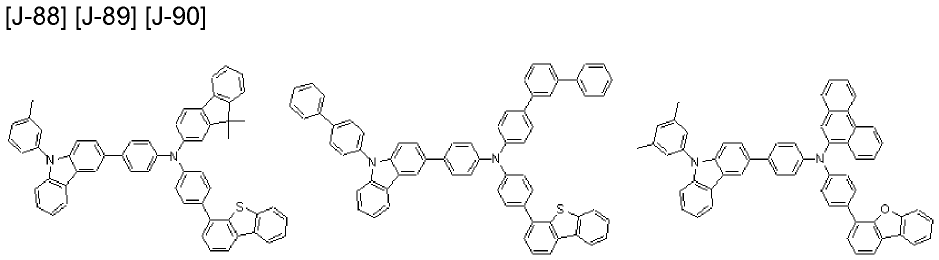

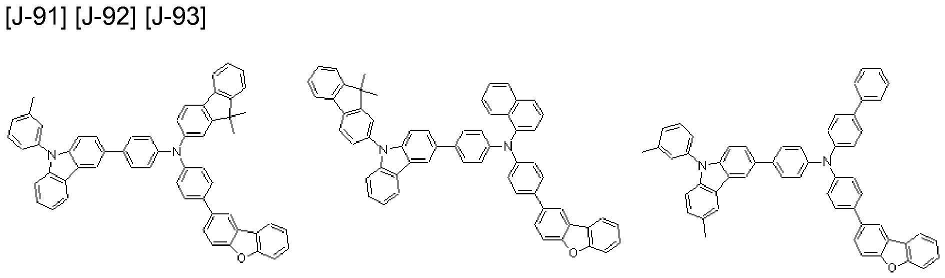

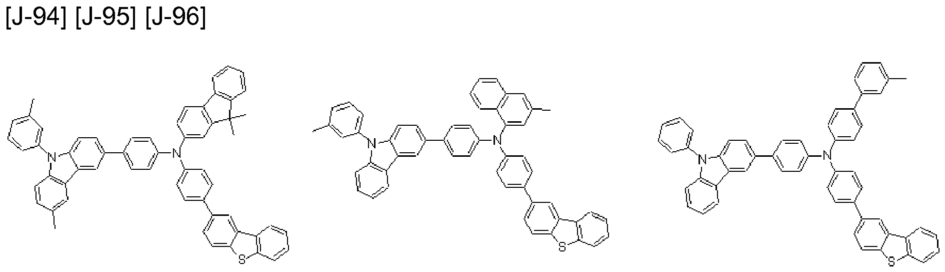

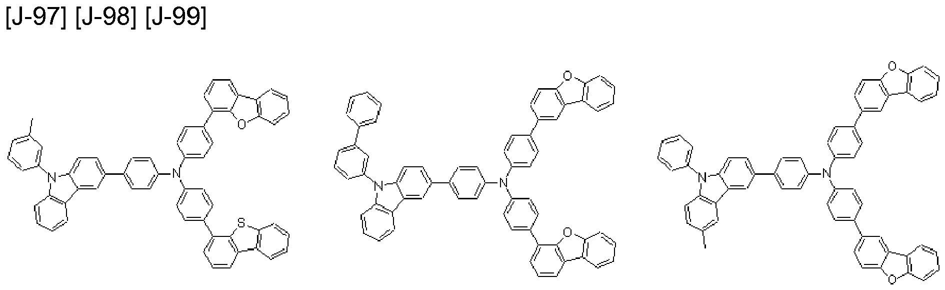

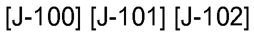

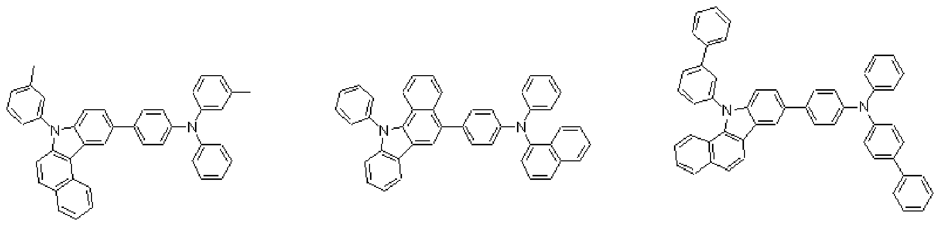

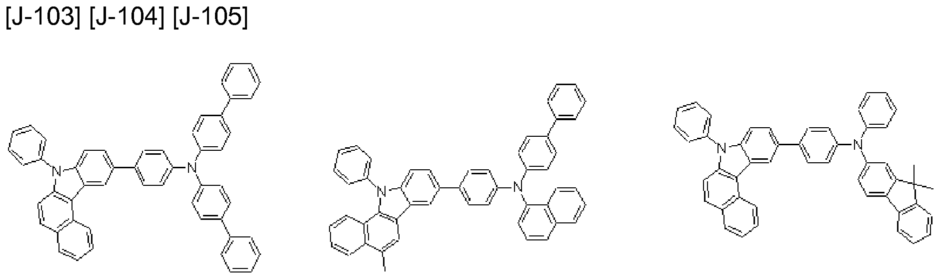

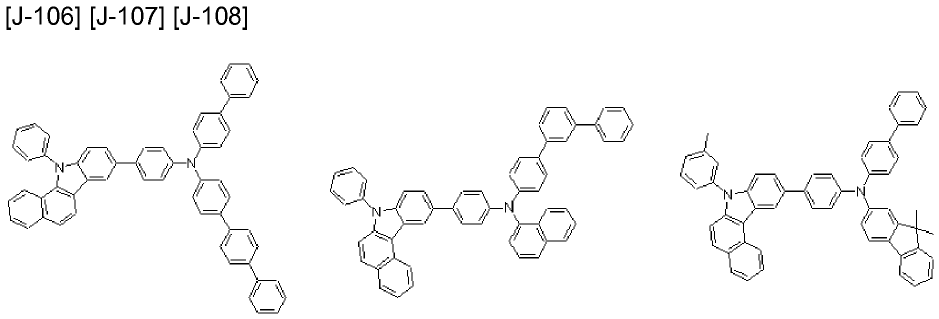

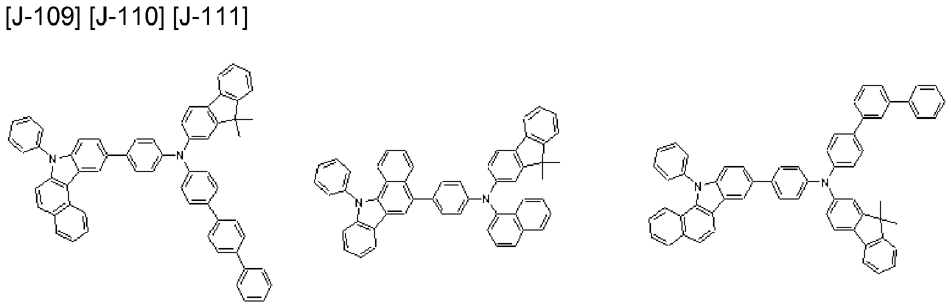

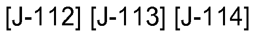

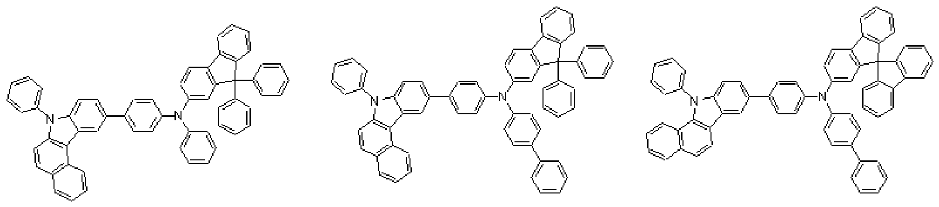

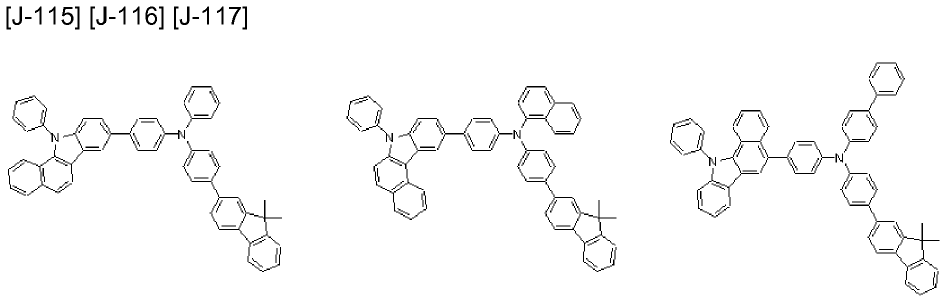

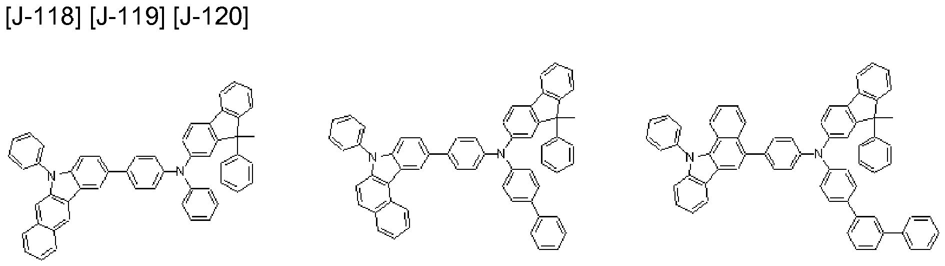

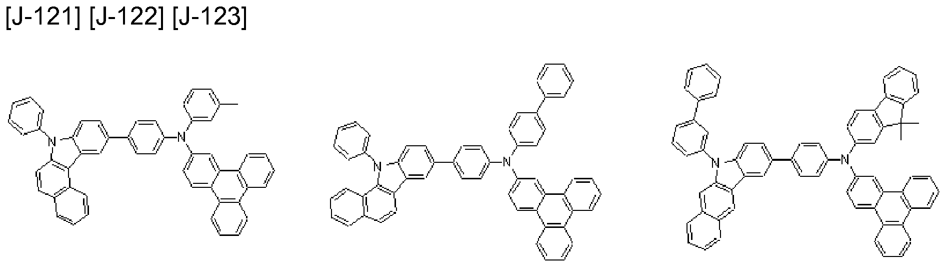

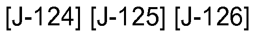

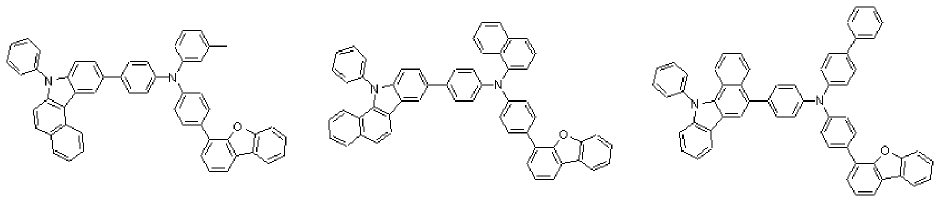

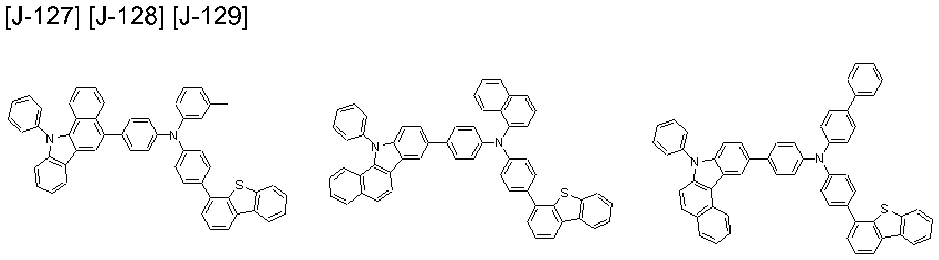

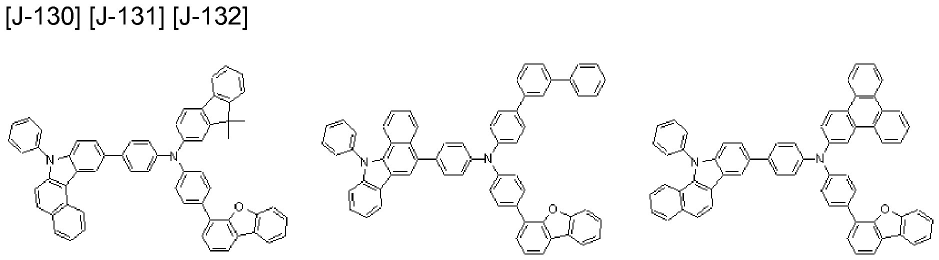

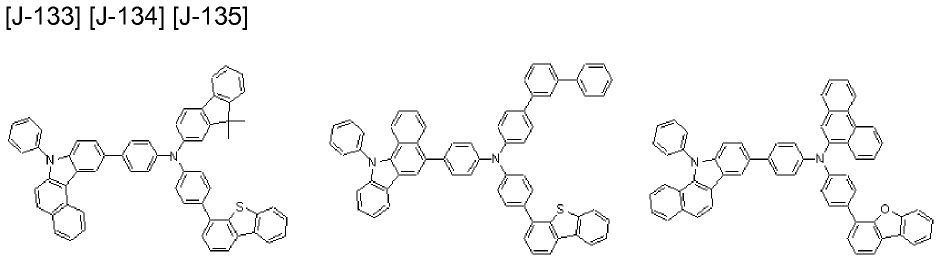

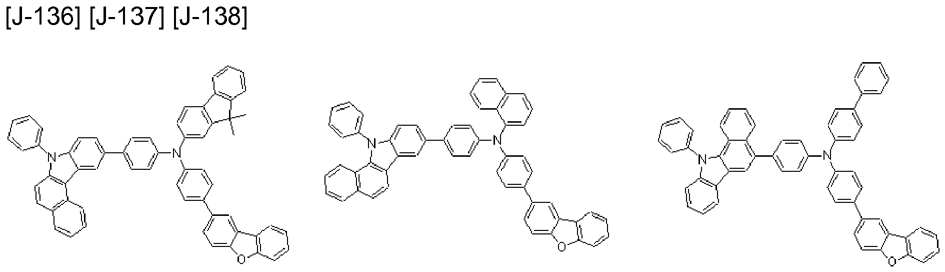

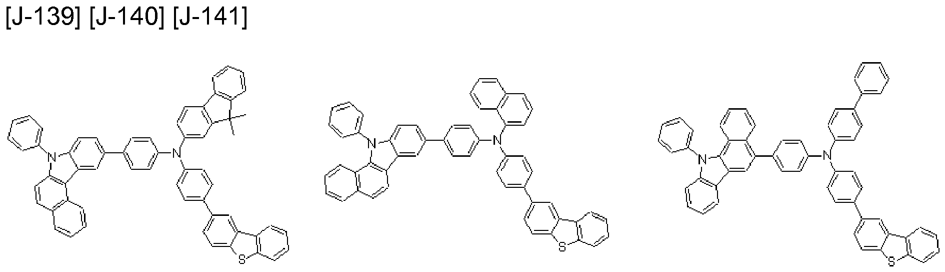

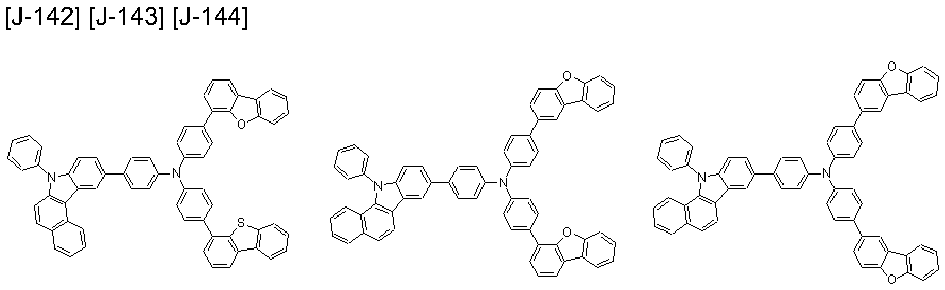

9. The organic optoelectronic device of claim 1, wherein the organic optoelectronic device is an organic photoelectric device, an organic light emitting diode, an organic solar cell, an organic transistor, an organic photo conductor drum, or an organic memory device.

10. The organic optoelectronic device of claim 1, wherein the compound represented by the Chemical Formula A-1 has a HOMO level of greater than or equal to 5.4eV and less than or equal to 5.8eV.

11. The organic optoelectronic device of claim 1, wherein the compound represented by the Chemical Formula A-1 has triplet exciton energy of greater than or equal to 2.5eV and less than or equal to 2.9eV.

12. The organic optoelectronic device of claim 1, wherein the compound represented by the Chemical Formula B-1 has a HOMO level of greater than or equal to 5.2eV and less than or equal to 5.6eV.

13. A display device comprising the organic optoelectronic device of any one of claim 1 to claim 12.
